# EUROPÄISCHE PATENTSCHRIFT

(11) **EP 3 609 688 B1**
(45) Veröffentlichungstag und Bekanntmachung des Hinweises auf die Patenterteilung: **12.05.2021**
(21) Anmeldenummer: 18718777.8
(22) Anmeldetag: 12.04.2018
(51) Int. Cl.: B29D 11/00, G02B 13/00, G02B 3/00

(54) **VERFAHREN ZUR HERSTELLUNG VON LINSENELEMENTEN UND VON GEHÄUSTEN, STRAHLUNGSEMPFINDLICHEN BAUELEMENTEN AUF WAFEREBENE**
METHOD FOR THE PRODUCTION OF LENS ELEMENTS AND HOUSED, RADIATION-SENSITIVE COMPONENTS ON WAFER LEVEL
PROCÉDÉ SERVANT À FABRIQUER DES ÉLÉMENTS DE LENTILLE ET DES COMPOSANTS ENCAPSULÉS SENSIBLES AU RAYONNEMENT SUR UN NIVEAU DE PLAQUETTE

(30) Priorität: 13.04.2017 DE 102017206387; 28.07.2017 DE 102017213065
(43) Veröffentlichungstag der Anmeldung: 19.02.2020
(73) Patentinhaber: Fraunhofer-Gesellschaft zur Förderung der angewandten Forschung e.V., 80686 München (DE)
(72) Erfinder: LASKE, Norman, 25596 Bokelrehm (DE); QUENZER, Hans-Joachim, 25524 Itzehoe (DE); STENCHLY, Vanessa, 25704 Meldorf (DE); KULKARNI, Amit, 22335 Hamburg (DE); SCHULZ-WALSEMANN, Arne Veit, 25560 Oldenborstel (DE)
(74) Vertreter: Hersina, Günter
(86) Internationale Anmeldenummer: PCT/EP2018/059460
(87) Internationale Veröffentlichungsnummer: WO 2018/189334

(56) Entgegenhaltungen:
- JP-A- 2000 052 443
- JP-B2- 5 431 694
- KR-A- 20040 093 607
- US-A- 6 049 430
- US-A1- 2015 064 883

## Beschreibung

Die vorliegende Erfindung bezieht sich auf ein Herstellungsverfahren für Linsenelemente auf Waferebene und ein Herstellungsverfahren von gehäusten, strahlungsempfindlichen Bauelementen auf Waferebene, und insbesondere auf ein Herstellungsverfahren für plankonvexe Siliziumlinsen auf Waferebene und für gehäuste, für IR-Strahlung empfindliche Sensorelemente auf Waferebene.

Durch die preiswerten Herstellungsverfahren für IR-Sensoren steigt auch die Nachfrage nach preiswerten IR optischen Komponenten, allen voran für Linsen. Silizium ist hierfür ein geeignetes Material, ist es doch in weiten Bereichen, insbesondere aber in den technisch bedeutsamen IR-Bereichen von 3-5 µm und 8-25 µm weitgehend transparent. Da die ungekühlten IR-Sensoren, wie etwa Thermopiles oder Bolometer, bereits mit Verfahren der Mikroelektronik und Mikrosystemtechnik auf Silizium-Wafern gefertigt werden, besteht auch die Forderung, die Siliziumlinsen auf Waferebene herzustellen.

Die US 2015/064883 A1 bezieht sich auf ein Verfahren und ein System zum Herstellen einer halb-leitfähigen Rückwandplatine.

Die JP 2000 052443 A bezieht sich auf eine Verbundbasis und deren Herstellung.

Die KR 2004 0093607 A bezieht sich auf ein Herstellungsverfahren eines hybriden Mikrolinsenarrays.

Die US 6 049 430 A bezieht sich auf eine Objektivlinse mit hoher numerischer Apparatur, die in Waferform herstellbar ist.

Die JP 5 431 694 B2 bezieht sich auf einen pyroelektrischen Infrarotdetektor.

Die heutigen waferbasierten Herstellungsverfahren für Siliziumlinsen haben allerdings alle spezifische Nachteile, insbesondere dann, wenn die Linsen kurze Brennweiten besitzen sollen. Diese Linsen mit engen Krümmungsradien (ROC: radius of curvature) haben auch eine vergleichsweise hohe Pfeilhöhe im Bereich von 50-200 µm je nach Durchmesser der Apertur der Linse. Herstellungsverfahren, die sich auf Plasmaätzverfahren stützen, haben daher einen vergleichsweise langen und teuren Ätzvorgang zur Folge.

Die wichtigsten derzeitigen Herstellungsverfahren für Siliziumlinsen auf Waferebene sind:
a) Die Herstellung von Linsen aus Photoresist, sei es durch Auftropfen oder durch Schmelzen von Photolackstrukturen auf einem Silizium-Wafer und anschließendes Plasmaätzen in das Siliziumsubstrat, wobei die Resiststruktur in dem Maße abgetragen wird wie die Linsenstruktur in das Siliziumsubstrat übertragen wird.
b) Herstellung einer Linsenstruktur aus Photoresist mittels Grautonlithographie. Auch hier wird anschließend die Lackstruktur durch Plasmaätzen in das Siliziumsubstrat möglichst formtreu übertragen.
c) Nasschemisches Ätzen: Hier kommen geschlossene Photoresiststrukturen zum Einsatz, die mit einer großen Anzahl von Öffnungen versehen sind. Über die Dichte, Größe und Lage dieser Öffnungen kann der isotrope Ätzangriff gesteuert werden, so dass linsenförmige Gebilde hergestellt werden können.

Allen diesen Prozessen ist jedoch gemein, dass die großen Ansprüche an die Formtreue der Linsen nur sehr schwierig zu erreichen sind. Insbesondere ist es sehr schwierig, die Qualität des Strukturierungsprozesses über den gesamten Wafer hinweg zu gewährleisten. Insgesamt sind daher die Waferausbeuten sehr problematisch gerade vor dem Hintergrund, dass sehr große Ausbeuten über den einzelnen Wafer hinweg gewährleistet sein sollten.

Ausgehend von dem vorliegenden Stand der Technik besteht die der vorliegenden Erfindung zugrunde liegende Aufgabe darin, ein verbessertes und effektiveres Herstellungsverfahren für Linsenelemente, z.B. Siliziumlinsen, und für IR-Strahlung empfindliche Sensorelemente auf Waferebene zu schaffen.

Insbesondere besteht ein Bedarf darin, Siliziumlinsen möglichst präzise auf Waferebene herzustellen und noch auf Waferebene mit Bauelementen, wie z.B. den IR Sensoren, hermetisch dicht fügen zu können. Dabei sollten die IR-Linsen auch noch integraler Bestandteil der vakuumdichten Abdeckung der Bauelemente (IR-Sensoren) sein. Hierfür sollten die Wafer aber eine sehr große Ausbeute (> 97%) besitzen, da andernfalls viele Bauelemente durch die aufmontierten fehlerhaften Linsen ausfallen.

Diese Aufgabe wird durch die unabhängigen Patentansprüche gelöst.

Erfindungsgemäße Weiterbildungen sind in den Unteransprüchen definiert.

Ein Herstellungsverfahren 100 umfasst folgende Schritte: Bereitstellen 202 eines ersten Teilsubstrats 10 mit daran angeordneten Kugelelementen 14, Bereitstellen eines zweiten Teilsubstrats 30; 40; 56; 60; 70; 71, das eine Glasmaterialschicht 30; 44; 74 aufweist, Anordnen 222 des zweiten Teilsubstrats 30; 40; 56; 60; 70; 71 auf dem ersten, mit den Kugelelementen 14 versehenen Teilsubstrat 10, Fixieren 200 mittels Tempern und Ausübens von mechanischem Druck der Kugelelemente 14 an der Glasmaterialschicht 30; 44; 54 des zweiten Teilsubstrats, Entfernen des ersten Teilsubstrats 10 von den an der Glasmaterialschicht 30; 44; 54; 74 fixierten Kugelelementen 14, und einseitiges Dünnen 300 der an der Glasmaterialschicht 30; 44; 54; 74 des zweiten Teilsubstrats 30; 40; 56; 60; 70; 71 fixierten Kugelelemente 14, um plankonvexe Linsenelemente 24 zu erhalten.

Ein Verfahren zur Herstellung eines gehäusten Bauelements auf Waferebene umfasst folgende Schritte: Herstellen eines mit plankonvexen Linsenelementen versehenen Trägersubstrats, wobei ein Halbleitermaterial aufweisende Kugelelemente 14, z.B. Kugelelemente 14 aus einem Halbleitermaterial, 22 mittels Druck und Wärme an einem Trägersubstrat 22 fixiert werden und wobei die an dem Trägersubstrat 22 fixierten Kugelelemente 14 einseitig gedünnt werden, um plankonvexe Linsenelemente 24 aus einem Halbleitermaterial zu bilden; Bereitstellen eines Bauelementesubstrats mit einer Vielzahl von Bauelementen; Anordnen der Substrate aneinander, so dass die an dem Trägersubstrat angeordneten Linsenelemente mit den zugeordneten Bauelementen des Bauelementesubstrats ausgerichtet sind; und Vereinzeln des Trägersubstrats mit dem daran angeordneten Bauelementesubstrat, um vereinzelte, mit jeweils zumindest einem Linsenelement versehene Bauelemente zu erhalten.

Der Kerngedanke der vorliegenden Erfindung besteht nun darin, Linsenelemente aus einem geeignetem Material, wie z.B. einem Halbleitermaterial, wie z.B. Siliziumlinsen und insbesondere plankonvexe Siliziumlinsenelemente, auf Waferebene herzustellen zu können, indem Kugelelemente (Vollkugelelemente oder Kugelsegmentelemente z.B. aus einem Halbleitermaterial) mittels Druck und Wärme an einer Glasmaterialschicht eines Trägersubstrats fixiert bzw. in dasselbe eingebettet werden. Die Kugelelemente weisen einen Kugelradius R auf. Das Trägersubstrat mit der Glasmaterialschicht und den daran fixierten Kugelelementen wird dann einem (mechanischen) Dünnungsprozess (Schleifen bzw. Grinding) unterzogen, so dass die an dem Trägersubstrat fixierten Kugelelemente einseitig gedünnt werden, um die plankonvexen Siliziumlinsenelemente zu bilden. Der Dünnungsprozess kann nun solange ausgeführt werden, bis die erforderliche "Pfeilhöhe", d.h. die Höhe des resultierenden Kugelsegments, basierend auf dem vorgegeben Krümmungsradius (ROC: radius of curvature) exakt eingestellt ist, so dass die gewünschten optischen Eigenschaften des resultierenden Siliziumlinsenelements exakt erhalten werden können, da der konvexseitige Krümmungsradius der Siliziumlinsenelemente exakt dem Kugelradius der Siliziumkugelelemente entspricht.

Das erfindungsgemäße Konzept ermöglicht, Siliziumlinsen äußerst präzise auf Waferebene herzustellen und noch auf Waferebene mit Bauelementen, wie z.B. den IR Sensoren, hermetisch dicht zu fügen. Dabei können die IR-Linsen auch noch integraler Bestandteil der vakuumdichten Abdeckung der Bauelemente (IR-Sensoren) sein. Ferner kann erreicht werden, dass die Wafer eine sehr große Ausbeute (> 97%) besitzen und somit nur sehr wenige Bauelemente durch aufmontierte fehlerhafte Linsen ausfallen.

Bevorzugte Ausführungsbeispiele der vorliegenden Erfindung werden nachfolgend unter Bezugnahme auf die beiliegenden Zeichnungen näher erläutert. Es zeigen:
- Fig. 1: ein Flussdiagramm des erfindungsgemäßen Herstellungsverfahrens gemäß einem Ausführungsbeispiel;
- Fig. 2: ein beispielhaftes prinzipielles Ablaufdiagramm des erfindungsgemäßen Herstellungsverfahrens gemäß einem weiteren Ausführungsbeispiel;
- Fig. 3: ein beispielhaftes prinzipielles Ablaufdiagramm des erfindungsgemäßen Herstellungsverfahrens gemäß einem weiteren Ausführungsbeispiel;
- Fig. 4A: ein beispielhaftes prinzipielles Ablaufdiagramm des erfindungsgemäßen Herstellungsverfahrens gemäß einem weiteren Ausführungsbeispiel;
- Fig. 4B: ein beispielhaftes prinzipielles Ablaufdiagramm des erfindungsgemäßen Herstellungsverfahrens gemäß einem weiteren Ausführungsbeispiel;
- Fig. 5: ein beispielhaftes prinzipielles Ablaufdiagramm des erfindungsgemäßen Herstellungsverfahrens gemäß einem weiteren Ausführungsbeispiel;
- Fig. 6: ein beispielhaftes prinzipielles Ablaufdiagramm des erfindungsgemäßen Herstellungsverfahrens gemäß einem weiteren Ausführungsbeispiel;
- Fig. 7A: ein beispielhaftes prinzipielles Ablaufdiagramm des erfindungsgemäßen Herstellungsverfahrens gemäß einem weiteren Ausführungsbeispiel;
- Fig. 7B: ein beispielhaftes prinzipielles Ablaufdiagramm des erfindungsgemäßen Herstellungsverfahrens gemäß einem weiteren Ausführungsbeispiel;
- Fig. 7C: ein beispielhaftes prinzipielles Ablaufdiagramm des erfindungsgemäßen Herstellungsverfahrens gemäß einem weiteren Ausführungsbeispiel;
- Fig. 8: ein beispielhaftes prinzipielles Ablaufdiagramm des erfindungsgemäßen Herstellungsverfahrens gemäß einem weiteren Ausführungsbeispiel;
- Fig. 9: ein beispielhaftes prinzipielles Block- bzw. Ablaufdiagramm des erfindungsgemäßen Herstellungsverfahrens gemäß einem weiteren Ausführungsbeispiel;
- Fig. 10: ein beispielhaftes prinzipielles Ablaufdiagramm eines Verfahrens zur Herstellung eines gehäusten Bauelements auf Waferebene;
- Fig. 11: eine beispielhafte Ausführungsformen für ein gehäustes strahlungsempfindliches Bauelement gemäß einem Ausführungsbeispiel, das beispielsweise mit einem hier beschriebenen Verfahren hergestellt ist; und
- Fig. 12: eine beispielhafte Ausführungsform mit mehreren strahlungsempfindlichen Bauelementen und zugeordneten Linsenelementen in demselben Gehäuse.

Bevor nachfolgend Ausführungsbeispiele der vorliegenden Erfindung im Detail anhand der Zeichnungen näher erläutert werden, wird darauf hingewiesen, dass identische funktionsgleiche oder gleichwirkende Elemente, Objekte, Funktionsblöcke und/oder Verfahrensschritte in den unterschiedlichen Figuren mit den gleichen Bezugszeichen versehen sind, so dass die in unterschiedlichen Ausführungsbeispielen dargestellte Beschreibung dieser Elemente, Objekte, Funktionsblöcke und/oder Verfahrensschritte (mit gleichen Bezugszeichen) untereinander austauschbar ist bzw. aufeinander angewendet werden kann. In der nachfolgenden Beschreibung bedeutet die Beschreibung eines Elements aus einem Halleitermaterial, dass das Element ein Halbleitermaterial aufweist, d.h. zumindest teilweise oder auch vollständig aus dem Halbleitermaterial gebildet ist.

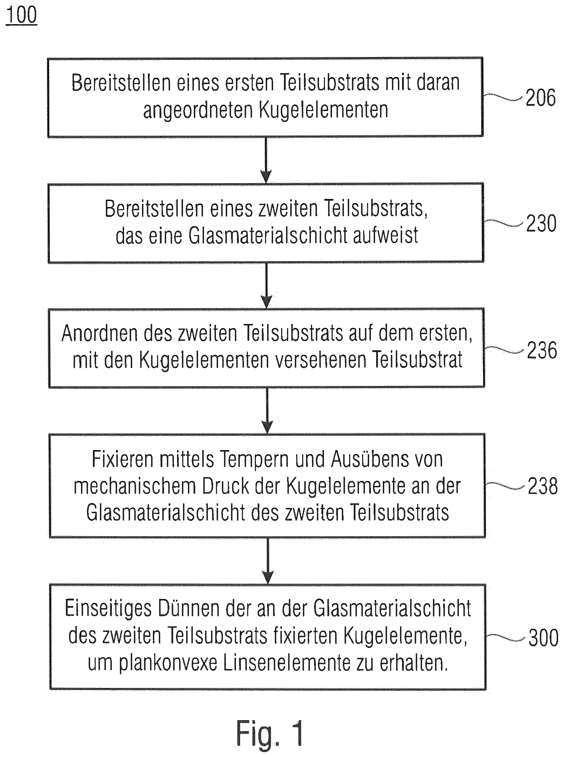

Fig. 1 zeigt nun ein Flussdiagramm des erfindungsgemäßen Verfahrens 100 zur Herstellung von Linsenelementen, z.B. Linsenelementen aus einem Halbleitermaterial, wie z.B. Silizium, auf Waferebene, wobei die resultierenden Linsenelemente plankonvex ausgebildet sind. Da für das erfindungsgemäße Verfahren zur Herstellung von Linsenelementen auf Waferebene als ein geeignetes Material Silizium für die Linsenelemente angegeben wird, wird im Nachfolgenden häufig auch von "Siliziumlinsenelementen (oder Si-Linsenelementen)" gesprochen. Es sollte aber deutlich werden, dass die Verwendung von Silizium als Material für die Linsenelemente nur beispielhaft ist, wobei je nach Anwendungsbereich beispielsweise auch andere, für den gewünschten Wellenlängenbereich (möglichst) transparente Materialien bzw. Halbleitermaterialien, wie z.B. GaAs, CdTe, Ge, ZnSe, ZnS, KRS-5, CaF2, BaF2, etc. für die Linsenelemente verwendet werden können.

Bezug nehmend auf das Verfahren 100 von Fig. 1 wird nun ein erstes Teilsubstrat mit daran angeordneten Kugelelementen bereitgestellt, woraufhin ein zweites Teilsubstrats bereitgestellt, das eine Glasmaterialschicht aufweist. Das zweite Teilsubstrat wird auf dem ersten, mit den Kugelelementen versehenen Teilsubstrat angeordnet. Bei einem weiteren Schritt 200 werden die Kugelelemente, d.h. beispielsweise Vollkugel- oder Kugelsegmentelemente aus einem Halbleitermaterial, wie z.B. Silizium, mittels Ausübens von mechanischem Druck und Wärme (Tempern) an einem Trägersubstrat fixiert. Die Kugelelemente (Si-Kugelelemente) weisen dabei einen vorgegebenen Kugelradius R auf. Daraufhin wird das erste Teilsubstrat von den an der Glasmaterialschicht fixierten Kugelelementen entfernt.

In einem nachfolgenden Schritt 300 werden die an dem Trägersubstrat fixierten Kugelelemente (z.B. Si-Kugelelemente) einseitig, mechanisch gedünnt, z.B. mittels Schleifverfahren (Grinding), um die plankonvexen Linsenelemente z.B. aus einem Halbleitermaterial, wie Silizium etc., zu erhalten. Dabei entspricht der konvexseitige Krümmungsradius der hergestellten Linsenelemente dem Kugelradius R der (unbearbeiteten bzw. nicht gedünnten) an dem Trägersubstrat fixierten Kugelelemente. Durch das einseitige Dünnen der an dem Trägersubstrat fixierten Kugelelemente wird ferner die plane bzw. ebene Seite der plankonvexen Linsenelemente gebildet.

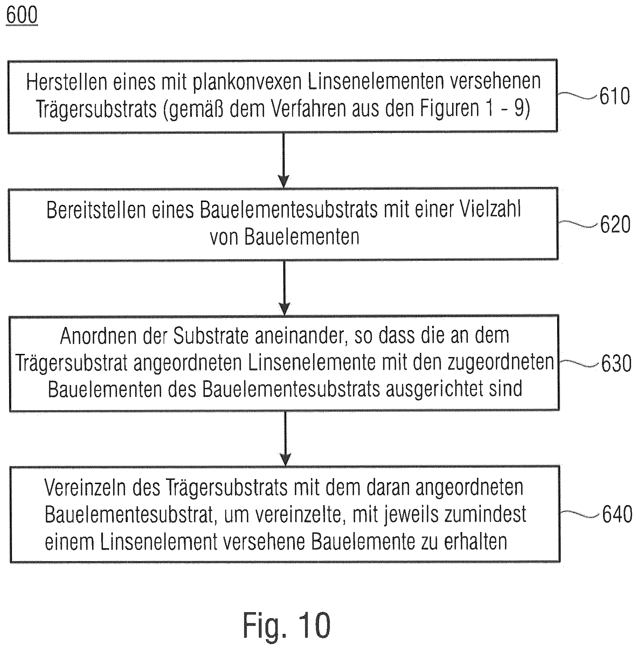

Bei einem nachfolgenden optionalen Schritt 630, vgl. Fig. 10, werden Bauelemente, wie z.B. optische Sensoren (IR-Sensoren), an dem mit den Linsenelementen versehenen Trägersubstrat fixiert, um eine Anordnung mit Bauelementen zu erhalten, wobei die Bauelemente jeweils mit zumindest einem Linsenelement versehen sind.

Die Bauelemente können an einem Substrat (Bauelementesubstrat bzw. Bauelementewafer) angeordnet sein, so dass das mechanische Fixieren 630 bzw. das hermetisch dichte Fügen oder Bonden der Linsenelemente mit den Bauelementen als Bondverfahren zweier Wafer erfolgen kann. Bei einem nachfolgenden Schritt 640 kann nun das Trägersubstrat mit den daran angeordneten Bauelementen (bzw. mit dem daran angeordneten Bauelementesubstrat) vereinzelt werden, um dann die vereinzelten, mit jeweils zumindest einem Linsenelement versehene Bauelemente (optische Sensoren bzw. IR-Sensoren) zu erhalten.

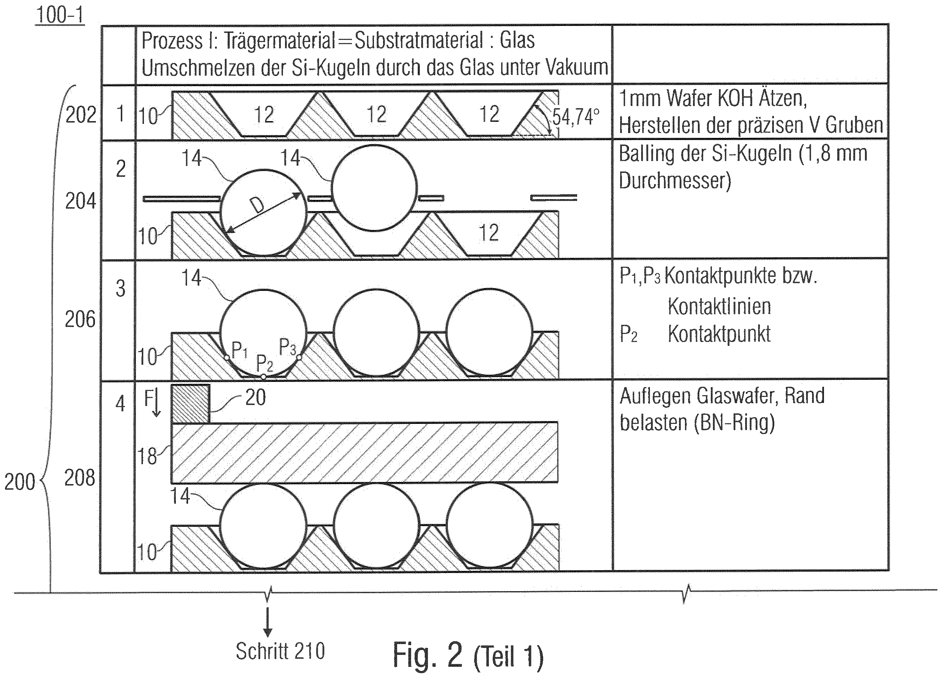

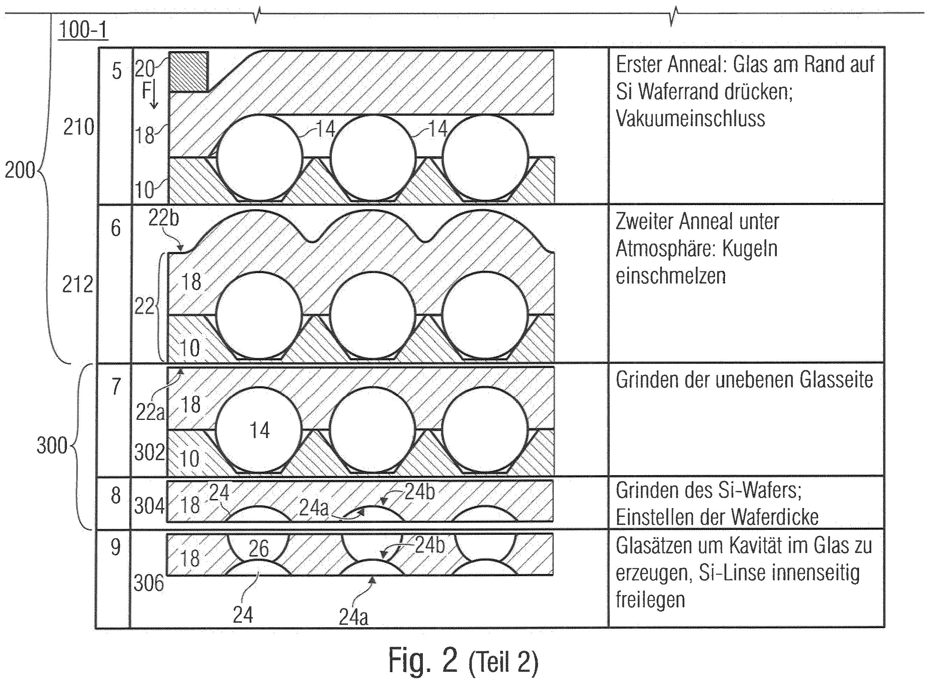

Im Folgenden werden nun anhand der Fig. 2 bis 9 beispielhafte Prozessfolgen bzw. Prozessabläufe zur Implementierung des in Fig. 1 dargestellten Herstellungsverfahrens 100 beschrieben.

Alle nachfolgend beschriebenen Prozessalternativen basieren auf dem grundlegenden Konzept, dass zunächst Kugelelemente z.B. aus einem Halbleitermaterial an einem Trägersubstrat mittels Druck und Wärme fixiert bzw. in diesem eingebettet werden, woraufhin die an dem Trägersubstrat fixierten Kugelelemente einseitig, mechanisch gedünnt werden, um plankonvexe Linsenelemente aus einem Halbleitermaterial, wie z.B. Silizium, zu erhalten. Je nach Prozessfolge ist es auch möglich, dass das Trägersubstrat nur einseitig oder auch beidseitig dem mechanischen Dünnen (Schleifen bzw. Grinding) unterzogen wird.

Fig. 2 zeigt nun ein beispielhaftes Ablaufdiagramm 100-1 des erfindungsgemäßen Herstellungsverfahrens von plankonvexen Linsenelementen, z.B. Linsenelementen aus einem Halbleitermaterial, wie z.B. Silizium, auf Waferebene. Im Folgenden wird nun zunächst der Prozessablauf des Schritts 200 des Fixierens von Kugelelementen aus einem Halbleitermaterial, wie z.B. Silizium, an einem Trägersubstrat beschrieben.

Zunächst wird bei einem Schritt 202 ein erstes (Teil-)Substrat 10 mit Vertiefungen 12 bereitgestellt. Das erste Teilsubstrat 10 ist zum Aufnehmen von Kugelelementen vorgesehen, wobei die Vertiefungen 12 z.B. quadratisch bzw. rechteckig oder kreisrund ausgebildet sein können.

Das erste Teilsubstrat 10 kann beispielsweise ein Halbleiterwafer mit einer Dicke zwischen 0,5 und 2,0 mm oder 0,8 bis 1,2 mm bzw. mit einer Dicke von etwa 1 mm sein. Beispielsweise kann ein Silizium-Wafer mit einer Dicke von etwa 1 mm (bzw. zwischen 0,5 und 2,0 mm oder 0,8 bis 1,2 mm) verwendet werden, wobei beispielsweise mittels eines KOH-Ätzvorgangs (KOH = Kaliumhydroxid) präzise die Vertiefungen (V-Gruben) hergestellt werden können. Falls es sich bei dem Halbleiterwafer um ein (100)-Siliziummaterial handelt, ergibt sich wie in Fig. 1 beispielhaft angegeben, ein Ätzwinkel gegenüber von 54,74° der Horizontalen. Bei anderen Halbleitermaterialien bzw. anderen Schnittebenen des Halbleitermaterials lassen sich andere Ätzwinkel erreichen bzw. realisieren.

Wie in Fig. 2 bei Schritt 204 dargestellt ist, können nun eine Vielzahl von Kugelelementen 14 aus einem Halbleitermaterial mit einem Durchmesser D = 2R (z.B. D ist etwa 1,8 mm bzw. D ist zwischen 1,0 bis 2,5 mm oder zwischen 1,5 bis 2,1 mm) bereitgestellt werden, wobei dann jeweils ein Kugelelement 14 in eine der Vertiefungen 12 des ersten Teilsubstrats 10 eingebracht wird, so dass sich z.B. jeweils ein Kugelelement 14 in einer Vertiefung 12 des ersten Teilsubstrats befindet. Dieser Vorgang wird auch als "Balling" bezeichnet.

Die Vertiefungen 12 in dem ersten Teilsubstrat 10 können mittels herkömmlicher Halbleiterbearbeitungstechniken, wie z.B. Ätzverfahren, mit einer hohen Genauigkeit gebildet werden, so dass eine exakte Passform zwischen dem jeweiligen Kugelelement 14 und den Boden- bzw. Seitenwänden der Vertiefungen 12 erreicht werden kann. Bei Schritt 204 sind beispielsweise (in der Schnittansicht drei) exakt einstellbare Kontaktpunkte p1, p2 und p3 (bzw. ein Kontaktpunkt p2 (optional) und eine Kontaktlinie p1, p3) angegeben. Damit kann eine sehr genaue Anordnung und Positionierung der Kugelelemente 14 an dem ersten Teilsubstrat 10 erreicht werden. Bei Schritt 206 sind nun die Kugelelemente 14 in den Vertiefungen 12 des ersten Teilsubstrats 10 angeordnet und stehen zur Weiterverarbeitung zur Verfügung.

Bei einem weiteren Schritt 208 wird ein zweites (Teil)-Substrat 18 auf dem mit den Kugelelementen 14 versehenen ersten Teilsubstrat 10 angeordnet, das zweite Teilsubstrat 18 kann beispielsweise ein Glasmaterial aufweisen. Bei Schritt 208 kann also ein "Glas-Wafer" 18 auf das mit den Kugelelementen 14 versehene Teilsubstrat 10 "aufgelegt" werden. Wie bei Schritt 208 ferner dargestellt ist, kann ein Ring 20 (z.B. ein BN-Ring, BN = Boronnitrid) an dem Randbereich des zweiten Teilsubstrats 18 umlaufend vorgesehen sein, um bei einem nachfolgenden Temperaturbehandlungsschritt 210 (Tempern "T-1" bzw. erster Anneal) bei einer Temperatur von beispielsweise 700-900 °C das erste und das zweite Teilsubstrat 10, 18 zumindest in einem Randbereich (Waferrand) fest aneinander zu fixieren (zu bonden). Dazu wird zusätzlich zur Temperaturbehandlung durch den Ring 20 mechanischer Druck auf das Glasmaterial des zweiten Teilsubstrats 10 ausgeübt wird.

Bei diesem ersten Temper-Vorgang wird also beispielsweise das Glasmaterial des zweiten Teilsubstrats 18 auf den Randbereich des ersten Teilsubstrats 10 (z.B. Si-Waferrandbereich) gedrückt, um an diesem Randbereich die Glas-Si-Fixierung zwischen dem ersten und zweiten Teilsubstrat 10 und 18 zu erhalten. Dieser erste Temper-Vorgang T-1 wird beispielsweise unter einer Atmosphäre mit äußerst niedrigem Druck (d.h. hohem Unterdruck) bzw. möglichst unter Vakuum (soweit technisch realisierbar), durchgeführt, so dass in dem eingeschlossenen inneren Bereich zwischen dem ersten und zweiten Teilsubstrat 18 eine entsprechende Atmosphäre möglichst annähernd mit Vakuum gebildet wird, so dass ein Vakuumeinschluss erhalten werden kann. Als Vakuum kann ein Grobvakuum mit 300...1 hPa (mbar), ein Feinvakuum mit 1...10⁻³ hPa, ein Hochvakuum (HV) mit 10⁻³...10⁻⁷ hPa, ein Ultrahochvakuum (UHV) mit 10⁻⁷...10⁻¹² hPa, oder ein extrem hohes Vakuum (XHV) < 10⁻¹² hPa eingesetzt werden.

Bei einem weiteren Temperaturbehandlungsschritt 212 (zweiter Anneal oder Tempern T2) mit den beiden aneinander fixierten Teilsubstraten 10, 18 wird eine zumindest teilweise Verflüssigung bzw. eine hinreichende Erweichung des Glasmaterials des zweiten Teilsubstrats 18 erreicht, so dass die Kugelelemente 14 zumindest teilweise mit dem verflüssigten bzw. hinreichend erweichten Glasmaterial des zweiten Teilsubstrats 18 umflossen werden, d.h. dass das verflüssigte bzw. fließfähige Glasmaterial des zweiten Teilsubstrats 18 (entsprechend der erreichten Viskosität des verflüssigten Glasmaterials) um und zwischen die Kugelelemente 14 in die vorhandenen Zwischenräume hineinfließt. Dabei wird z.B. ein normaler bzw. höherer Atmosphärendruck verwendet, um die Kugelelemente 14 in das Glasmaterial des zweiten Teilsubstrats 18 einzuschmelzen. Nach einer Wiederverfestigung des Glasmaterials des zweiten Teilsubstrats 18 sind also die Kugelelemente 14 zwischen dem ersten Teilsubstrat 10 und dem verfestigten Glasmaterial des zweiten Teilsubstrats 18 eingebettet bzw. eingeschmolzen. Somit bilden das erste Teilsubstrat 10 und das wiederverfestigte Glasmaterial des zweiten Teilsubstrats 18 das Trägersubstrat 22, in dem die Kugelelemente 14 fixiert bzw. eingebettet sind.

Bei dem anhand von Fig. 2 dargestellten Prozessablauf 100-1 des erfindungsgemäßen Herstellungsverfahrens wird also beispielsweise als Trägermaterial für die Linsenelemente ein Glasmaterial bzw. Glassubstratmaterial verwendet, wobei die Kugelelemente (z.B. Si-Kugeln) von dem Glasmaterial unter Vakuum umschmolzen werden, um die Einbettung der Kugelelemente in das Trägersubstrat zu erreichen.

Für die nachfolgende Beschreibung wird der freiliegende, äußere Bereich des ersten Teilsubstrats 10, d.h. die Unterseite bezüglich der Anordnung in Schritt 212 von Fig. 2, als erster Hauptoberflächenbereich 22a des Trägersubstrats 22 bezeichnet, während der freiliegende, äußere Bereich des zweiten Teilsubstrats 18, d.h. die Oberseite bezüglich der bei Schritt 212 von Fig. 2 dargestellten Anordnung, als zweiter Hauptoberflächenbereich 22b des Trägersubstrats 22 bezeichnet wird.

Der Verfahrensschritt 212 von Fig. 2 basiert dabei beispielsweise auf Techniken des sogenannten Glasfließens. Als Glasmaterialien für das zweite Teilsubstrat 18 kommen beispielsweise folgende Glasmaterialien infrage, wie z.B. Pyrex, Borofloat, AF32, Eagle XG, Hoya SD 2, usw., wobei diese Auflistung nicht als abschließend anzusehen ist. Als Material bzw. Halbleitermaterial des ersten Teilsubstrats 10 kommt beispielsweise Silizium infrage. Dabei sollte der thermische Ausdehnungskoeffizient (CTE = Coefficient of Thermal Extension) der Glasmaterialien des zweiten Teilsubstrats 18 zu dem verwendeten Halbleitermaterial des ersten Teilsubstrats 10 passen, um die resultierenden thermomechanischen Spannungen möglichst niedrig zu halten. Angepasste thermische Ausdehnungskoeffizienten bedeuten beispielsweise, dass der CTE des Glasmaterials in Ausführungsbeispielen nicht um mehr als 1-2 ppm/°C von dem CTE des verwendeten Halbleitermaterials abweicht. Bei Ausführungsformen ist das CTE des Glasmaterials beispielsweise gewählt, um weniger als 0,5 ppm/°C von dem CTE des Halbleitermaterials abzuweichen.

Um nun die gewünschten plankonvexen Linsenelemente aus den Kugelelementen 14 zu erhalten, wird das Trägersubstrat 22 beidseitig (z.B. mechanisch) gedünnt, d.h. mittels eines Schleifverfahrens (Grinding) bearbeitet. Ausgehend von dem zweiten Hauptoberflächenbereich 22b des Trägersubstrats 22 werden bei dem mechanischen Dünnungsprozess Unebenheiten in dem verfestigten Glasmaterial des zweiten Teilsubstrats 18 eingeebnet bzw. planarisiert.

Bei dem Schritt 304 wird nun einerseits das Material des ersten Teilsubstrats 10, z.B. mittels Schleifen, entfernt, wobei ferner die an dem resultierenden Trägersubstrat 22 fixierten Kugelelemente 14 ausgehend von dem ersten Hauptoberflächenbereich 22a des Trägersubstrats 22 gedünnt (mechanisch abgeschliffen) werden, um plankonvexe Linsenelemente 24 zu erhalten. Über das exakte Einstellen der resultierenden Waferdicke des Trägersubstrats 22 können die exakten optischen Eigenschaften der resultierenden Linsenelemente 24 eingestellt werden. Dabei ist die ebene Seite 24a der resultierenden plankonvexen Linsenelemente bündig mit der gedünnten Rückseite (ersten Hauptoberfläche) des Trägersubstrats 22, während sich die konvexe Seite 24b der Linsenelemente 24 in dem verfestigten Glasmaterial des zweiten Teilsubstrats 18 befindet. Der Radius R der resultierenden plankonvexen Linsenelemente entspricht dabei dem Radius der ursprünglichen Kugelelemente 14, während die Höhe (Pfeilhöhe) der resultierenden plankonvexen Linsenelemente 24 über die Einstellung der resultierenden Waferdicke bei dem mechanischen Dünnungsprozess erhalten bzw. eingestellt wird. Als Pfeilhöhe wird in diesem Zusammenhang der Abstand zwischen der ebenen Fläche 24a der plankonvexen Linsenelemente 24 und dem Scheitelpunkt der konvexen Seite 24b der Linsenelemente 24 bezeichnet.

Bei einem nachfolgenden Schritt 306 können nun (z.B. einseitig offene) Kavitäten ausgehend von dem äußeren, freiliegenden Oberflächenbereich des zweiten Teilsubstrats, d.h. ausgehend von dem zweiten Hauptoberflächenbereich 22b des gedünnten Trägersubstrats 22, zu den Linsenelementen 24 erfolgen. Dabei kann jeweils eine Kavität 26 pro Linsenelement 24 erzeugt werden, wobei der an die jeweilige Kavität angrenzende Bereich der konvexen Seite 24b der Linsenelemente 24 freigelegt bzw. freiliegend ist. Die Kavitäten 26 können beispielsweise mittels Glasätzprozessen in dem (restlichen) Glasmaterial des ersten Teilsubstrats gebildet werden, so dass die plankonvexen Linsenelemente (Si-Linsen) 24 innenseitig, d.h. hinsichtlich des zweiten Hauptoberflächenbereichs 22b, freigelegt bzw. freiliegend sind.

Die ober dargestellten Verfahrensschritte 200, 204, 206, 208, 210 und 212 bilden somit zusammen den Schritt 200 des Fixierens 200 von Kugelelementen aus einem Halbleitermaterial an einem Trägersubstrat, während mit den Einzelschritten 302, 304 und 306 von Fig. 2 der Schritt 300 des einseitigen Dünnens der an dem Trägersubstrat fixierten Kugelelemente zum Bilden der plankonvexen Linsenelemente aus einem Halbleitermaterial realisiert wird.

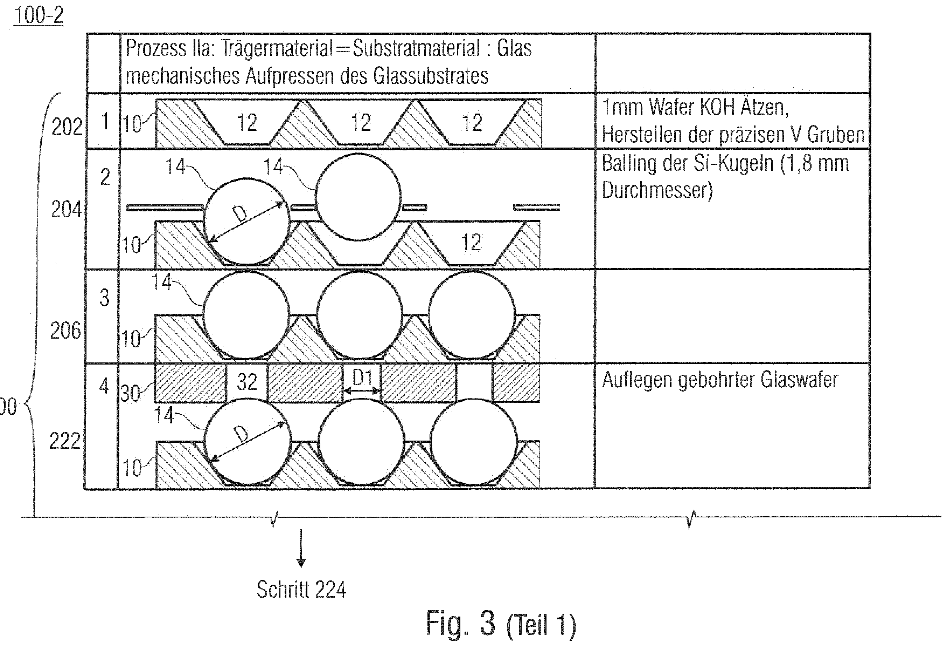

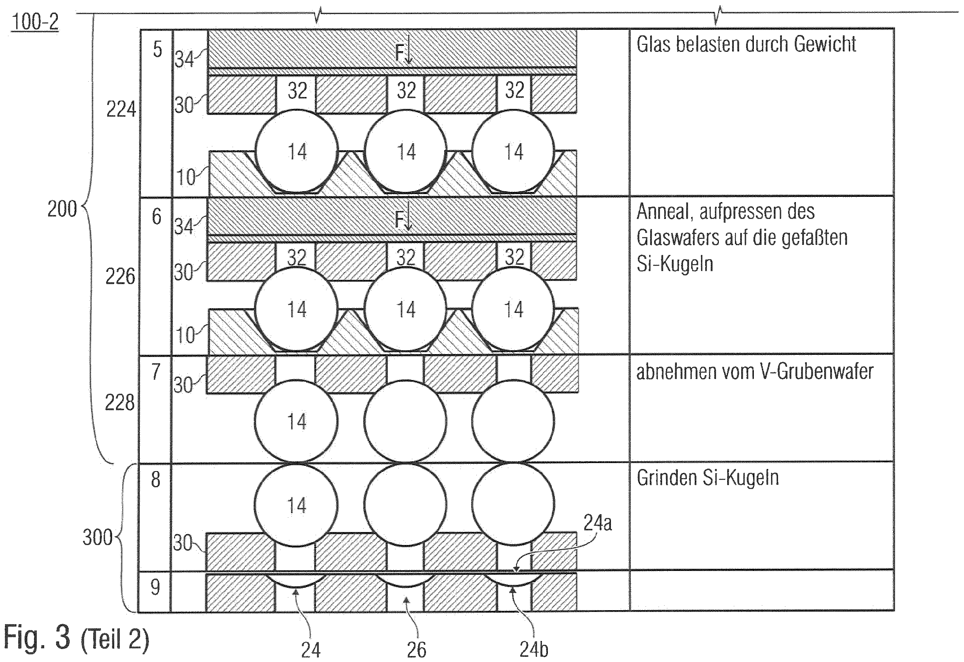

Im Folgenden wird nun anhand von Fig. 3 ein beispielhaftes Ablaufdiagramm eines weiteren Herstellungsverfahrens 100-2 zur Herstellung von plankonvexen Linsenelementen (zumindest teilweise) aus einem Halbleitermaterial auf Waferebene beschrieben.

Bei Schritt 202 wird ein mit Vertiefungen 12 versehenes erstes Teilsubstrat 10 bereitgestellt. Bei Schritt 204 werden Kugelelemente 14 in den Vertiefungen 12 des ersten Teilsubstrats 10 angeordnet bzw. eingefügt, so dass sich jeweils ein Kugelelement 14 in einer Vertiefung 12 des ersten Teilsubstrats befindet (Schritt 206).

Bei Schritt 222 wird ein zweites, ein Glasmaterial aufweisendes Teilsubstrat 30 bereitgestellt, das Vertiefungen 32, wie z.B. durchgehende Bohrungen oder Durchführungen in dem zweiten Teilsubstrat 30, aufweist.

Das zweite Teilsubstrat 30 wird auf dem ersten, mit den Kugelelementen 14 versehenen Teilsubstrat 10 angeordnet, wobei die Vertiefungen 32 in dem ersten Teilsubstrat 18 mit den in den Vertiefungen 12 des ersten Teilsubstrats 10 angeordneten Kugelelementen 14 ausgerichtet sind. Auf den mit den Kugelelementen versehenen ersten Teilsubstrat 10 (Teilwafer) wird also der gebohrte Glas-Wafer 30 aufgelegt. Dabei ist der Durchmesser D1 der Vertiefungen 32 in dem zweiten Teilsubstrat 30 kleiner als der Durchmesser D der Kugelelemente 14. Der Durchmesser D1 der Vertiefungen 32 beträgt beispielsweise 20 bis 70% bzw. 40 bis 60% des Durchmessers d der Kugelelemente 14, d.h. D1 = 0,2 - 0,7 * D bzw. D1 = 0,4 - 0,6 * D.

Bei Schritt 224 wird ein mechanischer Druck F auf das zweite Teilsubstrat 30 ausgeübt, indem das zweite Teilsubstrat 30 (z.B. ein Glassubstrat) beispielsweise durch ein Gewicht 34 belastet wird. Bei einem weiteren Schritt 226, der beispielsweise zusammen mit dem Schritt 224 durchgeführt wird, wird unter Einwirkung einer erhöhten Temperatur, z.B. in einem Bereich von 700 - 900 °C und unter Einwirken des mechanischen Drucks F (von Schritt 224) das zweite Teilsubstrat 30 an den in den Vertiefungen des ersten Teilsubstrats 10 angeordneten Kugelelementen 14 fixiert bzw. auf diese aufgepresst. Der Glas-Wafer 30 wird also auf die gefassten (eingefassten) Halbleiterkugelelemente 14 (z.B. Siliziumkugeln) aufgepresst. Dadurch wird mittels einer Glas-Halbleiter-Bondverbindung ein Presssitz (press fit) der Kugelelemente 14 in den Vertiefungen 32 des zweiten Teilsubstrats 30 erhalten, wobei z.B. jeweils ein Kugelelement 14 an einer Vertiefung des zweiten Teilsubstrats 30 befestigt bzw. fixiert ist.

Bei einem Schritt 228 wird das erste Teilsubstrat 10 von dem fest mit dem zweiten Teilsubstrat 30 verbundenen Kugelelementen 14 entfernt, wobei das zweite Teilsubstrat 30 nun als Trägersubstrat.

Die im Vorhergehenden beschriebenen Schritte 202, 204, 206, 222, 224, 226 und 228 bilden somit den erfindungsgemäßen Schritt 200 des Fixierens der Kugelelemente 14 mittels Druck und Wärme an einem Trägersubstrat. Wie in Fig. 3 ferner dargestellt ist, werden bei dem Schritt 300 des Dünnens, bzw. mechanischen Schleifens oder Grinding, aus den an dem zweiten Teilsubstrat 30 (Trägersubstrat) fixierten Kugelelemente 14 die plankonvexen Linsenelemente 24 gebildet. Dabei befindet sich die konvexe Seite 24b der Linsenelemente 24 an den Vertiefungen 32 des zweiten Teilsubstrats (Trägersubstrats), wobei die ebene Seite 24a der plankonvexen Linsenelemente 24 durch den Schritt des Dünnens (direkt) erhalten wird. Die Vertiefungen 32 des zweiten Teilsubstrats 30 bilden dabei die (einseitig offenen) Kavitäten 26 für die plankonvexen Linsenelemente 24, wobei der an die Kavität 26 angrenzende (optisch wirksame) Bereich (der konvexen Seite 24b) der Linsenelemente 24 jeweils freigelegt bzw. freiliegend ist.

Wie die obigen Ausführungen deutlich machen, bilden somit beispielsweise die Verfahrensschritte 202, 204, 206, 222, 224, 226 und 228 den Schritt 200 des Fixierens von Kugelelementen aus einem Halbleitermaterial an einem Trägersubstrat. Ferner werden bei dem Schritt 300 die an dem Trägersubstrat fixierten Kugelelemente einseitig mechanisch gedünnt, um die plankonvexen Linsenelemente zu erhalten. Bei der anhand von Fig. 3 dargestellten Vorgehensweise weist das resultierende Trägersubstrat 22 als Substratmaterial z.B. Glas auf, wobei das in Fig. 3 dargestellte Prinzip auf einem mechanischen Aufpressen des Glassubstrats auf die an dem ersten Teilsubstrat angeordneten Kugelelemente basiert.

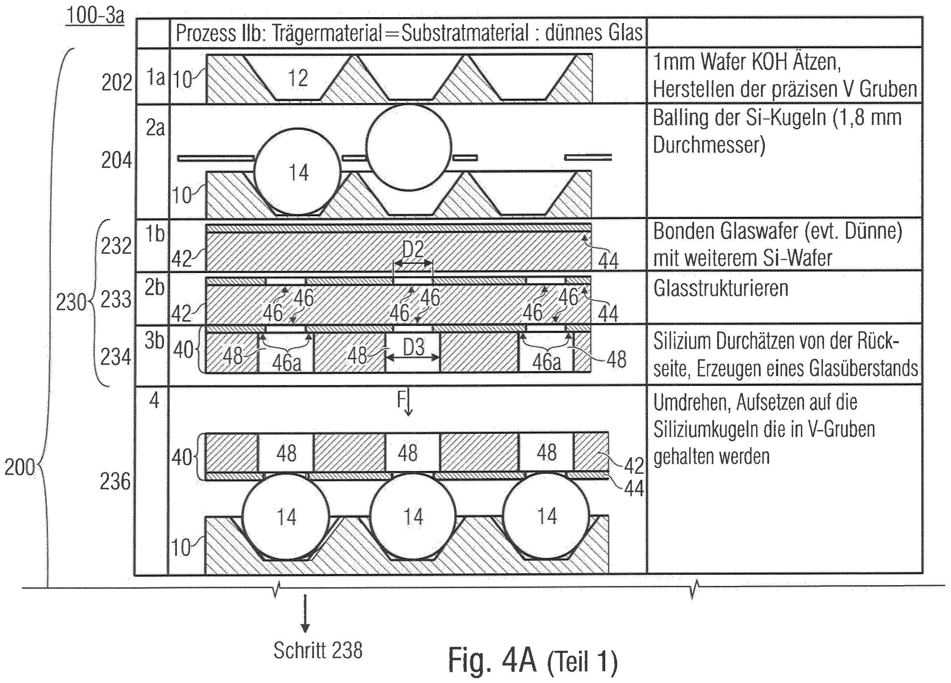

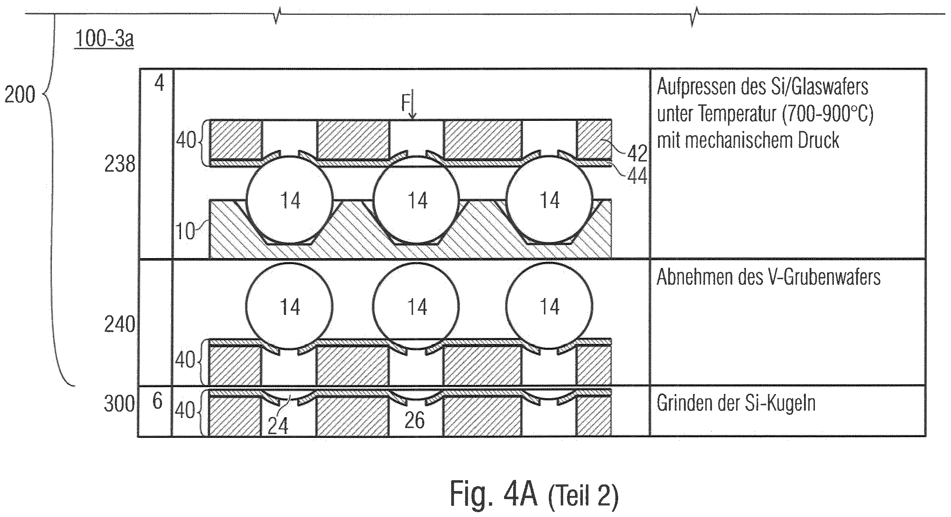

Im Folgenden wird nun anhand von Fig. 4A ein beispielhaftes Ablaufdiagramm eines weiteren Herstellungsverfahrens 100-3a zur Herstellung von plankonvexen Linsenelementen aus einem Halbleitermaterial auf Waferebene beschrieben.

Bei Schritt 202 wird ein mit Vertiefungen 12 versehenes erstes Teilsubstrat 10 bereitgestellt. Bei Schritt 204 werden Kugelelemente 14 in die Vertiefungen 12 des ersten Teilsubstrats eingefügt, so dass sich z.B. jeweils ein Kugelelement 14 in einer Vertiefung 12 des ersten Teilsubstrats befindet.

Bei Schritt 230 wird nun ein zweites Teilsubstrat 40 bereitgestellt, wobei das zweite Teilsubstrat 40 ein Hilfssubstrat 42 aus einem Halbleitermaterial, z.B. einen Silizium-Wafer, und eine Schicht 44 z.B. aus einem Glasmaterial (Glasschicht 44), die an einem ersten Hauptoberflächenbereich des Hilfssubstrats 42 angeordnet ist, aufweist.

Das Hilfssubstrat 42 weist nun Durchgangsöffnungen 48 auf, die jeweils den Positionen der auf dem ersten Teilsubstrat 10 angeordneten Kugelelementen 14 entsprechen und mit diesen ausrichtbar sind, d.h. die Durchgangsöffnungen 48 und die Kugelelemente 14 können zentriert zueinander angeordnet werden. Die Glasmaterialschicht 44 weist ferner Öffnungen 46 auf, die mit den Durchgangsöffnungen 48 des Hilfssubstrats 42 (im Wesentlichen mittig) ausgerichtet sind. Der Durchmesser D2 der Öffnungen 46 der Glasmaterialschicht 44 ist geringer als der Durchmesser D3 (D2 < D3) der Durchgangsöffnungen 48 des Hilfssubstrats 42.

Der Durchmesser D2 der Öffnungen 46 der Glasmaterialschicht 44 beträgt beispielsweise 20 bis 70% oder 40 bis 60% des Durchmessers D3 der Durchgangsöffnungen 48 des Hilfssubstrats 42, d.h. D2 = 0,2 - 0,7 * D3 oder D2 = 0,4 - 0,6 * D3. Ferner kann die Dicke der Glasmaterialschicht 44 beispielsweise zwischen 10 und 100 µm, zwischen 30 und 70 µm und etwa 50 µm betragen.

Dabei ist der Durchmesser D3 der Durchgansöffnungen 48 in dem Hilfssubstrat kleiner als der Durchmesser D der Kugelelemente 14. Der Durchmesser D3 der Durchgansöffnungen 48 beträgt beispielsweise 20 bis 70% bzw. 40 bis 60% des Durchmessers D der Kugelelemente 14, d.h. D3 = 0,2 - 0,7 * D bzw. D3 = 0,4 - 0,6 * D.

Da die Öffnungen 46 der Glasmaterialschicht 44 einen geringeren Durchmesser als die Durchgangsöffnungen 48 des Hilfssubstrats 42 aufweisen, ist jeweils an der mit der Glasmaterialschicht 44 versehenen Seite der Durchgangsöffnungen 48 des Hilfssubstrats 42 ein Überstand der Glasmaterialschicht (seitlich) über die Durchführungsöffnungen 48 vorhanden.

Im Folgenden werden nun beispielhafte Teilschritte zur Herstellung und zum Bereitstellen des zweiten Teilsubstrats 40 beschrieben. So kann beispielsweise bei Schritt 232 auf das Hilfssubstrat 42 (Halbleitersubstrat bzw. weiterer Si-Wafer) eine (dünne) Glasmaterialschicht 44 aufgebracht werden, d.h. es kann beispielsweise ein Glas-Wafer auf den Halbleiterwafer gebondet werden, woraufhin der Glas-Wafer auf die gewünschte Dicke der Glasmaterialschicht gedünnt wird. Bei Schritt 233 wird nun beispielsweise die Glasmaterialschicht 44 strukturiert, um die Öffnungen 46 zu bilden. Bei Schritt 234 werden nun die Durchgangsöffnungen 48 erzeugt, indem beispielsweise von der Rückseite (zweiter Hauptoberflächenbereich) des Hilfssubstrats 42 das vorliegende Halbleitermaterial, z.B. Silizium, durchgeätzt wird, wobei seitlich an den Durchführungsöffnungen 48 an dem ersten Hauptoberflächenbereich des Hilfssubstrats 42 die Glasüberstände 46a erzeugt werden.

Bei einem Schritt 236 wird nun das zweite Teilsubstrat 40 auf dem ersten, mit den Kugelelementen 14 versehene Teilsubstrat 10 angeordnet bzw. auf dasselbe aufgesetzt. Dabei ist der mit der Glasmaterialschicht 44 versehene erste Hauptoberflächenbereich des zweiten Hilfssubstrats 40 den in den Vertiefungen 12 des ersten Teilsubstrats 10 eingelegten Kugelelementen 14 zugewandt, wobei ferner sind die Kugelelemente 14 mit den Durchführungsöffnungen des zweiten Teilsubstrats und mit den Öffnungen der Glasmaterialschicht (möglichst mittig bzw. zentriert) ausgerichtet sind. Ausgehend von dem Schritt 234 wird das zweite Teilsubstrat also "umgedreht", und auf die Halbleiterkugelelemente 14 (z.B. Siliziumkugeln), die in den Vertiefungen 12 (z.B. V-Gruben) gehalten werden, aufgesetzt.

Bei einem Schritt 238 wird das mit der Glasmaterialschicht 44 versehene zweite Teilsubstrat unter erhöhter Temperatur (Temperaturbehandlung bzw. Tempern) und mit (hohem) mechanischem Druck F an den Kugelelementen 14, die in den Vertiefungen 12 des ersten Teilsubstrats 10 angeordnet sind, aufgepresst und fixiert. Die Fixierung wird durch ein thermisches Bonden des Glasmaterials der Glasmaterialschicht 44 mit dem Halbleitermaterial (Silizium) der Kugelelemente 14 erreicht. Es wird also der mit einer Glasmaterialschicht 44 versehene Halbleiter-Wafer 40 unter erhöhter Temperatur (z.B. 700-900 °C) und mit mechanischem Druck F auf die an dem Hilfssubstrat 10 angeordneten Halbleiterkugelelemente (Siliziumkugeln) 14 aufgepresst. Bei dem oben dargestellten Prozessablauf 100-3a dient also eine an einem Teilsubstrat 10 angeordnete dünne Glasschicht als Substratmaterial zum Fixieren der Halbleiterkugelelemente.

Bei Schritt 240 wird das erste Teilsubstrat 10 (der V-Grubenwafer) von den fest mit dem zweiten Teilsubstrat 40 verbundenen Kugelelementen 14 entfernt bzw. abgenommen, wobei nun das zweite Teilsubstrat 40 mit dem Hilfssubstrat 42 und der daran angeordneten Glasmaterialschicht 44, das Trägersubstrat bildet, an dem die Kugelelemente 14 fixiert sind.

Bei dem Schritt 300 werden die an dem Trägersubstrat 40 fixierten Kugelelemente 14 einseitig gedünnt, d.h. die Siliziumkugelelemente werden mit einem Schleifvorgang (Grinding) bearbeitet, um die plankonvexen Linsenelemente 24 aus dem Halbleitermaterial (Silizium) zu erhalten. Der Vorgang des mechanischen Dünnens wird solange durchgeführt, bis die gewünschte resultierende Linsenform (Linsenhöhe) der plankonvexen Linsenelemente 24 erhalten wird.

Die ebene Seite 24a der plankonvexen Linsenelemente 40 wird durch den Schritt des mechanischen Dünnens (direkt) erhalten, wobei sich die konvexe Seite 24b der Linsenelemente 24 an den Durchgangsöffnungen des zweiten Teilsubstrats 40 (Trägersubstrat) befindet. Dabei bilden die Durchgangsöffnungen 48 des zweiten Teilsubstrats 40, d.h. die Durchgangsöffnungen durch das Hilfssubstrat 42 und durch die Glasmaterialschicht 44, (einseitig offene) Kavitäten 26 für die Linsenelemente 24, wobei der an der Kavität angrenzende (optisch wirksame) Bereich der konvexen Seite 24b der Linsenelemente (jeweils) freigelegt bzw. freiliegend ist.

Die vorhergehenden Ausführungen machen somit beispielhaft deutlich, dass die Verfahrensschritte 202, 204, 230, 236, 238 und 240 zum Fixieren der Halbleiterkugelelemente an dem Trägersubstrat vorgesehen sind, während dann bei dem Schritt 300 das einseitige Dünnen der an dem Trägersubstrat fixierten Kugelelemente durchgeführt wird, um die plankonvexen Linsenelemente 24 auf Waferebene, d.h. an dem Trägersubstrat fixiert, zu erhalten.

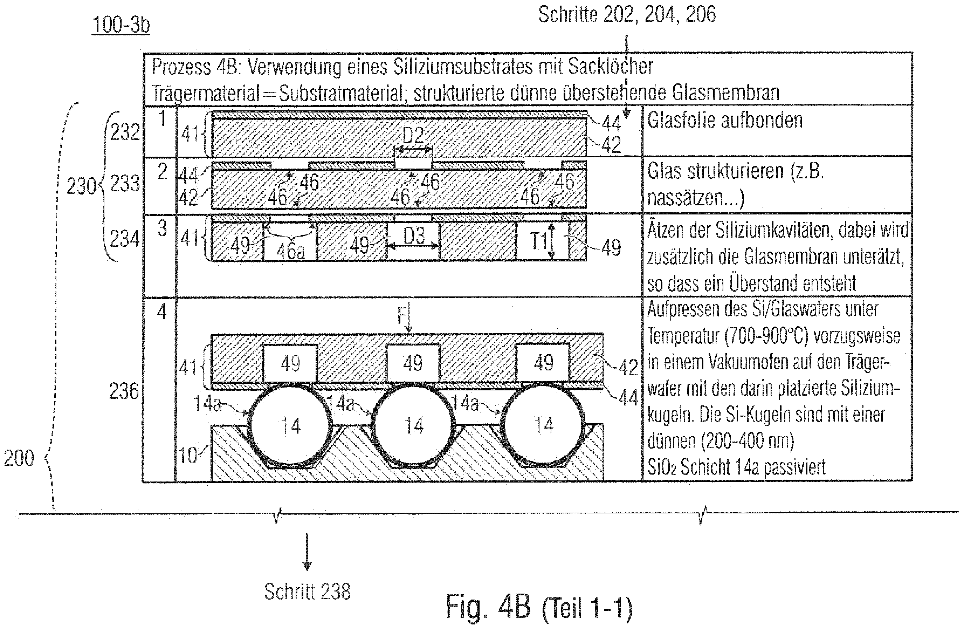

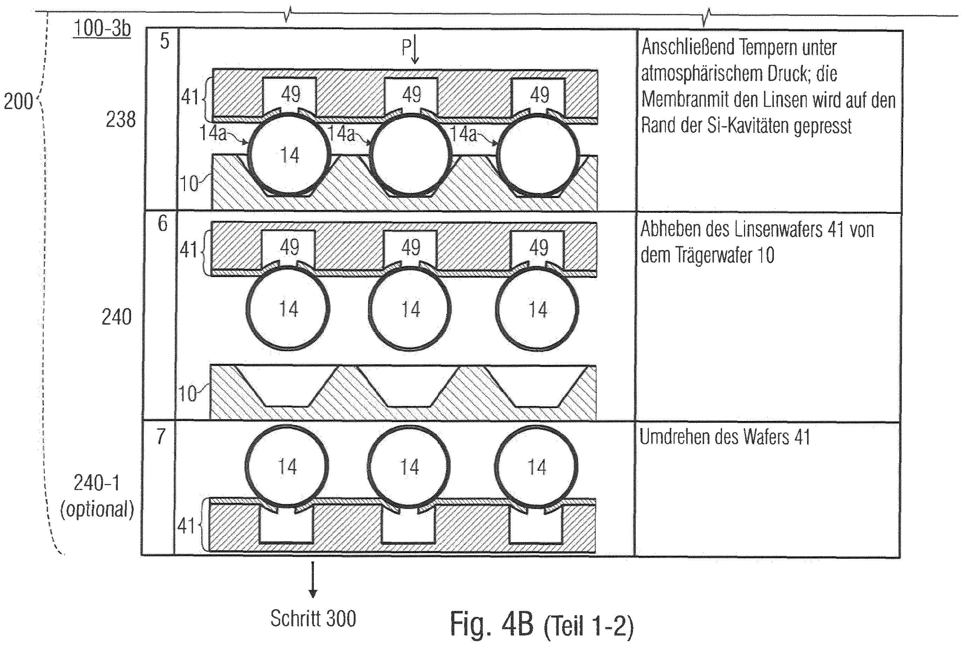

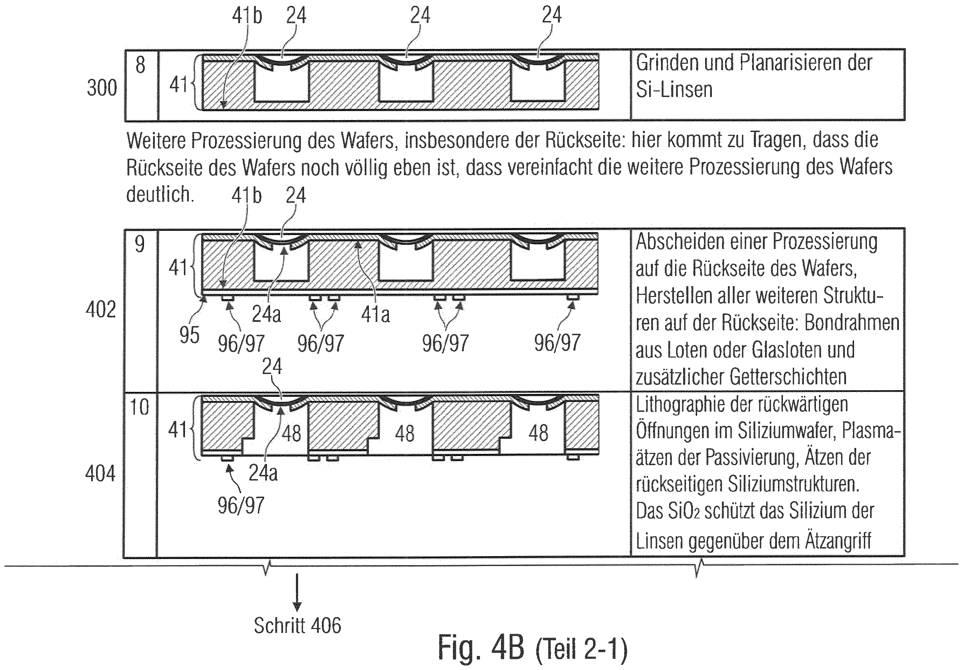

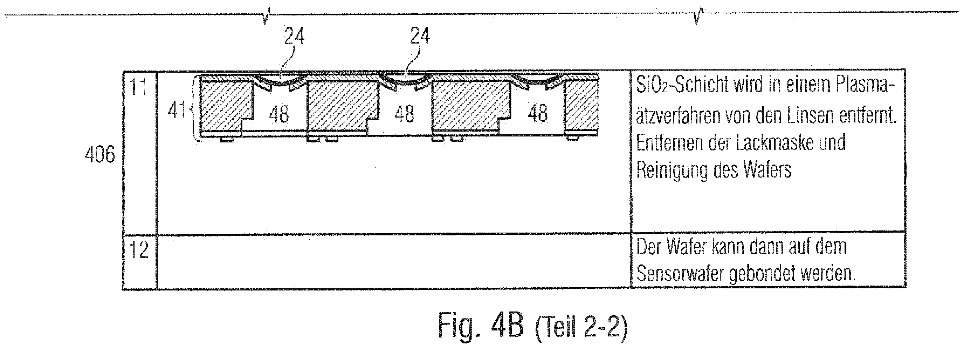

Im Folgenden wird nun anhand von Fig. 4B ein beispielhaftes Ablaufdiagramm eines weiteren Herstellungsverfahrens 100-3b zur Herstellung von plankonvexen Linsenelementen aus einem Halbleitermaterial auf Waferebene beschrieben.

Zunächst werden bei dem Verfahren 100-3b die bereits anhand der Fig. 2, 3 und 4a beschriebenen Verfahrensschritte 202, 204 und 206 durchgeführt, um ein mit Vertiefungen 12 versehenes erstes Teilsubstrat 10 aus einem Halbleitermaterial, z.B. Silizium, bereitzustellen. In den Vertiefungen 12 des ersten Teilsubstrats 10 sind nun die Kugelelemente 14 so angeordnet, dass sich beispielsweise jeweils ein Kugelelement 14 in einer Vertiefung 12 des ersten Teilsubstrats 10 befindet (Schritte 202, 204, 206). Die Halbleiterkugeln 14 (Kugelelemente - Siliziumkugeln) können dabei eine dünne Passivierungsschicht, z.B. eine 200-400 nm dicke Oxidschicht, wie z.B. eine Siliziumdioxid-Schicht (SiO₂-Schicht), aufweisen.

Bei Schritt 230 wird nun ein zweites Teilsubstrat 41 bereitgestellt, wobei das zweite Teilsubstrat 41 ein Hilfssubstrat 42 aus einem Halbleitermaterial, z.B. einen Silizium-Wafer, und eine Schicht 44 z.B. aus einem Glasmaterial (Glasschicht 44), die an einem ersten Hauptoberflächenbereich des Hilfssubstrats 42 angeordnet ist, aufweist.

Im Folgenden werden nun beispielhafte Teilschritte zur Herstellung und zum Bereitstellen 230 des zweiten Teilsubstrats 41 beschrieben. So kann beispielsweise bei Schritt 232 auf das Hilfssubstrat 42 (Halbleitersubstrat bzw. weiterer Si-Wafer) eine (dünne) Glasmaterialschicht 44 aufgebracht werden, d.h. es kann beispielsweise ein Glas-Wafer auf den Halbleiterwafer gebondet werden, woraufhin der Glas-Wafer auf die gewünschte Dicke der Glasmaterialschicht gedünnt wird. Bei Schritt 233 wird nun beispielsweise die Glasmaterialschicht 44 strukturiert, um Öffnungen 46 mit einem Durchmesser D2 zu bilden. Bei Schritt 234' werden nun die Ausnehmungen 49 erzeugt, indem beispielsweise von der Vorderseite (von dem ersten Hauptoberflächenbereich) des Hilfssubstrats 42 das vorliegende Halbleitermaterial, z.B. Silizium, bis zu einer Tiefe T1 geätzt wird. Dabei wird zusätzlich gezielt eine Unterätzung der Glasmaterialschicht 44 erreicht, sodass seitlich an den Ausnehmungen 49 an dem ersten Hauptoberflächenbereich des Hilfssubstrats 42 die Glasüberstände 46a erzeugt werden.

Das Hilfssubstrat 42 weist nun beispielsweise ausgehend von dem ersten Hauptoberflächenbereich Ausnehmungen 49 auf, die jeweils den Positionen der auf dem ersten Teilsubstrat 10 angeordneten Kugelelementen 14 entsprechen und mit diesen ausrichtbar sind, d.h. Ausnehmungen 49 und die Kugelelemente 14 können zentriert zueinander angeordnet werden. Die Ausnehmungen 49 erstrecken sich z.B. nicht vollständig, d.h. nur teilweise, (in der Dickenrichtung senkrecht zum ersten Hauptoberflächenbereich des Hilfssubstrats 42) bis in eine Tiefe T1 in das Material des Hilfssubstrats 42. Die Glasmaterialschicht 44 weist ferner Öffnungen 46 auf, die mit den Ausnehmungen 49 des Hilfssubstrats 42 (im Wesentlichen mittig) ausgerichtet sind. Der Durchmesser D2 der Öffnungen 46 der Glasmaterialschicht 44 ist geringer als der Durchmesser D3 (D2 < D3) Ausnehmungen 49 des Hilfssubstrats 42.

Der Durchmesser D2 der Öffnungen 46 der Glasmaterialschicht 44 beträgt beispielsweise 20 bis 70% oder 40 bis 60% des Durchmessers D3 der Ausnehmungen 49 des Hilfssubstrats 42, d.h. D2 = 0,2 - 0,7 * D3 oder D2 = 0,4 - 0,6 * D3. Ferner kann die Dicke der Glasmaterialschicht 44 beispielsweise zwischen 10 und 100 µm, zwischen 30 und 70 µm und etwa 50 µm betragen.

Dabei ist der Durchmesser D3 der Ausnehmungen 49 in dem Hilfssubstrat kleiner als der Durchmesser D der Kugelelemente 14. Der Durchmesser D3 der Ausnehmungen 49 beträgt beispielsweise 20 bis 70% bzw. 40 bis 60% des Durchmessers D der Kugelelemente 14, d.h. D3 = 0,2 - 0,7 * D bzw. D3 = 0,4 - 0,6 * D.

Da die Öffnungen 46 der Glasmaterialschicht 44 einen geringeren Durchmesser als die Ausnehmungen 49 des Hilfssubstrats 42 aufweisen, ist jeweils an der mit der Glasmaterialschicht 44 versehenen Seite der Ausnehmungen 49 des Hilfssubstrats 42 ein Überstand 46a der Glasmaterialschicht 46 (seitlich) über die Durchführungsöffnungen 48 vorhanden.

Bei einem Schritt 236 wird nun das zweite Teilsubstrat 41 auf dem ersten, mit den Kugelelementen 14 versehene Teilsubstrat 10 angeordnet bzw. auf dasselbe aufgesetzt. Dabei ist der mit der Glasmaterialschicht 44 versehene erste Hauptoberflächenbereich des zweiten Hilfssubstrats 41 den in den Vertiefungen 12 des ersten Teilsubstrats 10 eingelegten Kugelelementen 14 zugewandt, wobei ferner sind die Kugelelemente 14 mit den Ausnehmungen 49 des zweiten Teilsubstrats und mit den Öffnungen 46 der Glasmaterialschicht 44 (möglichst mittig bzw. zentriert) ausgerichtet sind. Ausgehend von dem Schritt 234 wird das zweite Teilsubstrat also "umgedreht", und auf die Halbleiterkugelelemente 14 (z.B. Siliziumkugeln), die in den Vertiefungen 12 (z.B. V-Gruben) gehalten werden, aufgesetzt. Die Halbleiterkugeln 14 weisen beispielsweise eine dünne Passivierungsschicht 14a, z.B. eine 200-400 nm dicke Oxidschicht (z.B. SiO₂-Schicht) auf.

Bei einem Schritt 238 wird das mit der Glasmaterialschicht 44 versehene zweite Teilsubstrat unter erhöhter Temperatur (Temperaturbehandlung bzw. Tempern) und mit (hohem) mechanischem Druck F an den Kugelelementen 14, die in den Vertiefungen 12 des ersten Teilsubstrats 10 angeordnet sind, aufgepresst und fixiert. Die Fixierung wird durch ein thermisches Bonden des Glasmaterials der Glasmaterialschicht 44 mit dem Halbleitermaterial (Silizium) bzw. mit dem Oxidmaterial (z.B. SiO₂) der Kugelelemente 14 erreicht. Es wird also der mit einer Glasmaterialschicht 44 versehene Halbleiter-Wafer 41 unter erhöhter Temperatur (z.B. 700-900 °C) und mit mechanischem Druck F auf die an dem Hilfssubstrat 10 angeordneten Halbleiterkugelelemente (Siliziumkugeln) 14 aufgepresst. Bei dem oben dargestellten Prozessablauf 100-3b dient also eine an einem Teilsubstrat 10 angeordnete dünne Glasschicht 44 als Substratmaterial zum Fixieren der Halbleiterkugelelemente.

Bei Schritt 240 wird das erste Teilsubstrat 10 (der V-Grubenwafer) von den fest mit dem zweiten Teilsubstrat 41 verbundenen Kugelelementen 14 entfernt bzw. abgenommen, wobei nun das zweite Teilsubstrat 41 mit dem Hilfssubstrat 42 und der daran angeordneten Glasmaterialschicht 44, das Trägersubstrat bildet, an dem die Kugelelemente 14 fixiert sind. Bei einem optionalen Schritt 240-1 wird das zweite Teilsubstrat 41 beispielsweise umgedreht bzw. für den nächsten Bearbeitungsschritt ausgerichtet.

Bei dem Schritt 300 werden die an dem Trägersubstrat 41 fixierten Kugelelemente 14 einseitig gedünnt, d.h. die Siliziumkugelelemente werden mit einem Schleifvorgang (Grinding) bearbeitet, um die plankonvexen Linsenelemente 24 aus dem Halbleitermaterial (Silizium) zu erhalten. Der Vorgang des mechanischen Dünnens wird solange durchgeführt, bis die gewünschte resultierende Linsenform (Linsenhöhe) der plankonvexen Linsenelemente 24 erhalten wird.

Die ebene Seite 24a der plankonvexen Linsenelemente 41 wird durch den Schritt des mechanischen Dünnens (direkt) erhalten, wobei sich die konvexe Seite 24b der Linsenelemente 24 (mit der daran angeordneten Oxidschicht 14a) an den Ausnehmungen 49 des zweiten Teilsubstrats 41 (Trägersubstrat) befindet. Dabei bilden die Ausnehmungen 49 des zweiten Teilsubstrats 41, d.h. die Ausnehmungen 49 durch das Hilfssubstrat 42 und durch die Glasmaterialschicht 44, Kavitäten 26 für die Linsenelemente 24, wobei der an der Kavität angrenzende (optisch wirksame) Bereich der konvexen Seite 24b der Linsenelemente z.B. noch mit der Oxidschicht 14a (SiO₂-Schicht) bedeckt ist.

Die vorhergehenden Ausführungen machen somit beispielhaft deutlich, dass die Verfahrensschritte 202, 204, 230, 236, 238 und 240 zum Fixieren der Halbleiterkugelelemente an dem Trägersubstrat vorgesehen sind, während dann bei dem Schritt 300 das einseitige Dünnen der an dem Trägersubstrat fixierten Kugelelemente durchgeführt wird, um die plankonvexen Linsenelemente 24 auf Waferebene, d.h. an dem Trägersubstrat fixiert, zu erhalten.

Im Folgenden werden nun beispielhaft optionale Schritte des Herstellungsverfahrens dargestellt, bei denen die Rückseite 41b (zweite Hauptoberfläche) des zweiten Teilsubstrats 41 bearbeitet wird, um das mit den plankonvexen Linsenelementen 24 versehene zweite Teilsubstrat 41 (Trägersubstrat) für die elektrische und mechanische Verbindung (Bonding), d.h. beispielsweise für ein Waferbonding, mit einem Bauelementesubstrat (Sensorwafer) vorzubereiten und bereitstellen zu können. Dabei kommt insbesondere zum Tragen, dass die Rückseite 41b (zweite Hauptoberfläche) des zweiten Teilsubstrats bzw. Linsenwafers 41 noch im Wesentlichen völlig eben und gleichmäßig ist, da bei den vorangegangenen Prozessschritten nur eine Bearbeitung von der Vorderseite 41a (d.h. von dem ersten Oberflächenbereich 41a) des zweiten Teilsubstrats bzw. Trägersubstrats 41 stattgefunden hat. Dadurch wird eine deutliche Vereinfachung der weiteren Prozessierung und prozesstechnischen Behandlung von der Rückseite 41b des zweiten Hilfssubstrats 41 erreicht.

Bei einem optionalen Schritt 402 wird eine Oberflächenbearbeitung der Rückseite bzw. zweiten Hauptoberfläche 41b des zweiten Teilsubstrats 41 durchgeführt, indem beispielsweise zunächst eine Passivierungsschicht 95 (z.B. ganzflächig) auf den zweiten Hauptoberflächenbereich des zweiten Teilsubstrats 41, d.h. auf der Rückseite des Trägersubstrats (bzw. Trägerwafers) abgeschieden wird. Daraufhin können optional weitere Strukturen auf dem zweiten Hauptoberflächenbereich des zweiten Trägersubstrats 41 hergestellt werden, wie z.B. ein Bondrahmen aus Lotmaterialien (Loten) oder Glasloten 96 und beispielsweise zusätzliche Getterschichten 97. Als Getterschicht bzw. ein Getter bzw. Gettermaterial aufweisende Schicht wird ein chemisch reaktives Material bezeichnet, das dazu dient, ein Vakuum möglichst lange zu erhalten. An der Oberfläche eines Gatters gehen Gasmoleküle mit den Atomen des Gattermaterials eine direkte chemische Verbindung ein, oder die Gasmoleküle werden durch Sorption festgehalten. Auf diese Weise können Gasmoleküle "eingefangen" werden.

Die Bondrahmen 96 können beispielsweise so ausgebildet sein, um die nachfolgend ausgebildeten Öffnungen in der Rückseite des zweiten Teilsubstrats 41 zu den darin befindlichen Ausnehmungen 49 kontinuierlich zu umgeben, um später eine gasdichte Verbindung mit dem Bauelementesubstrat bzw. Bauelementewafer herstellen zu können.

Bei einem nachfolgenden Schritt 404 kann nun ausgehend von der Rückseite 41b des zweiten Teilsubstrats 41die in dem zweiten Teilsubstrat 41 befindlichen Ausnehmungen 49 "geöffnet werden", um entsprechende vollständige Durchgangsöffnungen 48 zu der Rückseite des zweiten Teilsubstrats 41 zu erhalten. Der Schritt 404 zum Öffnen der Ausnehmungen 49 in dem zweiten Teilsubstrat 41 kann beispielsweise folgendermaßen durchgeführt werden, indem eine Lithographie der rückwärtigen Öffnungen in dem zweiten Teilsubstrat 41 durchgeführt wird, d.h. indem eine lithographische Maske (nicht gezeigt in Fig. 4B) auf der Rückseite 41b des zweiten Teilsubstrats 41 erzeugt wird, die die zu öffnenden Zugangsbereiche zu den Ausnehmungen 49 in dem zweiten Teilsubstrat 41 vorgibt bzw. definiert. Daraufhin kann ausgehend von der Rückseite 41b des zweiten Teilsubstrats 41 ein Entfernen der Passivierungsschicht 95 erfolgen, z.B. mittels Plasmaätzen, woraufhin ausgehend von der Rückseite 41b des zweiten Teilsubstrats 41 das Halbleitermaterial, z.B. das Siliziummaterial, geätzt wird, um die Durchgänge zu den Ausnehmungen 49 in dem zweiten Teilsubstrat 41 zu erhalten, d.h. um die resultierenden Durchgangsöffnungen 48 zu der Rückseite des zweiten Teilsubstrats 41 zu erhalten.

Bei dem Ätzen der rückseitigen Halbleiterstrukturen erfüllt dabei die Siliziumdioxid-Schicht 24a (als Ätzstoppschicht) auf den zu den Ausnehmungen 49 freiliegenden Bereichen der Siliziumkugelsegmente bzw. Siliziumlinsen 24 gegenüber dem von der Rückseite durchgeführten Ätzvorgang (Ätzangriff) eine Schutzfunktion für die Siliziumlinsen.

Bei einem nachfolgenden Schritt 406 können nun ferner die den Durchgangsöffnungen zugewandten Oberflächen der Siliziumlinsen 24 von der Siliziumdioxid-Schicht (SiO₂-Schicht) 24a entfernt werden. Dazu kann beispielsweise ein Plasmaätzverfahren eingesetzt werden. Anschließend können beispielsweise noch die Reste der Photolithographischen Maske (Lackmaske) auf der Rückseite 41b des zweiten Teilsubstrats 41 entfernt und beispielsweise eine abschließende Reinigung zumindest der Rückseite bzw. des gesamten resultierenden zweiten Teilsubstrats 41 durchgeführt werden.

Das mit den Linsenelementen 24 versehene zweite Teilsubstrat 41 kann nun für einen Waferbondvorgang mit dem Bauelementesubstrat bzw. Bauelementewafer bereitgestellt werden, wobei nachfolgend dann bei einem Schritt 630 mit einem Bondverfahren bzw. Waferbondprozess das zweite Teilsubstrat 41 (rückseitig) mit dem Bauelementesubstrat verbunden (gebonded) werden kann.

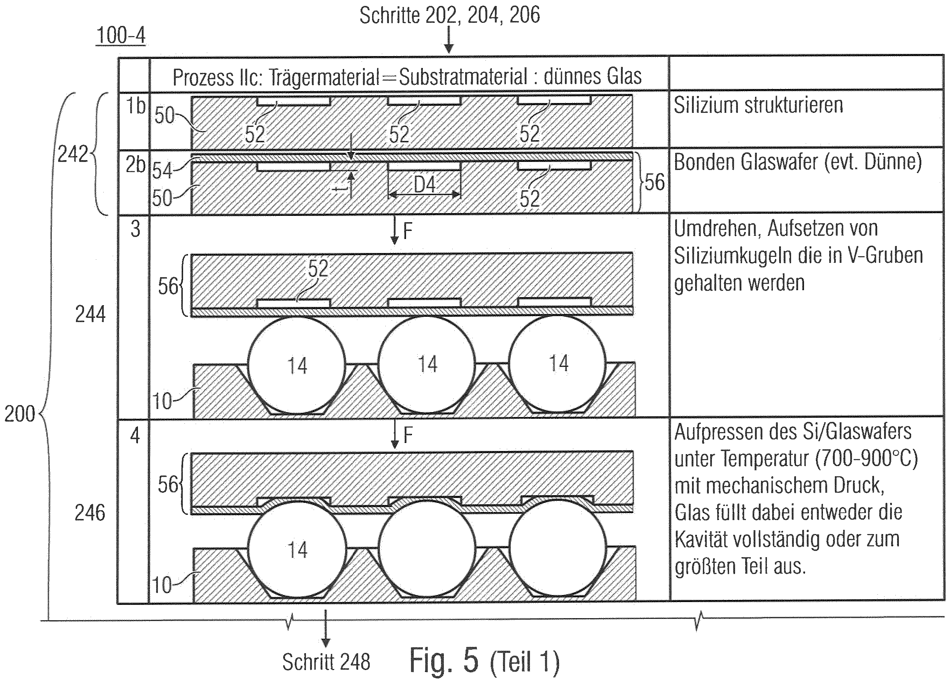

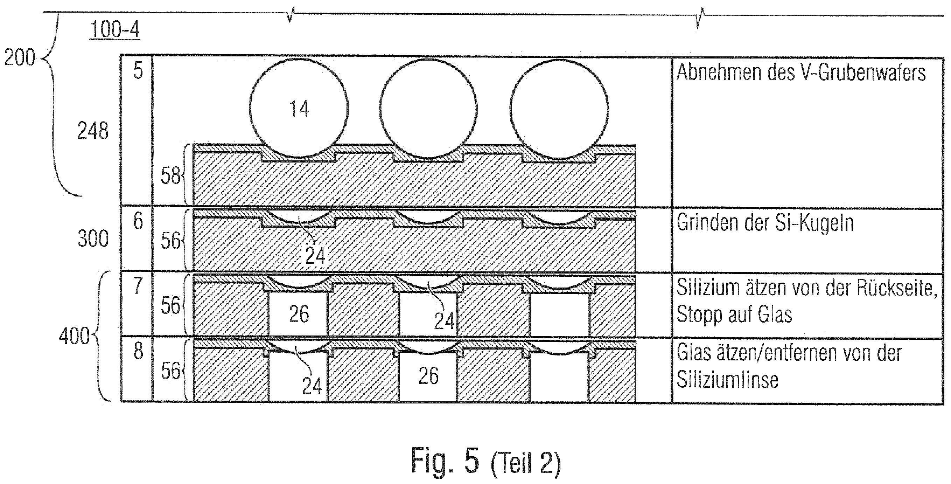

Im Folgenden wird nun anhand von Fig. 5 ein beispielhaftes Ablaufdiagramm eines weiteren Herstellungsverfahrens 100-4 zur Herstellung von plankonvexen Linsenelementen aus einem Halbleitermaterial auf Waferebene beschrieben.

Zunächst werden bei dem Verfahren 100-4 die bereits anhand der Fig. 2, 3 und 4a beschriebenen Verfahrensschritte 202, 204 und 206 durchgeführt, um ein mit Vertiefungen 12 versehenes erstes Teilsubstrat 10 aus einem Halbleitermaterial, z.B. Silizium, bereitzustellen. In den Vertiefungen 12 des ersten Teilsubstrats 10 sind nun die Kugelelemente 14 so angeordnet, dass sich beispielsweise jeweils ein Kugelelement 14 in einer Vertiefung 12 des ersten Teilsubstrats 10 befindet (Schritte 202, 204, 206).

Bei Schritt 242 von Fig. 5 wird nun ein zweites Teilsubstrat 56 bereitgestellt, das ein Hilfssubstrat 50 aus einem Halbleitermaterial, wie z.B. Silizium, aufweist. An einem ersten Hauptoberflächenbereich des Hilfssubstrats 50 sind (zum gegenüberliegenden zweiten Hauptoberflächenbereich nicht-durchgehende) Ausnehmungen 52 angeordnet. Diese Ausnehmungen 52 entsprechen jeweils den Positionen der auf dem ersten Teilsubstrat 10 angeordneten Kugelelemente 14 bzw. sind mit diesen Positionen ausrichtbar, d.h. die Ausnehmungen 52 und die Kugelelemente 14 können zentriert zueinander angeordnet werden. Die Ausnehmungen 52 können beispielsweise mittels herkömmlicher Halbleiterbearbeitungsprozesse, z.B. Ätzprozesse, in dem Halbleitermaterial strukturiert werden.

Dabei ist der Durchmesser (bzw. die Breite) D4 der Ausnehmungen 52 in dem Hilfssubstrat kleiner als der Durchmesser D der Kugelelemente 14. Der Durchmesser D4 der Ausnehmungen 52 beträgt beispielsweise 20 bis 70% bzw. 40 bis 60% des Durchmessers D der Kugelelemente 14, d.h. D3 = 0,2 - 0,7 * D bzw. D3 = 0,4 - 0,6 * D. Ferner ist die Tiefe t der Ausnehmungen 52 in dem Hilfssubstrat kleiner als beispielsweise 50, 30, 20, 10, 5 oder 1 % des Durchmessers D der Kugelelemente 14 und beträgt beispielsweise 50 bis 200 µm und etwa 100 µm. Ferner kann die Dicke der Glasmaterialschicht 54 beispielsweise zwischen 10 und 100 µm, zwischen 30 und 70 µm und etwa 50 µm betragen.

An dem ersten Hauptoberflächenbereich des Hilfsträgers 50 ist nun ferner eine Glasmaterialschicht 54 angeordnet, die die Ausnehmungen 56 in dem Hilfssubstrat 50 (zumindest teilweise oder auch vollständig) überspannt bzw. überdeckt. Somit kann das zweite Teilsubstrat 56 erhalten werden, indem auf den mit den Ausnehmungen 52 strukturierten Hilfsträger 50 die (z.B. durchgehende) Glasmaterialschicht 54 aufgebracht wird, beispielsweise durch Bonden eines Glaswafers an dem mit den Ausnehmungen versehenen ersten Hauptoberflächenbereich des Hilfssubstrats 50 und eventuellem nachträglichen Dünnen des Glaswafers.

Bei Schritt 244 wird das zweite Teilsubstrat 56 auf dem ersten, mit den Kugelelementen 14 versehenen Teilsubstrat 10 angeordnet bzw. aufgesetzt, wobei der mit der Glasmaterialschicht 54 versehene erste Hauptoberflächenbereich des zweiten Teilsubstrats 56 den in den Vertiefungen 12 des ersten Teilsubstrats 10 angeordneten Kugelelementen 14 zugewandt ist, und wobei die Kugelelemente 14 mit den Ausnehmungen des zweiten Teilsubstrats beispielsweise möglichst mittig bzw. zentriert ausgerichtet sind. Das bereitgestellte Teilsubstrat 56 wird also beispielsweise umgedreht, und auf das erste Teilsubstrat 10 aufgesetzt, in dem die Siliziumkugeln 14 in den V-Gruben gehalten werden.

Bei Schritt 246 wird nun das mit der Glasmaterialschicht 54 versehene zweite Teilsubstrat 56 an den Kugelelementen 14 unter erhöhter Temperatur (Temperaturbehandlung bzw. Tempern bei 700-900 °C) und unter Einwirkung eines mechanischen Drucks F fixiert. Das Aufpressen des zweiten Teilsubstrats 56, d.h. eines Si-/Glas-Wafers auf die Halbleiterkugelelemente 14 (Siliziumkugeln) wird somit unter erhöhter Temperatur und mit hohem mechanischem Druck durchgeführt. Das bei diesem Tempervorgang verflüssigte bzw. hinreichend erweichte Glasmaterial füllt bei dem Aufpress- bzw. Fixierungsschritt die Ausnehmung 52 (Kavität) zumindest teilweise (d.h. zum größten Teil) oder auch vollständig aus.

Bei Schritt 248 wird nun das erste Teilsubstrat 10 von den fest mit dem zweiten Teilsubstrat 56 verbundenen Kugelelementen 14 entfernt, wobei nun das zweite Teilsubstrat 56 das Trägersubstrat für die zu dünnenden Halbleiterkugelelemente 14 bildet. Bei dem Schritt 248 wird also das erste Teilsubstrat 10, d.h. der V-Grubenwafer, abgenommen.

Bei dem Schritt 300 des Dünnens der an dem zweiten Teilsubstrat 56 (Trägersubstrat) fixierten Kugelelemente 14 werden nun die plankonvexen Linsenelemente 24 erhalten. Der Prozess des mechanischen Dünnens kann beispielsweise mittels Schleifen bzw. Grinding der Halbleiterkugelelemente (Siliziumkugeln) erfolgen. Über das exakte Einstellen der resultierenden Waferdicke des Trägersubstrats 56 können die exakten optischen Eigenschaften der resultierenden Linsenelemente 24 eingestellt werden. Bei dem Schritt des Dünnens wird (direkt) die ebene Seite 24a der plankonvexen Linsenelemente 24 erhalten, während sich die konvexe Seite 24b der Linsenelemente 24 an den zumindest teilweise mit den Glasmaterial 54 gefüllten Ausnehmungen 52 des zweiten Teilsubstrats 56 (Trägersubstrat) befindet.

Bei einem nachfolgenden Schritt 400 werden nun Kavitäten 26 ausgehend von dem zweiten Hauptoberflächenbereich des zweiten Teilsubstrats (Trägersubstrats) 56 zu den Linsenelementen 24 erzeugt, wobei jeweils beispielsweise eine Kavität 26 pro Linsenelement 24 erzeugt wird. Somit ist der an die Kavität 26 angrenzende, optisch wirksame Bereich der konvexen Seite 24b der Linsenelemente 24 jeweils freigelegt bzw. freiliegend. Dies wird beispielsweise mittels eines Ätzvorgangs des Siliziummaterials des Hilfssubstrats 50 von der Rückseite (dem zweiten Hauptoberflächenbereich desselben) aus erreicht, wobei ein Ätzstopp auf der Glasmaterialschicht 54 in den Ausnehmungen 52 erfolgt. Daraufhin wird das an die Kavität 56 angrenzende Glasmaterial (zumindest teilweise) im Bereich der konvexen Seite 24b der Linsenelemente 24 entfernt, d.h. der optisch wirksame Bereich der Linse 24 wird freigelegt. Das Entfernen des Glasmaterials von dem Linsenelement 24 (Siliziumlinse) kann beispielsweise mittels Ätzen erfolgen.

Aus der vorhergehenden Beschreibung hinsichtlich des in Fig. 5 dargestellten Verfahrens 100-4 zum Herstellen von plankonvexen Linsenelementen auf Waferebene wird deutlich, dass die Schritte 202, 204, 206, 242, 244, 246 und 248 den Schritt 200 des Fixierens von Kugelelementen aus einem Halbleitermaterial an einem Trägersubstrat implementieren, woraufhin bei Schritt 300 das einseitige Dünnen der an dem Trägersubstrat 56 fixierten Kugelelemente 14 und ferner bei Schritt 600 das Bilden der Kavitäten durchgeführt wird.

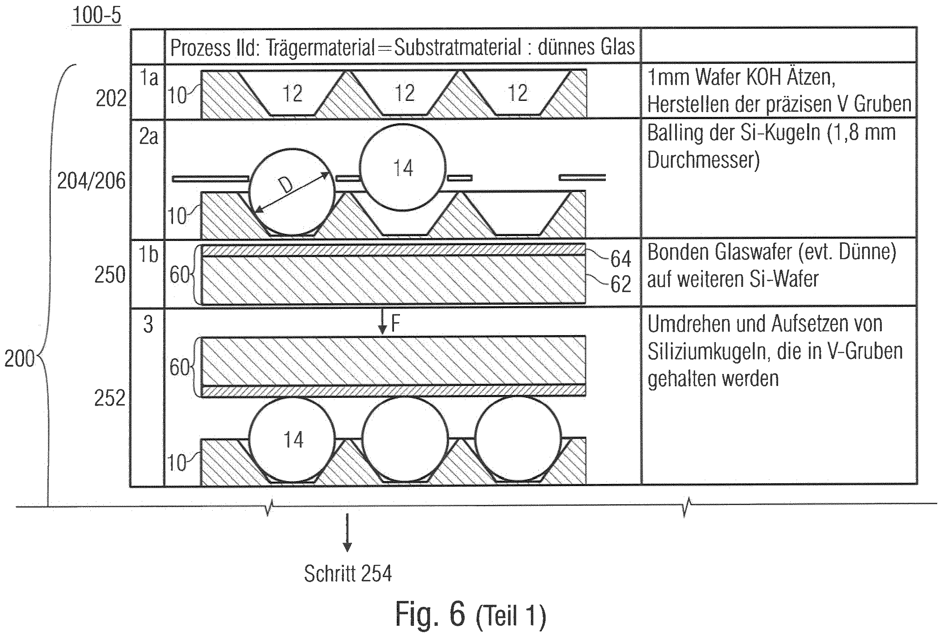

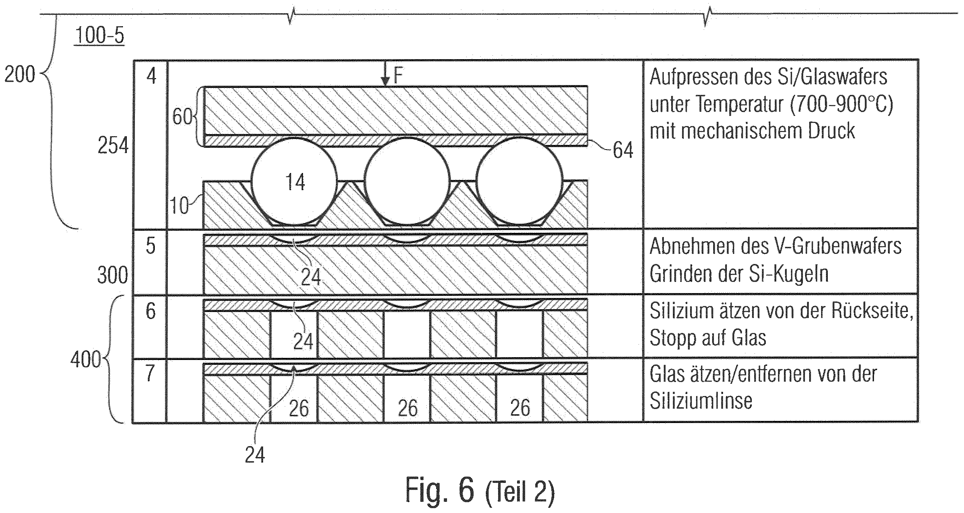

Im Folgenden wird nun anhand von Fig. 6 ein beispielhaftes Ablaufdiagramm eines weiteren Herstellungsverfahrens 100-5 zur Herstellung von plankonvexen Linsenelementen aus einem Halbleitermaterial auf Waferebene beschrieben.

Bei Schritt 202 wird ein mit Vertiefungen 12 versehenes erstes Teilsubstrat 10 bereitgestellt. Bei Schritt 204 werden Kugelelemente 14 in den Vertiefungen 12 des ersten Teilsubstrats 10 angeordnet bzw. eingefügt, so dass sich jeweils ein Kugelelement 14 in einer Vertiefung 12 des ersten Teilsubstrats befindet (Schritt 206).

Bei Schritt 250 von Fig. 6 wird nun ein zweites Teilsubstrat 60 bereitgestellt, das ein Hilfssubstrat 62 aus einem Halbleitermaterial, wie z.B. Silizium aufweist. An einem ersten Hauptoberflächenbereich des Hilfssubstrats 62 ist eine (z.B. durchgehende) Glasmaterialschicht 64 angeordnet, die den ersten Hauptoberflächenbereich des Hilfssubstrats 62 überdeckt. Das zweite Teilsubstrat 60 kann erhalten werden, indem auf den Hilfsträger 62 die (z.B. durchgehende) Glasmaterialschicht 64 aufgebracht wird, beispielsweise durch Bonden eines Glaswafers an den ersten Hauptoberflächenbereich des Hilfssubstrats 62 und eventuellem nachträglichen Dünnen des Glaswafers 64. Ferner kann die Dicke der Glasmaterialschicht 64 beispielsweise zwischen 10 und 100 µm, zwischen 30 und 70 µm und etwa 50 µm betragen.

Bei Schritt 252 wird das zweite Teilsubstrat 60 auf dem ersten, mit den Kugelelementen 14 versehenen Teilsubstrat 10 angeordnet bzw. aufgesetzt, wobei der mit der Glasmaterialschicht 64 versehene erste Hauptoberflächenbereich des zweiten Teilsubstrats 60 den in den Vertiefungen 12 des ersten Teilsubstrats 10 angeordneten Kugelelementen 14 zugewandt ist. Das bereitgestellte Teilsubstrat 60 wird also beispielsweise umgedreht, und auf das erste Teilsubstrat 10 aufgesetzt, in dem die Siliziumkugeln 14 in den V-Gruben gehalten werden.

Bei Schritt 254 wird nun das mit der Glasmaterialschicht 64 versehene zweite Teilsubstrat 60 an den Kugelelementen 14 unter erhöhter Temperatur (Temperaturbehandlung bzw. Tempern bei 700-900 °C) und unter Einwirkung eines mechanischen Drucks F fixiert. Das Aufpressen des zweiten Teilsubstrats 56, d.h. eines Si-/Glas-Wafers auf die Halbleiterkugelelemente 14 (Siliziumkugeln) wird somit unter erhöhter Temperatur und mit hohem mechanischem Druck durchgeführt. Das bei diesem Tempervorgang hinreichend erweichte dann und wieder-verfestigte Glasmaterial der Schicht 64 stellt somit eine feste Bondverbindung mit dem Halbleitermaterial (z.B. Silizium) der Kugelelemente 14 her.

Daraufhin wird nun das erste Teilsubstrat 10 von den fest mit dem zweiten Teilsubstrat 60 verbundenen Kugelelementen 14 entfernt, wobei nun das zweite Teilsubstrat 60 das Trägersubstrat für die zu dünnenden Halbleiterkugelelemente 14 bildet. Es wird also das erste Teilsubstrat 10, d.h. der V-Grubenwafer, abgenommen.

Bei dem Schritt 300 des Dünnens der an dem Trägersubstrat 60 fixierten Kugelelemente 14 werden nun die plankonvexen Linsenelemente 24 erhalten. Der Prozess des mechanischen Dünnens kann beispielsweise mittels Schleifen bzw. Grinding der Halbleiterkugelelemente (Siliziumkugeln) erfolgen. Über das exakte Einstellen der resultierenden Waferdicke des Trägersubstrats 60 können die exakten optischen Eigenschaften der resultierenden Linsenelemente 24 eingestellt werden. Bei dem Schritt des Dünnens wird (direkt) die ebene Seite 24a der plankonvexen Linsenelemente 24 erhalten, während sich die konvexe Seite 24b der Linsenelemente 24 (zumindest teilweise) in dem Glasmaterial der Schicht 64 befindet.

Bei einem nachfolgenden Schritt 400 werden nun Kavitäten 26 ausgehend von dem zweiten Hauptoberflächenbereich (Rückseite) des Trägersubstrats 60 zu den Linsenelementen 24 erzeugt, wobei jeweils beispielsweise eine Kavität 26 pro Linsenelement 24 erzeugt wird. Somit ist der an die Kavität 26 angrenzende, optisch wirksame Bereich der konvexen Seite 24b der Linsenelemente 24 jeweils freigelegt bzw. freiliegend. Dies wird beispielsweise mittels eines Ätzvorgangs des Siliziummaterials des Hilfssubstrats 50 von der Rückseite (dem zweiten Hauptoberflächenbereich desselben) aus erreicht, wobei ein Ätzstopp auf der Glasmaterialschicht 64 in den Ausnehmungen 52 erfolgt. Daraufhin wird das an die Kavität 26 angrenzende Glasmaterial (zumindest teilweise) im Bereich der konvexen Seite 24b der Linsenelemente 24 entfernt, d.h. der optisch wirksame Bereich der Linse 24 wird freigelegt. Das Entfernen des Glasmaterials von dem Linsenelement 24 (Siliziumlinse) kann beispielsweise mittels Ätzen erfolgen.

Aus der vorhergehenden Beschreibung hinsichtlich des in Fig. 6 dargestellten Verfahrens 100-4 zum Herstellen von plankonvexen Linsenelementen auf Waferebene wird deutlich, dass die Schritte 202, 204, 206, 250, 252 und 254 den Schritt 200 des Fixierens von Kugelelementen aus einem Halbleitermaterial an einem Trägersubstrat implementieren, woraufhin bei Schritt 300 das einseitige Dünnen der an dem Trägersubstrat 60 fixierten Kugelelemente 14 und ferner bei Schritt 600 das Bilden der Kavitäten 26 durchgeführt wird.

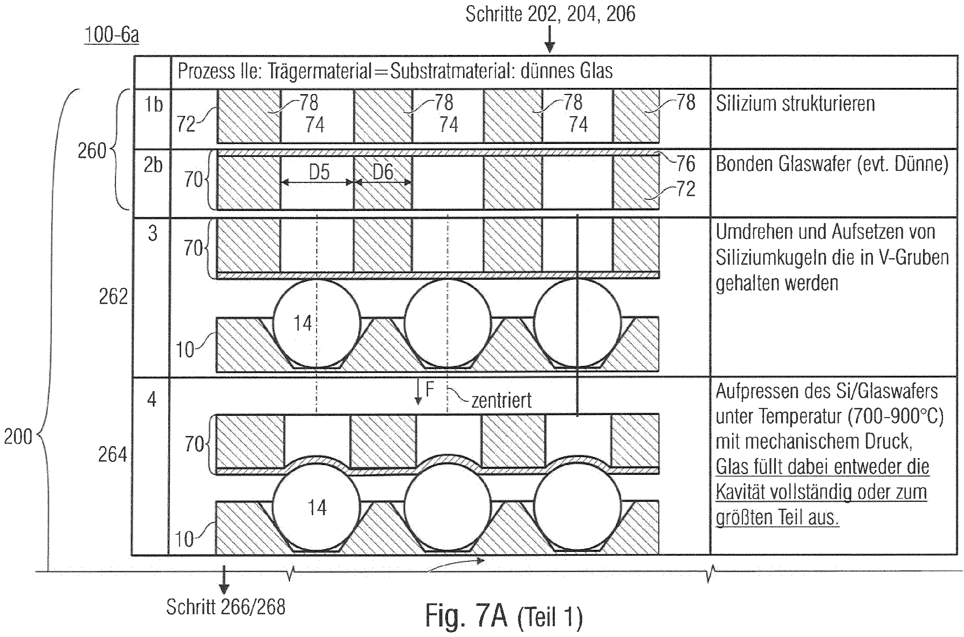

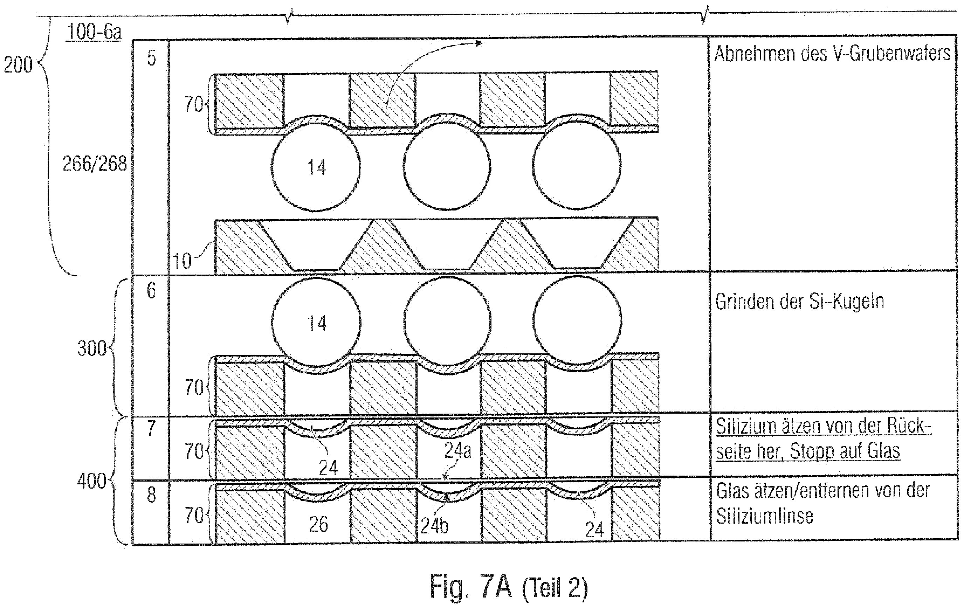

Im Folgenden wird nun anhand von Fig. 7A ein beispielhaftes Ablaufdiagramm eines weiteren Herstellungsverfahrens 100-6a zur Herstellung von plankonvexen Linsenelementen (z.B. aus einem Halbleitermaterial) auf Waferebene beschrieben.

Zunächst werden bei dem Verfahren 100-6a die bereits anhand der Fig. 2, 3 und 4 beschriebenen Verfahrensschritte 202, 204 und 206 durchgeführt, um ein mit Vertiefungen 12 versehenes erstes Teilsubstrat 10 z.B. aus einem Halbleitermaterial, wie z.B. Silizium, bereitzustellen. In den Vertiefungen 12 des ersten Teilsubstrats 10 sind nun die Kugelelemente 14 so angeordnet, dass sich beispielsweise jeweils ein Kugelelement 14 in einer Vertiefung 12 des ersten Teilsubstrats 10 befindet (Schritte 202, 204, 206).

Bei Schritt 260 von Fig. 7A wird nun ein zweites Teilsubstrat 70 bereitgestellt, das ein Hilfssubstrat 72 aus einem Halbleitermaterial, wie z.B. Silizium, aufweist. An einem ersten Hauptoberflächenbereich des Hilfssubstrats 72 sind (zum gegenüberliegenden zweiten Hauptoberflächenbereich z.B. durchgehende oder auch nicht-durchgehende) Ausnehmungen bzw. Durchgangsöffnungen 74 angeordnet. Diese Ausnehmungen 74 entsprechen jeweils den Positionen der auf dem ersten Teilsubstrat 10 angeordneten Kugelelemente 14 bzw. sind mit diesen Positionen ausrichtbar, d.h. die Ausnehmungen 74 und die Kugelelemente 14 können zentriert zueinander angeordnet werden. Die Ausnehmungen 74 können beispielsweise mittels herkömmlicher Halbleiterbearbeitungsprozesse, z.B. Ätzprozesse, in dem Halbleitermaterial 72 strukturiert werden.

Dabei ist der Durchmesser D5 der Ausnehmungen 74 in dem Hilfssubstrat 72 kleiner als der Durchmesser D der Kugelelemente 14. Der Durchmesser D5 der Ausnehmungen 74 beträgt beispielsweise 20 bis 70% bzw. 40 bis 60% des Durchmessers D der Kugelelemente 14, d.h. D5 = 0,2 - 0,7 * D bzw. D3 = 0,4 - 0,6 * D.

Die Zwischenbereiche 78 gemäß der Schnittansicht des Hilfssubstrats 72 sind nun z.B. so gewählt, dass die Ausnehmungen 74 in einem Abstand (Dicke) D6 zueinander angeordnet sind. Der Abstand D6 kann z.B. so gewählt werden, dass der Durchmesser D5 und der Abstand D6 in Kombination größer als der Durchmesser D der Kugelelemente 14 ist, d.h. D5 + D6 ≥ D. Der Durchmesser D5 und der Abstand D6 kann z.B. gewählt werden, um eine möglichst hohe Packungsdichte der Kugelelemente 14 an dem ersten Teilsubstrat 10 und (nach dem Fixieren) an dem Hilfssubstrat 72 zu ermöglichen.

An dem ersten Hauptoberflächenbereich des Hilfsträgers 72 ist nun ferner eine (z.B. durchgehende) Glasmaterialschicht 76 angeordnet, die die Ausnehmungen 74 in dem Hilfssubstrat 72 (zumindest teilweise oder auch vollständig) überspannt bzw. überdeckt. Somit kann das zweite Teilsubstrat 70 erhalten werden, indem auf den mit den Ausnehmungen 74 strukturierten Hilfsträger 72 die (z.B. durchgehende) Glasmaterialschicht 76 aufgebracht wird, beispielsweise durch Bonden eines Glaswafers an einen ersten Hauptoberflächenbereich des Hilfssubstrats 72 und eventuellem nachträglichen Dünnen des Glaswafers. Ferner kann die Dicke der Glasmaterialschicht 76 beispielsweise zwischen 10 und 100 µm, zwischen 30 und 70 µm und etwa 50 µm betragen.

Bei Schritt 262 wird das zweite Teilsubstrat 70 auf dem ersten, mit den Kugelelementen 14 versehenen Teilsubstrat 10 angeordnet bzw. aufgesetzt, wobei der mit der Glasmaterialschicht 76 versehene erste Hauptoberflächenbereich des zweiten Teilsubstrats 70 den in den Vertiefungen 12 des ersten Teilsubstrats 10 angeordneten Kugelelementen 14 zugewandt ist, und wobei die Kugelelemente 14 mit den Ausnehmungen 74 des zweiten Teilsubstrats 70 beispielsweise möglichst mittig bzw. zentriert ausgerichtet sind. Das bereitgestellte Teilsubstrat 70 wird also beispielsweise umgedreht, und auf das erste Teilsubstrat 10 aufgesetzt, in dem die Siliziumkugeln 14 in den V-Gruben gehalten werden.

Bei Schritt 264 wird nun das mit der Glasmaterialschicht 76 versehene zweite Teilsubstrat 70 an den Kugelelementen 14 unter erhöhter Temperatur (Temperaturbehandlung bzw.

Tempern bei 700-900°C) und unter Einwirkung eines mechanischen Drucks F aufgepresst bzw. fixiert.

Die Fixierung wird durch ein thermisches Bonden des Glasmaterials der Schicht 76 mit dem Halbleitermaterial (Silizium) der Kugelelemente 14 erreicht. Es wird also der mit einer Glasmaterialschicht 76 versehene Halbleiter-Wafer 70 unter erhöhter Temperatur (z.B. 700-900 °C) und mit mechanischem Druck F auf die an dem Hilfssubstrat 10 angeordneten Halbleiterkugelelemente (Siliziumkugeln) 14 aufgepresst. Bei dem oben dargestellten Prozessablauf 100-6a dient also eine an dem zweiten Teilsubstrat 70 angeordnete dünne Glasschicht 76 als Substratmaterial zum Fixieren der Halbleiterkugelelemente 14.

Das bei diesem Tempervorgang hinreichend erweichte Glasmaterial der Schicht füllt bei dem Aufpress- bzw. Fixierungsschritt die Ausnehmung 52 (Kavität) zumindest teilweise (d.h. zum größten Teil) oder auch vollständig aus.

Daraufhin wird bei Schritt 266, 268 nun das erste Teilsubstrat 10 (der V-Grubenwafer) von den fest mit dem zweiten Teilsubstrat 70 verbundenen Kugelelementen 14 entfernt bzw. abgenommen, wobei nun das zweite Teilsubstrat 70 mit dem Hilfssubstrat 72 und der daran angeordneten Glasmaterialschicht 76 das Trägersubstrat bildet, an dem die Kugelelemente 14 fixiert sind.

Bei dem Schritt 300 des Dünnens der an dem Trägersubstrat 70 fixierten Kugelelemente 14 werden nun die plankonvexen Linsenelemente 24 erhalten. Der Prozess des mechanischen, einseitigen Dünnens kann beispielsweise mittels Schleifen bzw. Grinding der Halbleiterkugelelemente (Siliziumkugeln) erfolgen. Der Vorgang des mechanischen Dünnens wird solange durchgeführt, bis die gewünschte resultierende Linsenform (Linsenhöhe) der plankonvexen Linsenelemente 24 mit den exakten optischen Eigenschaften der resultierenden Linsenelemente 24 erhalten wird. Bei dem Schritt des Dünnens wird (direkt) die ebene Seite 24a der plankonvexen Linsenelemente 24 erhalten, während sich die konvexe Seite 24b der Linsenelemente 24 (zumindest teilweise) in dem Glasmaterial der Schicht 76 befindet. Dabei entspricht der konvexseitige Krümmungsradius der hergestellten Linsenelemente dem Kugelradius R der (unbearbeiteten bzw. nicht gedünnten) an dem Trägersubstrat fixierten Kugelelemente. Durch das einseitige Dünnen der an dem Trägersubstrat fixierten Kugelelemente wird ferner die plane bzw. ebene Seite der plankonvexen Linsenelemente gebildet.

Der Dünnungsprozess wird also solange ausgeführt, bis die erforderliche Höhe des resultierenden Kugelsegments basierend auf dem vorgegeben Krümmungsradius (ROC: radius of curvature) exakt eingestellt ist, so dass die gewünschten optischen Eigenschaften des resultierenden Siliziumlinsenelements exakt erhalten werden können, da der konvexseitige Krümmungsradius der Siliziumlinsenelemente exakt dem Kugelradius der Siliziumkugelelemente entspricht
Bei einem nachfolgenden Schritt 400 werden nun Kavitäten 26 ausgehend von dem zweiten Hauptoberflächenbereich (Rückseite) des Trägersubstrats 70 zu den Linsenelementen 24 erzeugt, wobei jeweils beispielsweise eine Kavität 26 pro Linsenelement 24 erzeugt wird. Somit ist der an die Kavität 26 angrenzende, optisch wirksame Bereich der konvexen Seite 24b der Linsenelemente 24 jeweils freigelegt bzw. freiliegend.

Dies wird beispielsweise mittels eines Ätzvorgangs des Siliziummaterials des Hilfssubstrats 72 von der Rückseite (dem zweiten Hauptoberflächenbereich desselben) aus erreicht, wobei ein Ätzstopp auf der Glasmaterialschicht 76 in den Ausnehmungen 74 erfolgt.

Daraufhin wird das an die Kavität 26 angrenzende Glasmaterial (zumindest teilweise) im Bereich der konvexen Seite 24b der Linsenelemente 24 entfernt, d.h. der optisch wirksame Bereich der Linse 24 wird freigelegt. Das Entfernen des Glasmaterials von dem Linsenelement 24 (Siliziumlinse) kann beispielsweise mittels Ätzen erfolgen.

Aus der vorhergehenden Beschreibung hinsichtlich des in Fig. 7A dargestellten Verfahrens 100-6a zum Herstellen von plankonvexen Linsenelementen auf Waferebene wird deutlich, dass die Schritte 202, 204, 206, 262, 264, 266 und 268 den Schritt 200 des Fixierens von Kugelelementen aus einem Halbleitermaterial an einem Trägersubstrat implementieren, woraufhin bei Schritt 300 das einseitige Dünnen der an dem Trägersubstrat 70 fixierten Kugelelemente 14 und ferner bei Schritt 400 das Bilden der Kavitäten 26 durchgeführt wird.

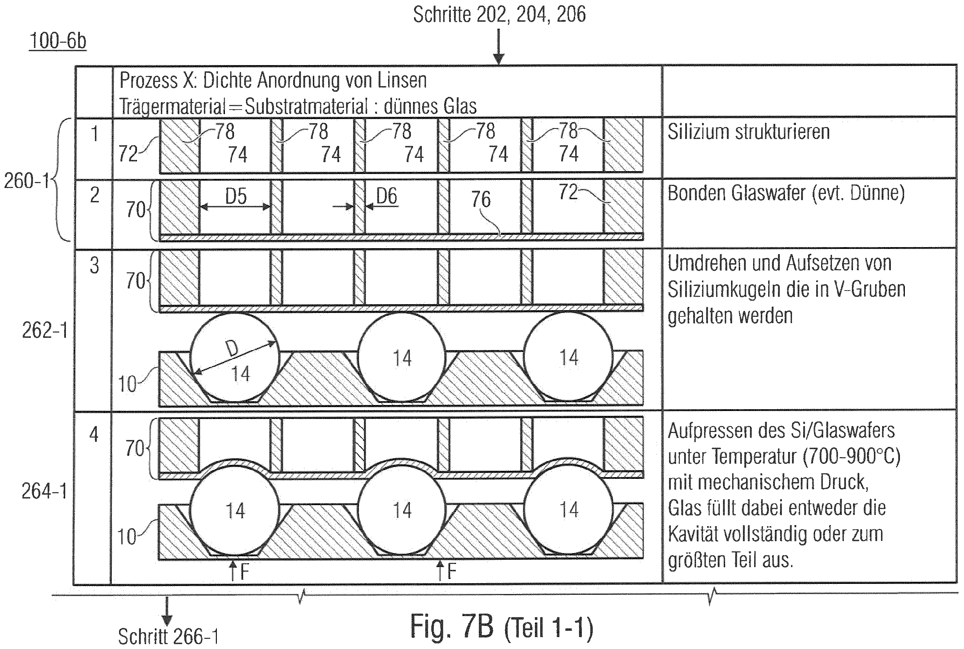

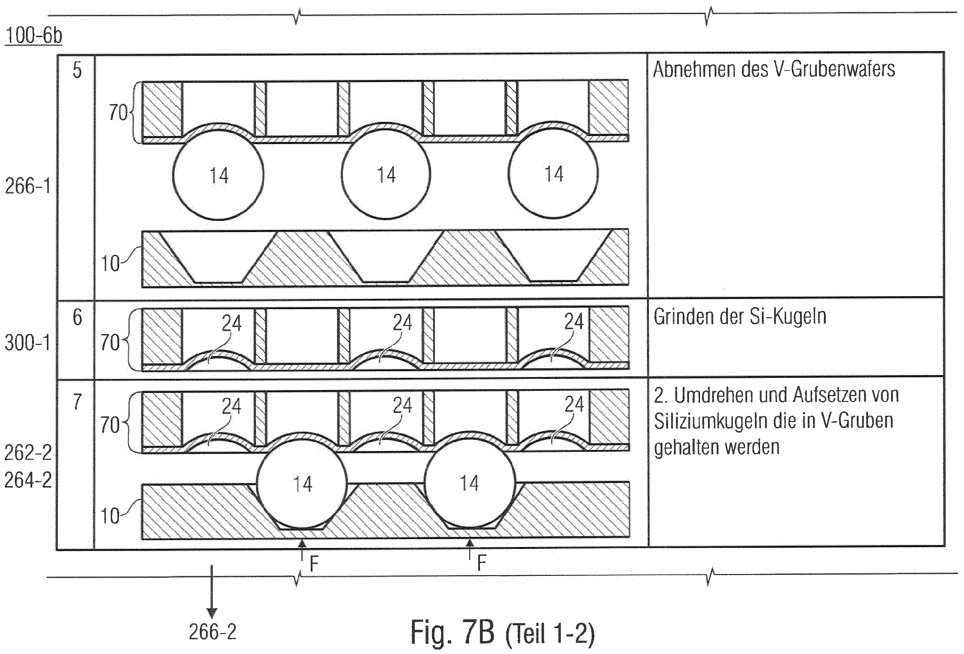

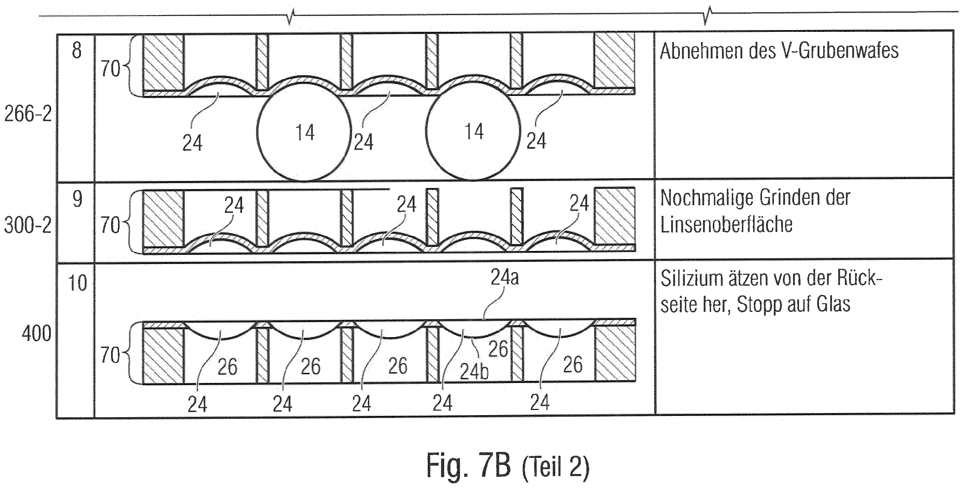

Im Folgenden wird nun anhand von Fig. 7B ein beispielhaftes Ablaufdiagramm eines weiteren Herstellungsverfahrens 100-6b zur Herstellung von plankonvexen Linsenelementen aus einem Halbleitermaterial auf Waferebene beschrieben.

Zunächst werden bei dem Verfahren 100-6b die bereits anhand der Fig. 2, 3 und 4 beschriebenen Verfahrensschritte 202, 204 und 206 durchgeführt, um ein mit Vertiefungen 12 versehenes (erstes) Teilsubstrat 10 aus einem Halbleitermaterial, z.B. Silizium, bereitzustellen. In den Vertiefungen 12 des Teilsubstrats 10 ist nun ein erster Teilsatz (eine erste Teilmenge) der Kugelelemente 14 so angeordnet, dass sich beispielsweise ein Kugelelement 14 in einer Vertiefung 12 des Teilsubstrats 10 befindet (Schritte 202, 204, 206).

Bei Schritt 260-1 von Fig. 7B wird nun ein weiteres (zweites) Teilsubstrat 70 bereitgestellt, das ein Hilfssubstrat 72 aus einem Halbleitermaterial, wie z.B. Silizium, aufweist. An einem ersten Hauptoberflächenbereich des Hilfssubstrats 72 sind (zum gegenüberliegenden zweiten Hauptoberflächenbereich z.B. durchgehende oder auch nicht-durchgehende) Durchgangsöffnungen oder Ausnehmungen 74 angeordnet. Diese Ausnehmungen 74 entsprechen jeweils den Positionen der auf dem ersten Teilsubstrat 10 angeordneten Kugelelemente 14 bzw. sind mit diesen Positionen ausrichtbar, d.h. die Ausnehmungen 74 und die Kugelelemente 14 können zentriert zueinander angeordnet werden. Die Ausnehmungen 74 können beispielsweise mittels herkömmlicher Halbleiterbearbeitungsprozesse, z.B. Ätzprozesse, in dem Halbleitermaterial 72 strukturiert werden.

Dabei ist der Durchmesser D5 der Ausnehmungen 74 in dem Hilfssubstrat 72 kleiner als der Durchmesser D der Kugelelemente 14. Der Durchmesser D5 der Ausnehmungen 74 beträgt beispielsweise 20 bis 70% bzw. 40 bis 60% des Durchmessers D der Kugelelemente 14, d.h. D5 = 0,2 - 0,7 * D bzw. D3 = 0,4 - 0,6 * D.

Die Zwischenbereiche 78 gemäß der Schnittansicht des Hilfssubstrats 72 sind nun z.B. so gewählt, dass die Ausnehmungen 76 in einem Abstand D6 zueinander angeordnet sind. Der Abstand (die Dicke) D6 kann z.B. so gewählt werden, dass der Durchmesser D5 und die Dicke D6 in Kombination kleiner oder gleich als der Durchmesser D der Kugelelemente 14 ist, d.h. D5 + D6 ≤ D. Der Durchmesser D5 und die Dicke D6 können z.B. gewählt werden, um eine möglichst hohe Packungsdichte der Kugelelemente 14 (nach dem Fixieren) an dem Hilfssubstrat 72 zu ermöglichen.

An dem ersten Hauptoberflächenbereich des Hilfsträgers 72 ist nun ferner eine (z.B. durchgehende) Glasmaterialschicht 76 angeordnet, die die Ausnehmungen 74 in dem Hilfssubstrat 72 (zumindest teilweise oder auch vollständig) überspannt bzw. überdeckt. Somit kann das zweite Teilsubstrat 70 erhalten werden, indem auf den mit den Ausnehmungen 74 strukturierten Hilfsträger 72 die (z.B. durchgehende) Glasmaterialschicht 76 aufgebracht wird, beispielsweise durch Bonden eines Glaswafers an einen ersten Hauptoberflächenbereich des Hilfssubstrats 72 und eventuellem nachträglichen Dünnen des Glaswafers. Ferner kann die Dicke der Glasmaterialschicht 76 beispielsweise zwischen 10 und 100 µm, zwischen 30 und 70 µm und etwa 50 µm betragen.

Bei Schritt 262-1 wird das weitere Teilsubstrat 70 auf dem mit den Kugelelementen 14 versehenen Teilsubstrat 10 angeordnet bzw. aufgesetzt, wobei der mit der Glasmaterialschicht 76 versehene erste Hauptoberflächenbereich des weiteren Teilsubstrats 70 den in den Vertiefungen 12 des ersten Teilsubstrats 10 angeordneten Kugelelementen 14 zugewandt ist, und wobei die Kugelelemente 14 mit einem Teilsatz der Ausnehmungen 74 des zweiten Teilsubstrats 70 beispielsweise möglichst mittig bzw. zentriert ausgerichtet sind. Das bereitgestellte Teilsubstrat 70 wird also beispielsweise umgedreht, und auf das erste Teilsubstrat 10 aufgesetzt, in dem die Siliziumkugeln 14 in den V-Gruben gehalten werden.

Bei Schritt 264-1 wird nun das mit der Glasmaterialschicht 76 versehene weitere Teilsubstrat 70 an den Kugelelementen 14 unter erhöhter Temperatur (Temperaturbehandlung bzw. Tempern bei 700-900°C) und unter Einwirkung eines mechanischen Drucks F aufgepresst bzw. fixiert.

Die Fixierung wird durch ein thermisches Bonden des Glasmaterials der Schicht 76 mit dem Halbleitermaterial (Silizium) der Kugelelemente 14 erreicht. Es wird also der mit einer Glasmaterialschicht 76 versehene Halbleiter-Wafer 70 unter erhöhter Temperatur (z.B. 700-900 °C) und mit mechanischem Druck F auf die an dem Hilfssubstrat 10 angeordneten Halbleiterkugelelemente (Siliziumkugeln) 14 aufgepresst. Bei dem oben dargestellten Prozessablauf 100-6b dient also eine an dem zweiten Teilsubstrat 70 angeordnete dünne Glasschicht 76 als Substratmaterial zum Fixieren der Halbleiterkugelelemente 14.

Das bei diesem Tempervorgang hinreichend erweichte Glasmaterial der Schicht füllt bei dem Aufpress- bzw. Fixierungsschritt die Ausnehmung 52 (Kavität) zumindest teilweise (d.h. zum größten Teil) oder auch vollständig aus.

Daraufhin wird bei Schritt 266-1 nun das (erste) Teilsubstrat 10 (der V-Grubenwafer) von den fest mit dem zweiten Teilsubstrat 70 verbundenen Kugelelementen 14 entfernt bzw. abgenommen, wobei nun das zweite Teilsubstrat 70 mit dem Hilfssubstrat 72 und der daran angeordneten Glasmaterialschicht 76 das Trägersubstrat bildet, an dem die Kugelelemente 14, d.h. der erste Teilsatz der Kugelelemente 14, fixiert sind.

Bei dem Schritt 300-1 des Dünnens der an dem Trägersubstrat 70 fixierten Kugelelemente 14 wird nun ein erster Teilsatz der plankonvexen Linsenelemente 24 erhalten. Der Prozess des mechanischen, einseitigen Dünnens kann beispielsweise mittels Schleifen bzw. Grinding der Kugelelemente (z.B. Halbleiter- bzw. Siliziumkugeln) erfolgen. Der Vorgang des mechanischen Dünnens wird solange durchgeführt, bis die gewünschte resultierende Linsenform (Linsenhöhe) der plankonvexen Linsenelemente 24 mit den exakten optischen Eigenschaften der resultierenden Linsenelemente 24 erhalten wird.

Bei einem Schritt 262-2 wird ein mit Vertiefungen 12 versehenes Teilsubstrats 10 bereitgestellt, wobei ein weiterer Teilsatz der Kugelelemente 14 in den Vertiefungen 12 des Teilsubstrats 10 angeordnet sind. Bei Schritt 262-2 kann das Teilsubstrat 10 von Schritt 262-1 verwendet werden, das mit dem weiteren Teilsatz der Kugelelemente 14 in den Vertiefungen 12 "neu-bestückt" wurde, oder es kann ein weiteres Teilsubstrats 10 mit dem weiteren Teilsatz der Kugelelemente 14 in den Vertiefungen 12 bereitgestellt werden.

Bei dem Schritt 262-2 wird ferner das weitere Teilsubstrats 70 auf dem mit dem weiteren Teilsatz von Kugelelementen 14 versehenen Teilsubstrat 10 angeordnet, wobei der mit der Glasmaterialschicht 74 versehene erste Hauptoberflächenbereich des weiteren Teilsubstrats 70 den Kugelelementen 14 zugewandt ist, und wobei die Kugelelemente 14 mit einem weiteren "unbelegten" Teilsatz der Durchgangsöffnungen 76 ausgerichtet sind.

Bei Schritt 262-2 wird also das weitere Teilsubstrat 70 (mit dem ersten Teilsatz von Kugelelementen) auf dem mit dem weiteren Teilsatz von Kugelelementen 14 versehenen Teilsubstrat 10 angeordnet bzw. aufgesetzt, wobei die weiteren Kugelelemente 14 mit einem weiteren unbelegten Teilsatz der Ausnehmungen 74 des zweiten Teilsubstrats 70 beispielsweise möglichst mittig bzw. zentriert ausgerichtet sind. Das bereitgestellte Teilsubstrat 70 wird also beispielsweise umgedreht, und auf das erste Teilsubstrat 10 aufgesetzt, in dem die Siliziumkugeln 14 in den V-Gruben gehalten werden.

Bei Schritt 264-2 wird nun das mit der Glasmaterialschicht 76 versehene weitere Teilsubstrat 70 an den weiteren Kugelelementen 14 unter erhöhter Temperatur (Temperaturbehandlung bzw. Tempern bei 700-900°C) und unter Einwirkung eines mechanischen Drucks F aufgepresst bzw. fixiert.

Die Fixierung wird wieder durch ein thermisches Bonden des Glasmaterials der Schicht 76 mit dem Halbleitermaterial (Silizium) der weiteren Kugelelemente 14 erreicht. Es wird also der mit einer Glasmaterialschicht 76 versehene Halbleiter-Wafer 70 unter erhöhter Temperatur (z.B. 700-900 °C) und mit mechanischem Druck F auf die an dem Hilfssubstrat 10 angeordneten Halbleiterkugelelemente (Siliziumkugeln) 14 aufgepresst. Bei dem oben dargestellten Prozessablauf 100-6b dient also eine an dem zweiten Teilsubstrat 70 angeordnete dünne Glasschicht 76 als Substratmaterial zum Fixieren der Halbleiterkugelelemente 14. Das bei diesem Tempervorgang hinreichend erweichte Glasmaterial der Schicht füllt bei dem Aufpress- bzw. Fixierungsschritt die Ausnehmung 52 (Kavität) zumindest teilweise (d.h. zum größten Teil) oder auch vollständig aus.

Daraufhin wird bei Schritt 266-2 nun das (erste) Teilsubstrat 10 (der V-Grubenwafer) von den fest mit dem zweiten Teilsubstrat 70 verbundenen, weiteren Kugelelementen 14 entfernt bzw. abgenommen, wobei nun das zweite Teilsubstrat 70 mit dem Hilfssubstrat 72 und der daran angeordneten Glasmaterialschicht 76 das Trägersubstrat bildet, an dem die Kugelelemente 14, d.h. der weitere Teilsatz der Kugelelemente 14, fixiert sind.

Bei dem Schritt 300-2 des Dünnens der an dem Trägersubstrat 70 fixierten, weiteren Kugelelemente 14 wird nun ein weiterer Teilsatz der plankonvexen Linsenelemente 24 erhalten. Der Prozess des mechanischen, einseitigen Dünnens kann beispielsweise mittels Schleifen bzw. Grinding der Kugelelemente (z.B. Halbleiter- oder Siliziumkugeln) erfolgen. Der Vorgang des mechanischen Dünnens wird solange durchgeführt, bis die gewünschte resultierende Linsenform (Linsenhöhe) der plankonvexen Linsenelemente 24 mit den exakten optischen Eigenschaften der resultierenden Linsenelemente 24 (erster und zweiter Teilsatz) erhalten wird.

Bei dem Schritt des Dünnens (300-1, 300-2) wird (direkt) die ebene Seite 24a der plankonvexen Linsenelemente 24 erhalten, während sich die konvexe Seite 24b der Linsenelemente 24 (zumindest teilweise) in dem Glasmaterial der Schicht 76 befindet. Dabei entspricht der konvexseitige Krümmungsradius der hergestellten Linsenelemente dem Kugelradius R der (unbearbeiteten bzw. nicht gedünnten) an dem Trägersubstrat fixierten Kugelelemente. Durch das einseitige Dünnen der an dem Trägersubstrat fixierten Kugelelemente wird ferner die plane bzw. ebene Seite der plankonvexen Linsenelemente gebildet. Dabei bilden die Durchgangsöffnungen des weiteren Teilsubstrats (70) Kavitäten (26) für die Linsenelemente (24), wobei der an die Kavität (26) angrenzende Bereich der Linsenelemente (24) zumindest teilweise freiliegend ist.

Der Dünnungsprozess wird also solange ausgeführt, bis die erforderliche Höhe des resultierenden Kugelsegments basierend auf dem vorgegeben Krümmungsradius (ROC: radius of curvature) exakt eingestellt ist, so dass die gewünschten optischen Eigenschaften des resultierenden Siliziumlinsenelements exakt erhalten werden können, da der konvexseitige Krümmungsradius der Siliziumlinsenelemente exakt dem Kugelradius der Siliziumkugelelemente entspricht

Bei einem nachfolgenden Schritt 400 werden nun Kavitäten 26 ausgehend von dem zweiten Hauptoberflächenbereich (Rückseite) des Trägersubstrats 70 zu den Linsenelementen 24 erzeugt, wobei jeweils beispielsweise (zumindest) eine Kavität 26 pro Linsenelement 24 erzeugt wird. Somit ist der an die Kavität 26 angrenzende, optisch wirksame Bereich der konvexen Seite 24b der Linsenelemente 24 jeweils freigelegt bzw. freiliegend.

Dies wird beispielsweise mittels eines Ätzvorgangs des Siliziummaterials des Hilfssubstrats 72 von der Rückseite (dem zweiten Hauptoberflächenbereich desselben) aus erreicht, wobei ein Ätzstopp auf der Glasmaterialschicht 76 in den Ausnehmungen 74 erfolgt.

Daraufhin wird das an die Kavität 26 angrenzende Glasmaterial (zumindest teilweise) im Bereich der konvexen Seite 24b der Linsenelemente 24 entfernt, d.h. der optisch wirksame Bereich der Linse 24 wird freigelegt. Das Entfernen des Glasmaterials von dem Linsenelement 24 (Siliziumlinse) kann beispielsweise mittels Ätzen erfolgen.

Aus der vorhergehenden Beschreibung hinsichtlich des in Fig. 7A dargestellten Verfahrens 100-6a zum Herstellen von plankonvexen Linsenelementen auf Waferebene wird deutlich, dass die Schritte 202, 204, 206, 262, 264, 266 und 268 den Schritt 200 des Fixierens von Kugelelementen aus einem Halbleitermaterial an einem Trägersubstrat implementieren, woraufhin bei Schritt 300 das einseitige Dünnen der an dem Trägersubstrat 70 fixierten Kugelelemente 14 und ferner bei Schritt 400 das Bilden der Kavitäten 26 durchgeführt wird.

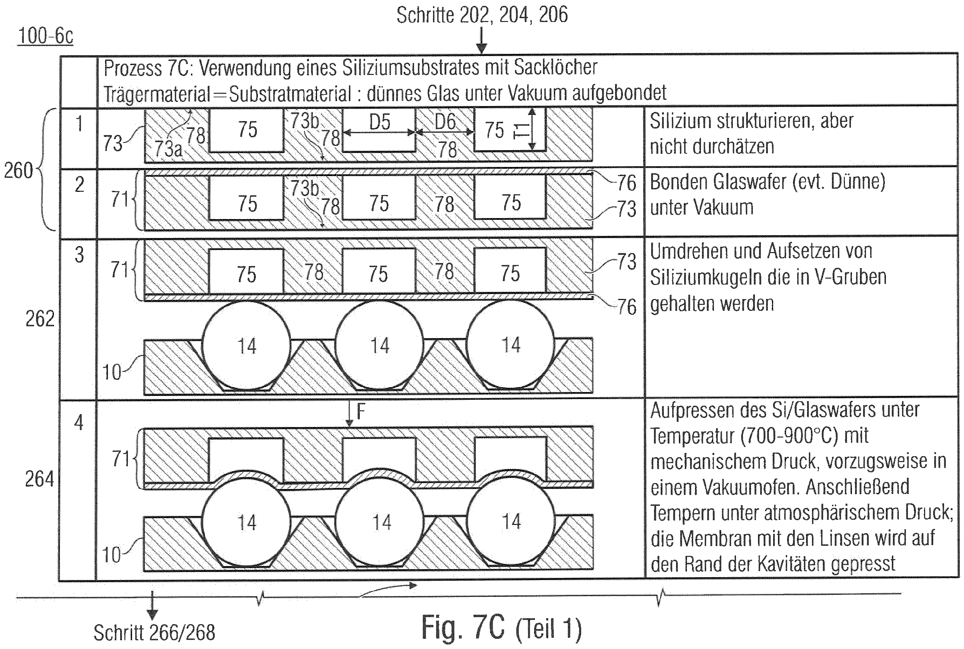

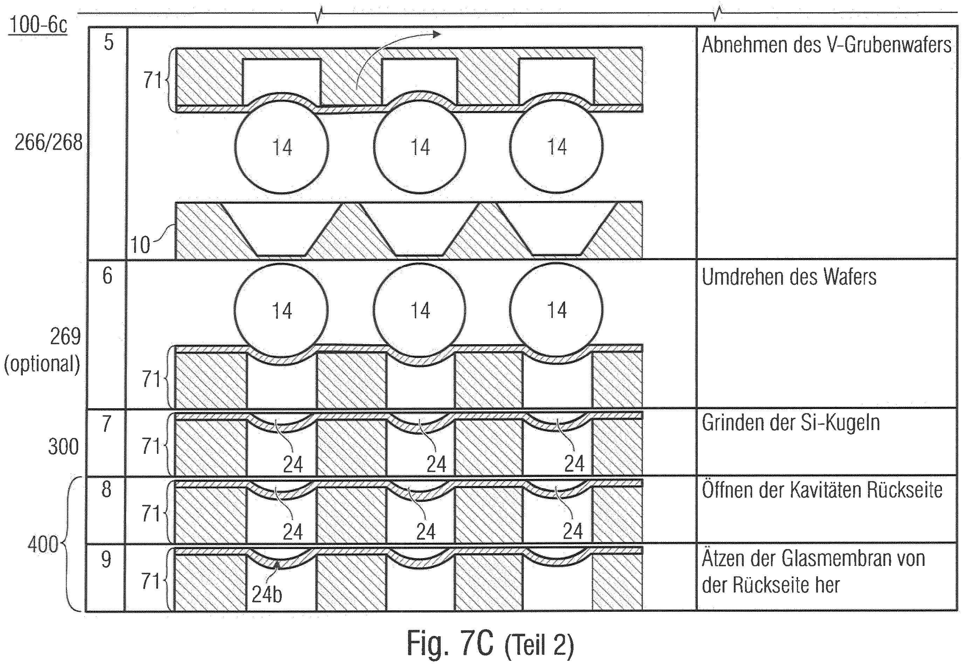

Im Folgenden wird nun anhand von Fig. 7C ein beispielhaftes Ablaufdiagramm eines weiteren Herstellungsverfahrens 100-6c zur Herstellung von plankonvexen Linsenelementen aus einem Halbleitermaterial auf Waferebene beschrieben.

Zunächst werden bei dem Verfahren 100-6c die bereits anhand der Fig. 2, 3 und 4 beschriebenen Verfahrensschritte 202, 204 und 206 durchgeführt, um ein mit Vertiefungen 12 versehenes erstes Teilsubstrat 10 z.B. aus einem Halbleitermaterial, wie z.B. Silizium, bereitzustellen. In den Vertiefungen 12 des ersten Teilsubstrats 10 sind nun die Kugelelemente 14 so angeordnet, dass sich beispielsweise jeweils ein Kugelelement 14 in einer Vertiefung 12 des ersten Teilsubstrats 10 befindet (Schritte 202, 204, 206).

Bei Schritt 260 von Fig. 7C wird nun ein zweites Teilsubstrat 71 bereitgestellt, das ein Hilfssubstrat 73 aus einem Halbleitermaterial, wie z.B. Silizium, aufweist. An einem ersten Hauptoberflächenbereich 73a des Hilfssubstrats 73 sind (zum gegenüberliegenden zweiten Hauptoberflächenbereich 73b) nicht-durchgehende Ausnehmungen 75 angeordnet. Diese Ausnehmungen 75 entsprechen jeweils den Positionen der auf dem ersten Teilsubstrat 10 angeordneten Kugelelemente 14 bzw. sind mit diesen Positionen ausrichtbar, d.h. die Ausnehmungen 75 und die Kugelelemente 14 können zentriert zueinander angeordnet werden. Die Ausnehmungen 75 können beispielsweise mittels herkömmlicher Halbleiterbearbeitungsprozesse, z.B. Ätzprozesse, in dem Halbleitermaterial des Hilfssubstrats 73 strukturiert werden, d.h. indem beispielsweise von der Vorderseite 73a des Hilfssubstrats 73 das Halbleitermaterial, z.B. Silizium, bis zu einer Tiefe T1 geätzt wird.

Dabei ist der Durchmesser D5 der Ausnehmungen 75 in dem Hilfssubstrat 73 kleiner als der Durchmesser D der Kugelelemente 14. Der Durchmesser D5 der Ausnehmungen 75 beträgt beispielsweise 20 bis 70% bzw. 40 bis 60% des Durchmessers D der Kugelelemente 14, d.h. D5 = 0,2 - 0,7 * D bzw. D3 = 0,4 - 0,6 * D.

Die Zwischenbereiche 78 gemäß der Schnittansicht des Hilfssubstrats 73 sind nun z.B. so gewählt, dass die Ausnehmungen 75 in einem Abstand (Dicke) D6 zueinander angeordnet sind. Der Abstand D6 kann z.B. so gewählt werden, dass der Durchmesser D5 und der Abstand D6 in Kombination größer als der Durchmesser D der Kugelelemente 14 ist, d.h. D5 + D6 ≥ D. Der Durchmesser D5 und der Abstand D6 kann z.B. gewählt werden, um eine möglichst hohe Packungsdichte der Kugelelemente 14 an dem ersten Teilsubstrat 10 und (nach dem Fixieren) an dem Hilfssubstrat 73 zu ermöglichen.

An dem ersten Hauptoberflächenbereich des Hilfsträgers 73 ist nun ferner eine (z.B. durchgehende) Glasmaterialschicht 76 angeordnet, die die Ausnehmungen 75 in dem Hilfssubstrat 73 z.B. vollständig überspannt bzw. überdeckt. Somit kann das zweite Teilsubstrat 71 erhalten werden, indem auf den mit den Ausnehmungen 75 strukturierten Hilfsträger 73 die (z.B. durchgehende) Glasmaterialschicht 76 aufgebracht wird, beispielsweise durch Bonden eines Glaswafers an einen ersten Hauptoberflächenbereich des Hilfssubstrats 73 und eventuellem nachträglichen Dünnen des Glaswafers. Ferner kann die Dicke der Glasmaterialschicht 76 beispielsweise zwischen 10 und 100 µm, zwischen 30 und 70 µm und etwa 50 µm betragen.

Bei Schritt 262 wird das zweite Teilsubstrat 71 auf dem ersten, mit den Kugelelementen 14 versehenen Teilsubstrat 10 angeordnet bzw. aufgesetzt, wobei der mit der Glasmaterialschicht 76 versehene erste Hauptoberflächenbereich des zweiten Teilsubstrats 71 den in den Vertiefungen 12 des ersten Teilsubstrats 10 angeordneten Kugelelementen 14 zugewandt ist, und wobei die Kugelelemente 14 mit den Ausnehmungen 75 des zweiten Teilsubstrats 70 beispielsweise möglichst mittig bzw. zentriert ausgerichtet sind. Das bereitgestellte Teilsubstrat 71 wird also beispielsweise umgedreht, und auf das erste Teilsubstrat 10 aufgesetzt, in dem die Siliziumkugeln 14 in den V-Gruben gehalten werden.

Bei Schritt 264 wird nun das mit der Glasmaterialschicht 76 versehene zweite Teilsubstrat 71 an den Kugelelementen 14 unter erhöhter Temperatur (z.B. in einem Vakuumofen) und unter Einwirkung eines mechanischen Drucks F aufgepresst bzw. fixiert. Die Fixierung wird durch ein thermisches Bonden des Glasmaterials der Schicht 76 mit dem Halbleitermaterial (Silizium) der Kugelelemente 14 erreicht. Es wird also der mit einer Glasmaterialschicht 76 versehene Halbleiter-Wafer 71 unter erhöhter Temperatur (z.B. 700-900 °C) und mit mechanischem Druck F auf die an dem Hilfssubstrat 10 angeordneten Halbleiterkugelelemente (Siliziumkugeln) 14 aufgepresst. Daraufhin wird z.B. eine Temperaturbehandlung (Tempern) unter atmosphärischen Druck durchgeführt. Bei dem oben dargestellten Prozessablauf 100-6c dient also eine an dem zweiten Teilsubstrat 71 angeordnete dünne Glasschicht 76 als Substratmaterial zum Fixieren der Halbleiterkugelelemente 14. Das bei diesem Tempervorgang hinreichend erweichte Glasmaterial der Schicht 76 überspannt bei dem Aufpress- bzw. Fixierungsschritt die Ausnehmung 75 (Kavität) beispielsweise vollständig.

Daraufhin wird bei Schritt 266, 268 nun das erste Teilsubstrat 10 (der V-Grubenwafer) von den fest mit dem zweiten Teilsubstrat 71 verbundenen Kugelelementen 14 entfernt bzw. abgenommen, wobei nun das zweite Teilsubstrat 71 mit dem Hilfssubstrat 73 und der daran angeordneten Glasmaterialschicht 76 das Trägersubstrat bildet, an dem die Kugelelemente 14 fixiert sind. Bei einem optionalen Schritt 269 wird das zweite Teilsubstrat 71 beispielsweise umgedreht bzw. für den nächsten Bearbeitungsschritt ausgerichtet.

Bei dem Schritt 300 des Dünnens der an dem Trägersubstrat 71 fixierten Kugelelemente 14 werden nun die plankonvexen Linsenelemente 24 erhalten. Der Prozess des mechanischen, einseitigen Dünnens kann beispielsweise mittels Schleifen bzw. Grinding der Halbleiterkugelelemente (Siliziumkugeln) erfolgen. Der Vorgang des mechanischen Dünnens wird solange durchgeführt, bis die gewünschte resultierende Linsenform (Linsenhöhe) der plankonvexen Linsenelemente 24 mit den exakten optischen Eigenschaften der resultierenden Linsenelemente 24 erhalten wird. Bei dem Schritt des Dünnens wird (direkt) die ebene Seite 24a der plankonvexen Linsenelemente 24 erhalten, während sich die konvexe Seite 24b der Linsenelemente 24 (zumindest teilweise) in dem Glasmaterial der Schicht 76 befindet. Dabei entspricht der konvexseitige Krümmungsradius der hergestellten Linsenelemente dem Kugelradius R der (unbearbeiteten bzw. nicht gedünnten) an dem Trägersubstrat fixierten Kugelelemente. Durch das einseitige Dünnen der an dem Trägersubstrat fixierten Kugelelemente wird ferner die plane bzw. ebene Seite der plankonvexen Linsenelemente gebildet.

Der Dünnungsprozess wird also solange ausgeführt, bis die erforderliche Höhe des resultierenden Kugelsegments basierend auf dem vorgegeben Krümmungsradius (ROC: radius of curvature) exakt eingestellt ist, so dass die gewünschten optischen Eigenschaften des resultierenden Siliziumlinsenelements exakt erhalten werden können, da der konvexseitige Krümmungsradius der Siliziumlinsenelemente exakt dem Kugelradius der Siliziumkugelelemente entspricht
Bei einem nachfolgenden Schritt 400 werden nun Kavitäten 26 ausgehend von dem zweiten Hauptoberflächenbereich (Rückseite) des Trägersubstrats 71 zu den Linsenelementen 24 erzeugt, wobei jeweils beispielsweise eine Kavität 26 pro Linsenelement 24 erzeugt wird. Somit ist der an die Kavität 26 angrenzende, optisch wirksame Bereich der konvexen Seite 24b der Linsenelemente 24 jeweils freigelegt bzw. freiliegend.

Dies wird beispielsweise mittels eines Ätzvorgangs des Siliziummaterials des Hilfssubstrats 73 von der Rückseite (dem zweiten Hauptoberflächenbereich desselben) aus erreicht, wobei ein Ätzstopp auf der Glasmaterialschicht 74 in den Ausnehmungen 75 erfolgt.

Daraufhin wird das an die Kavität 26 angrenzende Glasmaterial (zumindest teilweise) im Bereich der konvexen Seite 24b der Linsenelemente 24 entfernt, d.h. der optisch wirksame Bereich der Linse 24 wird freigelegt. Das Entfernen des Glasmaterials von dem Linsenelement 24 (Siliziumlinse) kann beispielsweise mittels Ätzen erfolgen.

Aus der vorhergehenden Beschreibung hinsichtlich des in Fig. 7C dargestellten Verfahrens 100-6c zum Herstellen von plankonvexen Linsenelementen auf Waferebene wird deutlich, dass die Schritte 202, 204, 206, 262, 264, 266 und 268 den Schritt 200 des Fixierens von Kugelelementen aus einem Halbleitermaterial an einem Trägersubstrat implementieren, woraufhin bei Schritt 300 das einseitige Dünnen der an dem Trägersubstrat 70 fixierten Kugelelemente 14 und ferner bei Schritt 400 das Bilden der Kavitäten 26 durchgeführt wird.

Bei dem in Fig. 7C dargestellten Verfahrens 100-6c zum Herstellen von plankonvexen Linsenelementen auf Waferebene können nach dem Schritt 300 des Dünnens der an dem Trägersubstrat 71 fixierten Kugelelemente 14 ferner die anhand von Fig. 4B beschriebenen optionalen Schritte 402, 404, 406 durchgeführt werden, bei denen die Rückseite 71b (zweite Hauptoberfläche) des zweiten Teilsubstrats 71 bearbeitet wird, um das mit den plankonvexen Linsenelementen 24 versehene zweite Teilsubstrat bzw. Trägersubstrat 71 für die elektrische und mechanische Verbindung, d.h. beispielsweise für ein Waferbonding, mit einem Bauelementesubstrat (Sensorwafer) vorzubereiten und bereitstellen zu können. Dabei kommt insbesondere zum Tragen, dass die Rückseite 71b (zweite Hauptoberfläche) des zweiten Teilsubstrats bzw. Linsenwafers 71 noch im Wesentlichen völlig eben und gleichmäßig ist, da bei den vorangegangenen Prozessschritten nur eine Bearbeitung von der Vorderseite 71a (d.h. von dem ersten Oberflächenbereich 71a) des zweiten Teilsubstrats bzw. Trägersubstrats 71 stattgefunden hat. Dadurch wird eine deutliche Vereinfachung der weiteren Prozessierung und prozesstechnischen Behandlung von der Rückseite 71b des zweiten Hilfssubstrats 71 erreicht.

Da bei dem anhand von Fig. 7C dargestellten Verfahren die "durchgehende" Glasmaterialschicht 76 die Ausnehmungen 75 in dem Hilfssubstrat 73 z.B. vollständig überspannt bzw. überdeckt, ist es nicht erforderlich, dass die Halbleiterkugeln 14 (Siliziumkugeln) hier für dier Verfahrensschritte 402, 404, 406 eine Passivierungsschicht, z.B. eine Oxidschicht, aufweisen. Bei dem Ätzen der rückseitigen Halbleiterstrukturen erfüllt dabei die Glasmaterialschicht 76 auf den Siliziumkugelsegmenten 24 gegenüber dem von der Rückseite durchgeführten Ätzvorgang die Schutzfunktion für die Siliziumlinsen.

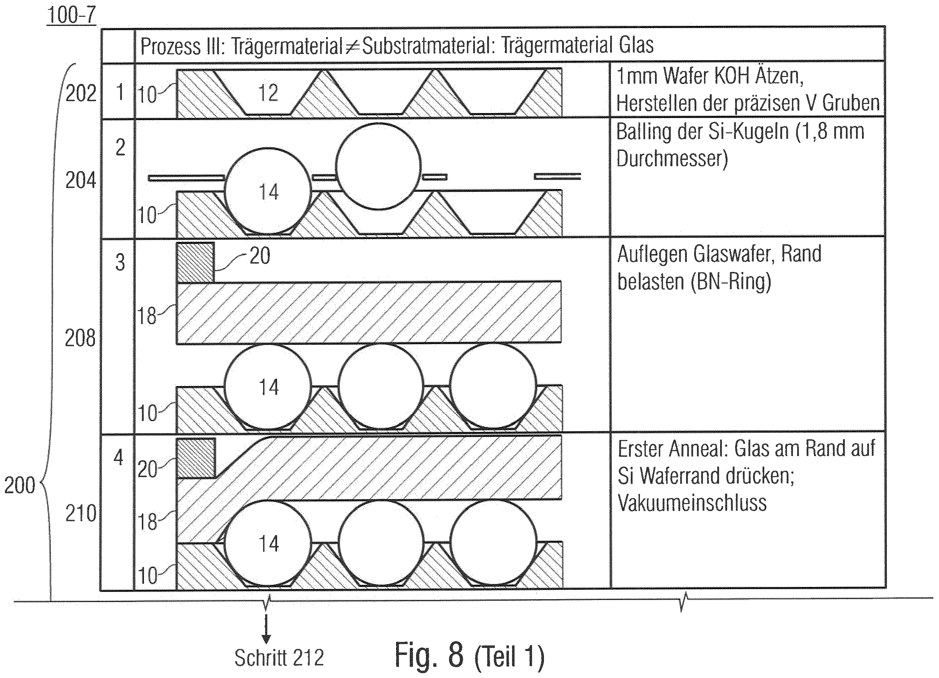

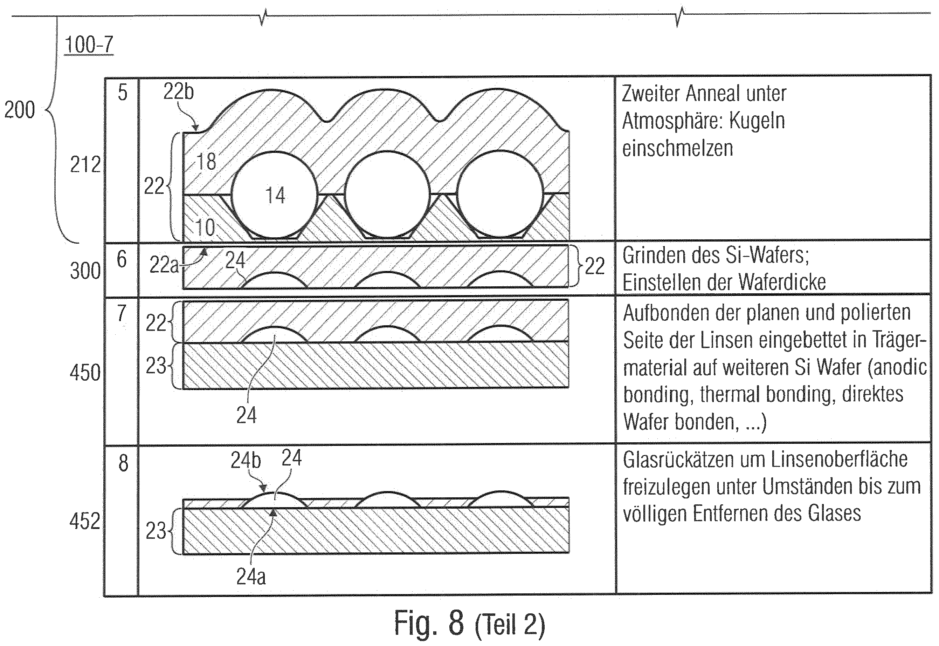

Im Folgenden wird nun anhand von Fig. 8 ein beispielhaftes Ablaufdiagramm eines weiteren Herstellungsverfahrens 100-7 zur Herstellung von plankonvexen Linsenelementen aus einem Halbleitermaterial auf Waferebene beschrieben.

Fig. 8 zeigt nun ein beispielhaftes Ablaufdiagramm des erfindungsgemäßen Herstellungsverfahrens 100-7 von plankonvexen Linsenelementen aus einem Halbleitermaterial, wie z.B. Silizium, auf Waferebene. Im Folgenden wird nun zunächst der Prozessablauf des Schritts 200 des Fixierens von Kugelelementen aus einem Halbleitermaterial, wie z.B. Silizium, an einem Trägersubstrat beschrieben.

Zunächst wird bei einem Schritt 202 ein erstes Teilsubstrat 10 mit Vertiefungen 12 bereitgestellt. Das erste Teilsubstrat 10 ist zum Aufnehmen von Kugelelementen vorgesehen, wobei die Vertiefungen 12 quadratisch bzw. rechteckig oder kreisrund ausgebildet sein können.

Wie in Fig. 8 bei Schritt 204 dargestellt ist, können nun eine Vielzahl von Kugelelementen 14 aus einem Halbleitermaterial mit einem Durchmesser D bereitgestellt werden, wobei dann jeweils ein Kugelelement 14 in eine der Vertiefungen 12 des ersten Teilsubstrats 10 eingebracht wird, so dass sich jeweils ein Kugelelement 14 in einer Vertiefung 12 des ersten Teilsubstrats befindet. Dieser Vorgang wird auch als "Balling" bezeichnet.

Die Vertiefungen 12 in dem ersten Teilsubstrat 10 können mittels herkömmlicher Halbleiterbearbeitungstechniken, wie z.B. Ätzverfahren, mit einer hohen Genauigkeit gebildet werden, so dass eine exakte Passform zwischen dem jeweiligen Kugelelement 14 und den Boden- bzw. Seitenwänden der Vertiefungen 12 erreicht werden kann.

Bei Schritt 208 sind nun die Kugelelemente 14 in den Vertiefungen 12 des ersten Teilsubstrats 10 angeordnet, wobei ein zweites Teilsubstrat 18 auf dem mit den Kugelelementen 14 versehenen ersten Teilsubstrat 10 angeordnet wird. Das zweite Teilsubstrat 18 kann beispielsweise ein Glasmaterial aufweisen. Bei Schritt 208 kann also ein "Glas-Wafer" 18 auf das mit den Kugelelementen 14 versehene Teilsubstrat 10 "aufgelegt" werden. Wie bei Schritt 208 ferner dargestellt ist, kann ein Ring 20 (z.B. ein BN-Ring, BN = Boronnitrid) an dem Randbereich des zweiten Teilsubstrats 18 umlaufend vorgesehen sein, um bei einem nachfolgenden Temperaturbehandlungsschritt 210 (Tempern "T-1" bzw. erster Anneal) bei einer Temperatur von beispielsweise 700-900 °C das erste und das zweite Teilsubstrat 10, 18 zumindest in einem Randbereich (Waferrand) fest aneinander zu fixieren (zu bonden). Dazu wird zusätzlich zur Temperaturbehandlung mechanischer Druck F durch den Ring 20 auf das Glasmaterial des zweiten Teilsubstrats 10 ausgeübt wird.

Dieser erste Temper-Vorgang wird beispielsweise möglichst unter Vakuum, durchgeführt, so dass in dem eingeschlossenen inneren Bereich zwischen dem ersten und zweiten Teilsubstrat 10, 18 entsprechend ein Vakuumeinschluss erhalten werden kann.

Bei einem weiteren Temperaturbehandlungsschritt 212 (zweiter Anneal oder Tempern T2) unter "normaler" Atmosphäre mit den beiden aneinander fixierten Teilsubstraten 10, 18 wird eine zumindest teilweise Verflüssigung bzw. hinreichende Erweichung des Glasmaterials des zweiten Teilsubstrats 18 erreicht, so dass die Kugelelemente 14 zumindest teilweise mit dem hinreichend erweichten Glasmaterial des zweiten Teilsubstrats 18 umflossen werden. Nach einer Wiederverfestigung des Glasmaterials des zweiten Teilsubstrats 18 sind also die Kugelelemente 14 zwischen dem ersten Teilsubstrat 10 und dem verfestigten Glasmaterial des zweiten Teilsubstrats 18 eingebettet. Somit bilden das erste Teilsubstrat 10 und das wiederverfestigte Glasmaterial des zweiten Teilsubstrats 18 das Trägersubstrat 22, in dem die Kugelelemente 14 fixiert bzw. eingebettet sind. Der Verfahrensschritt 212 von Fig. 8 basiert dabei beispielsweise auf Techniken des sogenannten Glasfließens.

Um nun die gewünschten plankonvexen Linsenelemente 24 aus den Kugelelementen 14 eingebettet in dem Trägersubstrat zu erhalten, wird das Trägersubstrat 22 beidseitig (z.B. mechanisch) gedünnt, d.h. mittels eines Schleifverfahrens (Grinding) bearbeitet.

Ausgehend von dem zweiten Hauptoberflächenbereich 22b des Trägersubstrats 22 werden bei dem mechanischen Dünnungsprozess Unebenheiten in dem verfestigten Glasmaterial des zweiten Teilsubstrats 18 eingeebnet bzw. planarisiert.

Ausgehend von dem ersten Hauptoberflächenbereich 22a des Trägersubstrats 22 wird nun einerseits das Material des ersten Teilsubstrats 10, z.B. mittels Schleifen, entfernt, wobei ferner die an dem resultierenden Trägersubstrat 22 fixierten Kugelelemente 14 einseitig gedünnt (mechanisch abgeschliffen) werden, um die plankonvexen Linsenelemente 24 zu erhalten. Über das exakte Einstellen der resultierenden Waferdicke des Trägersubstrats 22 können die exakten optischen Eigenschaften der resultierenden Linsenelemente 24 eingestellt werden. Dabei ist die ebene Seite 24a der resultierenden plankonvexen Linsenelemente bündig mit der gedünnten Rückseite (ersten Hauptoberfläche) des Trägersubstrats 22, während sich die konvexe Seite 24b der Linsenelemente 24 in dem verfestigten Glasmaterial des zweiten Teilsubstrats 18 befindet.

Bei Schritt 450 wird nun an den ersten Hauptoberflächenbereich 22a des mit den Linsenelementen 24 versehenen Trägersubstrats 22 ein drittes Teilsubstrat 23 aufgebondet bzw. mit demselben verbunden, wobei das dritte Teilsubstrat 23 ein Halbleitermaterial, wie z.B. Silizium, aufweisen kann. Somit wird die plane und polierte Seite 24a der Linsenelemente 24, d.h. die in dem Trägersubstrat 22 eingebetteten Linsenelemente 24, auf ein weiteres, drittes Teilsubstrat, wie z.B. einen Silizium-Wafer, aufgebonded. Dieser Verbindungsvorgang (Aufbonden) kann mittels anodischem Bonden (anodic bonding), thermischem Bonden (thermal bonding), oder direktem Wafer-Bonden erfolgen.

Bei Schritt 452 wird nun das Glasmaterial des Trägersubstrats 22 ausgehend von der ersten, freiliegenden Hauptoberfläche desselben zumindest teilweise entfernt, um die optisch wirksame, konvexseitige Oberfläche 24b der Linsenelemente 24 zumindest teilweise freizulegen. Dies kann beispielsweise durch Glasrückätzen des Glasmaterials des Trägersubstrats 22 erfolgen, um die (konvexseitige) Linsenoberfläche freizulegen, wobei unter Umständen das Glasmaterial völlig entfernt werden kann. Dies hängt beispielsweise von der jeweiligen Weiterverarbeitung der Linsenelemente 24 auf dem dritten Teilsubstrat 23 ab.

Bei der in Schritt 452 dargestellten Anordnung mit den an dem dritten Teilsubstrat 23 angeordneten Linsenelementen 24 wird deutlich, dass die plane Seite 24a der Linsenelemente 24 auf dem dritten Teilsubstrat 24 aufliegt bzw. daran gebondet ist, während die konvexseitige Oberfläche 24b der Linsenelemente 24 (d.h. zumindest der optisch wirksame Bereich derselben) freiliegend bzw. freigelegt ist.

Die ober dargestellten Verfahrensschritte 200, 204, 206, 208, 210 und 212 bilden somit zusammen den Schritt 200 des Fixierens 200 von Kugelelementen aus einem Halbleitermaterial an einem Trägersubstrat, während der Schritt 300 des einseitigen Dünnens der an dem Trägersubstrat fixierten Kugelelemente zum Bilden der plankonvexen Linsenelemente aus einem Halbleitermaterial realisiert wird.

Zunächst werden bei dem Verfahren 100-8 die im Vorhergehenden beschriebenen Verfahrensschritte 202, 204 und 206 durchgeführt, um ein mit Vertiefungen 12 versehenes erstes Teilsubstrat 10 aus einem Halbleitermaterial, z.B. Silizium, bereitzustellen. In den Vertiefungen 12 des ersten Teilsubstrats 10 sind nun die Kugelelemente 14 so angeordnet, dass sich beispielsweise jeweils ein Kugelelement 14 in einer Vertiefung 12 des ersten Teilsubstrats 10 befindet (Schritte 202, 204, 206).

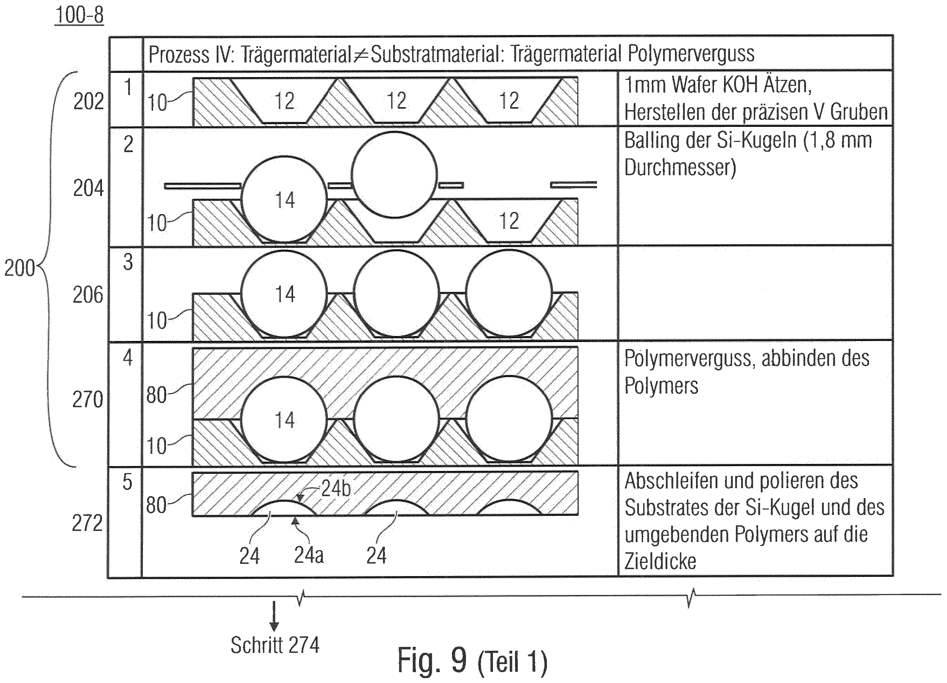

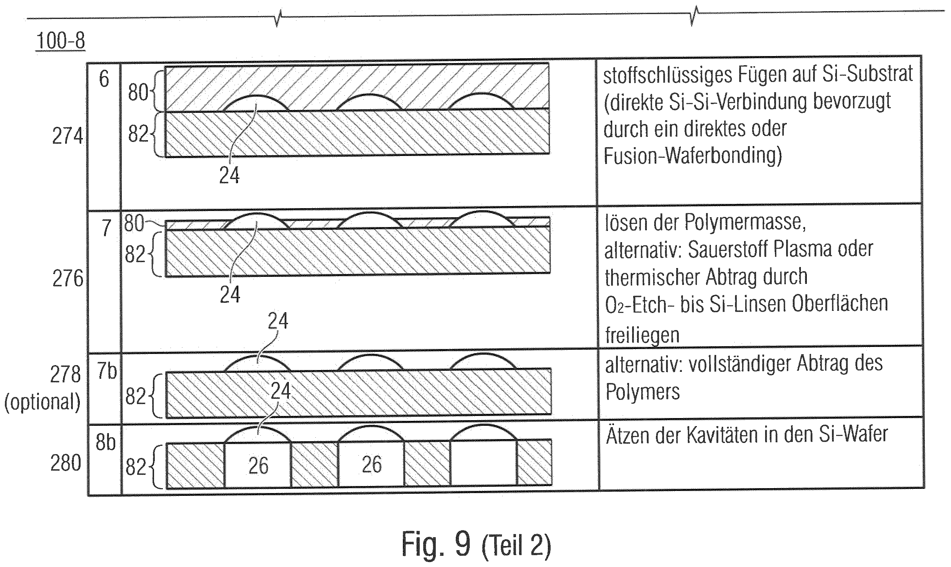

Im Folgenden wird nun anhand von Fig. 9 ein beispielhaftes Ablaufdiagramm eines weiteren Herstellungsverfahrens 100-8 zur Herstellung von plankonvexen Linsenelementen aus einem Halbleitermaterial auf Waferebene beschrieben. Im Folgenden wird nun zunächst der Prozessablauf des Schritts 200 des Fixierens von Kugelelementen aus einem Halbleitermaterial, wie z.B. Silizium, an einem Trägersubstrat beschrieben.

Zunächst wird bei einem Schritt 202 ein erstes Teilsubstrat 10 mit Vertiefungen 12 bereitgestellt. Das erste Teilsubstrat 10 ist zum Aufnehmen von Kugelelementen vorgesehen, wobei die Vertiefungen 12 quadratisch bzw. rechteckig oder kreisrund ausgebildet sein können.

Wie in Fig. 9 bei Schritt 204 dargestellt ist, können nun eine Vielzahl von Kugelelementen 14 aus einem Halbleitermaterial mit einem Durchmesser D bereitgestellt werden, wobei dann jeweils ein Kugelelement 14 in eine der Vertiefungen 12 des ersten Teilsubstrats 10 eingebracht wird, so dass sich jeweils ein Kugelelement 14 in einer Vertiefung 12 des ersten Teilsubstrats befindet. Dieser Vorgang wird auch als "Balling" bezeichnet.

Die Vertiefungen 12 in dem ersten Teilsubstrat 10 können mittels herkömmlicher Halbleiterbearbeitungstechniken, wie z.B. Ätzverfahren, mit einer hohen Genauigkeit gebildet werden, so dass eine exakte Passform zwischen dem jeweiligen Kugelelement 14 und den Boden- bzw. Seitenwänden der Vertiefungen 12 erreicht werden kann. Bei Schritt 206 sind nun die Kugelelemente 14 in den Vertiefungen 12 des ersten Teilsubstrats 10 angeordnet.

Bei Schritt 270 wird nun z.B. ein Polymermaterial auf das erste, mit den Kugelelementen 14 versehene Teilsubstrat 10 aufgebracht, so dass die Kugelelemente 14 nach einer Verfestigung des Polymermaterials zwischen dem verfestigten Polymermaterial 80 und dem ersten Teilsubstrat 10 eingebettet sind. Damit bilden das erste Teilsubstrat 10 und das verfestigte Polymermaterial 70 (bzw. Polymervergussmaterial oder Polymervergussmasse) das Trägersubstrat mit den daran fixierten Kugelelementen 14.

Bei Schritt 272 wird nun das Trägersubstrat, das das erste Teilsubstrat 10 und das Polymermaterial 80 aufweist, ein- oder beidseitig mechanisch gedünnt, wobei der Schritt des Dünnens der an dem Trägersubstrat fixierten Kugelelemente ausgehend von dem freiliegenden Hauptoberflächenbereich des ersten Teilsubstrats 10 erfolgt. Ferner kann das Trägersubstrat ausgehend von dem freiliegenden Hauptoberflächenbereich des Polymermaterials gedünnt werden, um die gewünschte Zieldicke des resultierenden Trägersubstrats mit den darin eingebetteten Linsenelementen 24 zu erhalten. Dabei ist die ebene Seite 24a der Linsenelemente 24 bündig mit der Rückseite (zweiten Hauptoberfläche) des Trägersubstrats, wobei sich jeweils die konvexe Seite 24b der Linsenelemente 24 in dem Polymermaterial befindet. Bei Schritt 272 wird also das Material des ersten Teilsubstrats, die Halbleiterkugelelemente (Siliziumkugeln) und das umgebende Polymermaterial auf die gewünschte Zieldicke abgeschliffen und poliert.

Bei Schritt 274 wird ein weiteres (drittes) Teilsubstrat 82 aus einem Halbleitermaterial mit dem Trägersubstrat an dessen zweiten Hauptoberflächenbereich verbunden bzw. auf dasselbe aufgebondet. Dies wird beispielsweise durch ein stoffschlüssiges Fügen des mit den Linsenelementen 24 versehenen Trägersubstrats auf das dritte Teilsubstrat, z.B. ein Siliziumsubstrat, erhalten. Eine direkte Silizium-Silizium-Verbindung wird beispielsweise durch ein direktes Waferbonding oder Fusion-Waferbonding erhalten.

Bei Schritt 276 wird das Polymermaterial 80 des Trägersubstrats ausgehend von dem freiliegenden (ersten) Hauptoberflächenbereich desselben zumindest teilweise entfernt, um die konvexseitige Oberfläche 24b der Linsenelemente 24 zumindest teilweise freizulegen, d.h. zumindest die optisch wirksamen Bereiche der konvexseitigen Oberfläche der Linsenelemente 24 freizulegen.

Das Entfernen des Polymermaterials kann beispielsweise durch ein Lösen der Polymermasse erfolgen. Alternativ kann ein Sauerstoffplasma oder ein thermischer Abtrag durch einen O₂-Ätzprozess (O₂-Etch) durchgeführt werden, bis die konvexseitige Oberfläche 24b der Linsenelemente (Siliziumlinsen) freiliegen bzw. freigelegt sind.

Ferner kann das Polymermaterial auch vollständig abgetragen werden, um die konvexseitige Oberfläche 24b der Linsenelemente vollständig freizulegen. Dies ist in dem optionalen Schritt 278 dargestellt.

Bei Schritt 280 werden beispielsweise einseitig offene Kavitäten 26 ausgehend von dem äußeren, freiliegenden Oberflächenbereich des dritten Teilsubstrats zu den Linsenelementen 24 erzeugt, so dass der an die jeweilige Kavität 26 angrenzende (optisch wirksame) Bereich der planen Seite 24a der Linsenelemente 24 freiliegend bzw. freigelegt ist. Die Kavitäten 26 können beispielsweise mittels eines Ätzvorgangs in das Halbleitermaterial (z.B. Silizium) des dritten Teilsubstrats gebildet werden.

Im Folgenden werden nochmals einige Aspekte des erfindungsgemäßen Herstellungsverfahrens zusammengefasst dargestellt.

Entsprechend dem erfindungsgemäßen Konzept werden also die Linsenelemente mit der jeweiligen erforderlichen Brennweite nicht mehr direkt hergestellt, sondern es werden Halbleiterkugeln (z.B. Siliziumkugeln), die exakt den erforderlichen Radius aufweisen, in ein starres Trägermaterial eingebettet, so dass ein komplettes Substrat bzw. ein kompletter Wafer mit Halbleiterkugeln erhalten wird. Anschließend werden diese an dem Substrat fixierten Halbleiterkugeln (einseitig) abgeschliffen (Grinding) und poliert, so dass ein Substrat im Waferformat entsteht, dass die gewünschten plankonvexen Linsen bzw. Kugelkappen aus eine Halbleitermaterial, z.B. Silizium, beinhaltet. Dieser Wafer kann anschließend weiter prozessiert werden und entsprechend den oben im Detail dargestellten Herstellungsverfahren entweder auf einen weiteren Silizium-Wafer gefügt (gebondet, Prozess 100-7) oder direkt mit Kavitäten versehen werden, so dass dieser Wafer direkt für die hermetisch dichte Verkappung von IR-Sensoren genutzt werden kann (Prozesse 100, 100-1, ..., 100-8).

Da das Verkapseln der IR-Sensoren noch auf Waferebene erfolgen soll, und die Fügeprozesse alle mit einer erhöhten Prozesstemperatur verbunden sind, sollte der thermische Ausdehnungskoeffizient (CTE - coefficient of thermal expansion) des Substrats mit den Linsen an dem von Silizium angepasst sein. Andernfalls können nach dem Fügen und dem Abkühlen sehr große mechanische Spannungen auftreten, die zu einer Beschädigung (zumindest) der Fügezonen oder sogar zu einer Beschädigung bzw. Zerstörung des Bauelements führen können. Da das Substrat aber auch die hermetische Dichtigkeit der Kavitäten der IR-Sensoren sicherstellen sollte, kommen als Material für das Substrat im Endeffekt i.W. Silizium selbst oder Gläser mit angepasstem CTE (Pyrex, Borofloat, AF32, Eagle XG, Hoya SD 2, etc.) in Frage. Daher kommt für die Prozesse als Material und Substratmaterial i.W. lediglich ein Glas in Frage.

Auch bei dem Prozess 100-7 wird nach dem Aufbonden des Substrats das Trägermaterial zumindest größten Teils entfernt (auch ein vollständiges Entfernen ist möglich, wenn die plane Seite der plankonvexen Linsen direkt mit dem darunterliegenden Siliziumsubstrat verbunden ist), um den eigentlichen Linsenbereich freizulegen. Anschließend werden auch hier Kavitäten rückseitig eingebracht, die im späteren Herstellungsvorgang die IR-Sensoren einschließen und versiegeln. In dieser Technologie kann als Trägermaterial ebenfalls Glas genutzt werden (Prozess 100-7), allerdings ist es hier zumindest grundsätzlich auch möglich, andere, gerade auch Polymere, als Werkstoff (Prozess 100-8) zu verwenden, unter den Voraussetzungen, dass sich der Werkstoff für ein Abschleifen und Polieren der Oberflächen eignet. Beispielsweise ist von Polyimid bekannt, dass ein Planarisieren und Polieren möglich ist. Hierzu wäre eine weitere Prozessvariante 100-8 aber besonders geeignet, da hier auch Materialien eingesetzt werden können, die nicht unter Temperatur viskos fließen, sondern z.B. erst durch eine thermische Nachbehandlung abbinden bzw. reagieren.

Anschließend können unabhängig davon, um welche Varianten es sich handelt, die Linsenoberflächen mit einer Entspiegelung (ARC: Anti Reflective Coating) versehen werden, z.B. durch Aufdampfen geeigneter Schichten mit angepassten Schichtdicken und Brechungsindizes.

Abschließend können je nach genauer Ausgestaltung des Fügeprozesses (Waferbonden) um die Kavitäten umlaufende Fügematerialien aufgebracht und strukturiert werden. Im einfachsten Fall könnten dies Glaslote sein, die aufgedruckt und umgeschmolzen werden oder es handelt sich um metallische Lote, wie Gold-Zinn. Im letzteren Fall sollte allerdings der Fügerahmen um die eigentlichen Kavitäten mit einer geeigneten lötfähigen Metallisierung versehen werden.

Fig. 10 zeigt ein beispielhaftes prinzipielles Ablaufdiagramm eines Verfahrens 600 zur Herstellung eines gehäusten Bauelements auf Waferebene. Das Verfahren 600 zur Herstellung eines gehäusten Bauelements auf Waferebene führt zunächst den Schritt 610 des Herstellens eines mit plankonvexen Linsenelementen versehenen Trägersubstrats (Linsenwafer) durch, bei dem ein Halbleitermaterial aufweisende Kugelelemente 14 an einem Trägersubstrat 22 fixiert werden, wobei die an dem Trägersubstrat 22 fixierten Kugelelemente 14 einseitig gedünnt werden, um die plankonvexen Linsenelemente 24 aus einem Halbleitermaterial bzw. die ein Halbleitermaterial aufweisenden plankonvexen Linsenelemente 24 zu bilden. Dieser Prozess wurde als Verfahren 100, 100-1 ... 100-8 anhand der Fig. 1 bis 9 im vorhergehenden detailliert beschrieben.

Anschließend wird bei Schritt 620 ein Bauelementesubstrat (z.B. Sensorwafer), das eine Vielzahl von Bauelementen, wie z. B. IR-Sensorelementen (IR-strahlungsempfindliche Bauelemente, IR = Infrarot) aufweist, bereitgestellt. Daraufhin werden bei einem Schritt 630 die Substrate (Bauelementesubstrat und Trägersubstrat) aneinander angeordnet, z.B. mit einem Vakuum-Bond-Prozess, so dass die an dem Trägersubstrat angeordneten Linsenelemente mit den zugeordneten Bauelementen (z.B. IR-Sensorelementen) des Bauelementesubstrats (Sensorwafers) ausgerichtet sind. Das Trägersubstrat mit den daran angeordneten Linsenelementen und das Bauelementesubstrat können also unter Verwendung von Loten oder Glasloten hermetisch dicht gefügt werden. Das Anordnen (Verbinden bzw. Bonden) der Substrate kann unter Vakuum erfolgen. Als Vakuum kann ein Grobvakuum mit 300...1 hPa (mbar), ein Feinvakuum mit 1...10⁻³ hPa, ein Hochvakuum (HV) mit 10⁻³... 10⁻⁷ hPa, ein Ultrahochvakuum (UHV) mit 10⁻⁷... 10⁻¹² hPa, oder ein extrem hohes Vakuum (XHV) < 10⁻¹² hPa eingesetzt werden.

Der gefertigte Linsenwafer kann beispielsweise mit einem Lotrahmen versehen werden, z. B. mit einem Glaslot oder einem metallischen Lot, und mit dem eigentlichen Sensorwafer hermetisch dicht unter Vakuum verbunden (Vakuum-gebondet) werden. Die Kavität, die zur Aufnahme der Siliziumlinse dient, bildet zugleich den evakuierten Bereich oberhalb des IR-Sensors. Durch das Vakuum gewinnt der IR-Sensor (z. B. ein Bolometer oder Thermopile) deutlich an Empfindlichkeit, da die Wärmeleitung über Luft entfällt.

Schließlich werden bei einem Schritt 640 das Trägersubstrat mit dem daran angeordneten Bauelementesubstrat vereinzelt (Dicing), um vereinzelte, mit jeweils einem Linsenelement versehene Bauelemente zu erhalten.

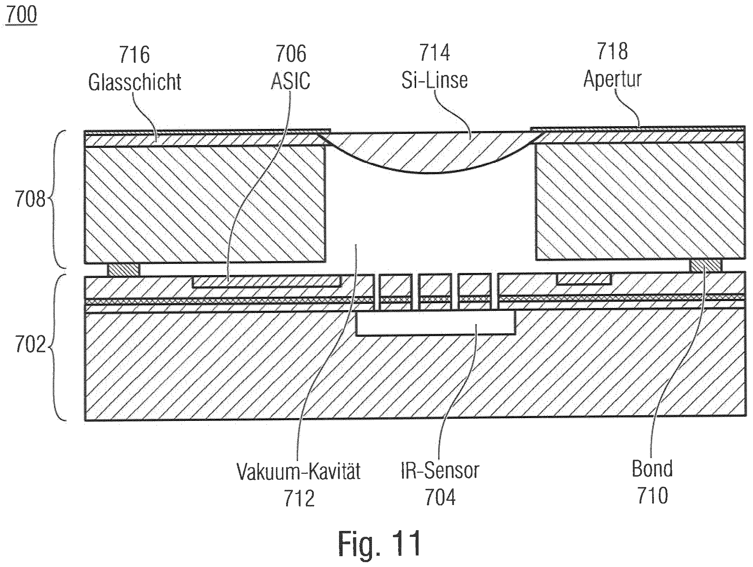

Fig. 11 zeigt nun eine beispielhafte Ausführungsform für ein gehäustes strahlungsempfindliches Bauelement 700 gemäß einem Ausführungsbeispiel, das beispielsweise mit dem hier beschriebenen Verfahren 100, 100-1 ... 100-8 hergestellt ist.

Wie in Fig. 11 dargestellt ist, umfasst das strahlungsempfindliche Bauelement (IR-Sensor) 700 einen in dem Bauelementesubstrat 702 angeordneten IR-Sensor 704 und einen ASIC 706. Zwischen dem Bauelementesubstrat 702 und einem Trägersubstrat 708 (vgl. Trägersubstrate 30, 40, 56, 70) ist ein Bondrahmen (Lotrahmen) 710 angeordnet. Zwischen dem Bauelementesubstrat 702 und einem Trägersubstrat 708 ist ferner eine Vakuum-Kavität 712 (vgl. Kavität 26) ausgebildet. Ferner sind an dem Trägersubstrat 708 eine Halbleiterlinse 714 (Si-Linse, vgl. Halbleiterlinse 24), eine Glasschicht 716 (vgl. Glasschicht 44, 54, 76) und eine Apertur 718 angeordnet.

Die Linsenform (z. B. der Linsenradius) der Halbleiterlinse 714 ist nun so gewählt, dass die Brennweite bzw. der Fokus der Linse 714 am Boden der Vakuum-Kammer 712, d. h. an dem IR-Sensorelement 704, liegt. Die nach innen gerichtete Halbleiterlinse 714 liefert durch die Kombination mit dem Glasmaterial der Glasschicht 716 (Glasmembran) eine hermetische Abdichtung des Vakuum-Hohlraums 712 gegenüber der Umgebung.

Gemäß der in den Fig. 1-10 dargestellten Vorgehensweise zur Herstellung des Linsenwafers bzw. eines gehäusten Bauelements wird sichergestellt, dass die Halbleiterlinse 714 oberhalb der Vakuumkavität 712 (i.W. immer) von der Glasschicht 714 (z. B. ringförmig oder kranzförmig) umgeben ist und somit eine Art "Fassung" (Einfassung) für die Halbleiterlinse 714 bildet und (zusammen mit dem Bondmaterial 710) die hermetische Abdichtung der Vakuumkapazität 712 eine hermetische Abdichtung des Vakuum-Hohlraums 712 gegenüber der Umgebung unterstützt bzw. ermöglicht.

Die in den Fig. 1-10 dargestellte Vorgehensweise zur Herstellung des Linsenwafers bzw. eines gehäusten Bauelements erfordert lediglich eine einzige Lithographie-Ebene (einen Durchätzprozess), wobei die restlichen Herstellungsschritte (alle) selbstjustierend sind, und somit einfach und günstig zu realisieren sind. Ferner ermöglicht die dargestellte Vorgehensweise eine hohe Reproduzierbarkeit der optischen Eigenschaften der Sensorelemente, d. h. beispielsweise der Brennweite, wobei das Herstellungsverfahren darüber hinaus kostengünstig realisierbar ist, da für das vorliegende Verfahren einsetzbare Halbleiterkugeln relativ kostengünstig verfügbar sind. Durch die beschriebene Vorgehensweise wird eine im Wesentlichen plane Außenseite des gehäusten Bauelements erhalten, während die konvexe Seite der Linse an der Innenseite zur Kavität gerichtet angeordnet ist.

Neben IR-Detektoren können entsprechend hergestellte gehäuste Bauelemente auch zur Realisierung von Infrarot-Kameras eingesetzt werden.

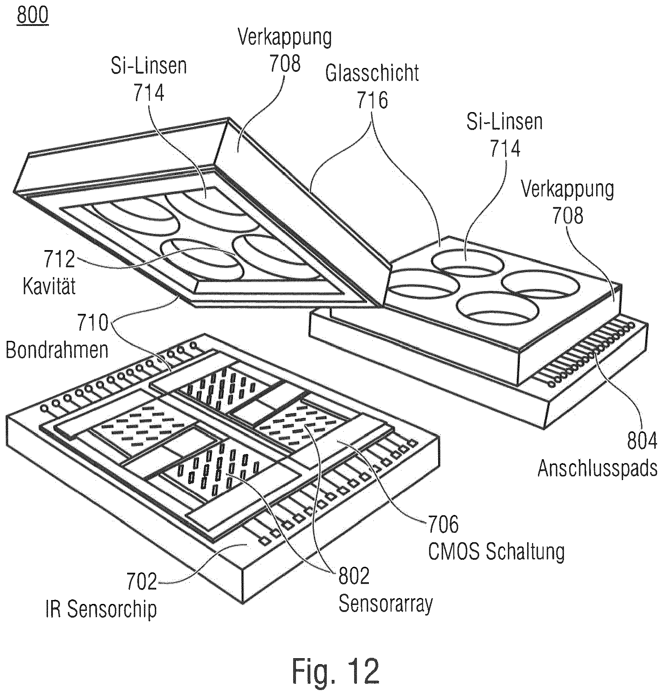

Fig. 12 zeigt eine beispielhafte Ausführungsform für ein gehäustes strahlungsempfindliches Bauelement (IR-Sensor) 800 mit mehreren strahlungsempfindlichen Bauelementen 700 und zugeordneten Linsenelementen 714 (Arrays) in demselben Gehäuse 802. In der Sensorarrayanordnung von Fig. 12 werden (soweit anwendbar) die Bezugszeichen aus Fig. 11 verwendet.

Wie in Fig. 12 in einer geöffneten Ansicht (links) und einer geschlossenen Ansicht (rechts) dargestellt ist, umfasst das strahlungsempfindliche Bauelement (IR-Sensor) 800 eine Mehrzahl (ein Array 802) von in dem Bauelementesubstrat 702 angeordneten IR-Sensoren 704 und CMOS-Schaltungen (ASICs) 706 mit zugeordneten Anschlusspads 804. Zwischen dem Bauelementesubstrat 702 (Sensorchip) und einem Trägersubstrat 708 (Verkappung; vgl. Trägersubstrate 30, 40, 56, 70) ist ein Bondrahmen (Lotrahmen) 710 angeordnet. Zwischen dem Bauelementesubstrat 702 und einem Trägersubstrat 708 ist ferner eine Vakuum-Kavität 712 (vgl. Kavität 26) ausgebildet. Ferner ist an dem Trägersubstrat 708 ein Array von Halbleiterlinsen 714 (Si-Linse, vgl. Halbleiterlinse 24) und eine Glasschicht 716 (vgl. Glasschicht 44, 54, 76) angeordnet.

Wie in Fig. 12 dargestellt ist, enthält der eigentliche IR-Sensorchip 702 neben den IR-Sensorelementen 704 die in einem Array 802 angeordnet sind, die Auswerteschaltkreise 706 und die für das Verkappen erforderliche Rahmenstruktur 710, z.B. AIGe-Bondrahmen. In die Verkappung 708 sind die Siliziumlinsen 714 in eine Vertiefung eingelassen, die während des Waferbondens evakuiert wird. Diese Kavität 712 wird ebenfalls von einer lötfähigen Rahmenstruktur 710 umschlossen. Die Siliziumlinsen 714 selbst sind an der Oberfläche des Verkappungschips 708 in eine Glasschicht 716 eingebettet. Der gesamte Aufbau kann noch auf Waferebene realisiert werden. Erst am Schluss des Herstellungsprozesses werden die Wafer 702, 708 vereinzelt.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software oder zumindest teilweise in Hardware oder zumindest teilweise in Software implementiert sein. Die Implementierung kann unter Verwendung eines digitalen Speichermediums, beispielsweise einer Floppy-Disk, einer DVD, einer BluRay Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Verfahren (100, 100-1, ..., 100-7) zum Herstellen von plankonvexen Linsenelementen (24) für strahlungsempfindliche Bauelemente, mit folgenden Schritten:
Bereitstellen (202) eines mit Vertiefungen (12) versehenen, ersten Teilsubstrats (10) mit daran angeordneten Kugelelementen (14);
Bereitstellen (230) eines zweiten Teilsubstrats (30; 40; 41; 56; 60; 70; 71), das eine Glasmaterialschicht (30; 44; 54; 76) aufweist;
Anordnen (236; 244; 262) des zweiten Teilsubstrats (30; 40; 41; 56; 60; 70; 71) auf dem ersten, mit den Kugelelementen (14) versehenen Teilsubstrat (10);
Fixieren (238, 246, 264) mittels Tempern und Ausübens von mechanischem Druck der Kugelelemente (14) an der Glasmaterialschicht (30; 44; 54) des zweiten Teilsubstrats; und
einseitiges Dünnen (300) der an der Glasmaterialschicht (30; 44; 54; 76) des zweiten Teilsubstrats (30; 40; 41; 56; 60; 70; 71) fixierten Kugelelemente (14), um die plankonvexen Linsenelemente (24) zu erhalten.

2. Verfahren nach Anspruch 1, wobei die Kugelelemente (14) ein Halbleitermaterial aufweisen und der konvexseitige Krümmungsradius R der Linsenelemente (24) dem Kugelradius R der Kugelelemente (14) entspricht

3. Verfahren nach Anspruch 1 oder 2, ferner mit folgendem Schritt:
Fixieren (630) der strahlungsempfindlichen Bauelemente an dem mit den Linsenelementen (24) versehenen, zweiten Teilsubstrat (30; 40; 41; 56; 60; 70), um mit jeweils zumindest einem Linsenelement (24) versehene, strahlungsempfindliche Bauelemente zu erhalten.

4. Verfahren nach Anspruch 3, ferner mit folgendem Schritt:
Vereinzeln (640) des zweiten Teilsubstrats (30; 40; 41; 56; 60; 70) mit den daran angeordneten Linsenelementen (24) und den strahlungsempfindlichen Bauelementen, um vereinzelte, mit jeweils zumindest einem Linsenelement (24) versehene, strahlungsempfindliche Bauelemente zu erhalten.

5. Verfahren (100-3b) nach einem der Ansprüche 1 bis 4, das ferner folgende Schritte aufweist:
Bereitstellen (202) des mit Vertiefungen (12) versehenen, ersten Teilsubstrats (10), wobei die Kugelelemente (14) in den Vertiefungen (12) des ersten Teilsubstrats (10) angeordnet sind;
Bereitstellen eines zweiten Teilsubstrats (41), wobei das zweite Teilsubstrat Ausnehmungen (49) und die Glasmaterialschicht (44) aufweist, wobei an einem ersten Hauptoberflächenbereich des zweiten Teilsubstrats die Glasmaterialschicht (44) angeordnet ist, wobei die Glasmaterialschicht (44) Öffnungen (46) aufweist, die mit den Ausnehmungen (49) des zweiten Teilsubstrats (41) ausgerichtet sind, und wobei die Öffnungen (46) der Glasmaterialschicht (44) einen kleineren Durchmesser als die Ausnehmungen (49) des zweiten Teilsubstrats (41) aufweisen;
Anordnen des zweiten Teilsubstrats (41) auf dem ersten, mit den Kugelelementen (14) versehenen Teilsubstrat (10), wobei der mit der Glasmaterialschicht (44) versehene erste Hauptoberflächenbereich des zweiten Teilsubstrats (41) den Kugelelementen (14) zugewandt ist, und wobei die Kugelelemente (14) mit den Ausnehmungen (49) ausgerichtet sind; und
Fixieren mittels Tempern und Ausüben von mechanischem Druck des mit der Glasmaterialschicht (44) versehenen zweiten Teilsubstrats (41) an den Kugelelementen (14); und
Entfernen des ersten Teilsubstrats (10) von den fest mit dem zweiten Teilsubstrat (41) verbundenen Kugelelementen (14).

6. Verfahren (100-2) nach einem der Ansprüche 1 bis 4, das ferner folgende Schritte aufweist:
Bereitstellen (202, 204, 206) des mit Vertiefungen (12) versehenen, ersten Teilsubstrats (10), wobei die Kugelelemente (14) in den Vertiefungen (12) des ersten Teilsubstrats (10) angeordnet sind;
Bereitstellen eines die Glasmaterialschicht aufweisenden, zweiten Teilsubstrats (30), wobei das zweite Teilsubstrat (30) Vertiefungen (32) aufweist;
Anordnen (222) des zweiten Teilsubstrats (30) auf dem ersten, mit den Kugelelementen (14) versehenen Teilsubstrat (10), wobei die Vertiefungen (32) in dem zweiten Teilsubstrat (30) mit den Kugelelementen (14) ausgerichtet sind;
Fixieren mittels Tempern und Ausübens von mechanischem Druck des zweiten Teilsubstrats (30) an den in den Vertiefungen (12) des ersten Teilsubstrats (10) angeordneten Kugelelementen (14), um die Kugelelemente (14) an den Vertiefungen (32) des zweiten Teilsubstrats (30) zu fixieren; und
Entfernen des ersten Teilsubstrats (10) von den fest mit dem zweiten Teilsubstrat (30) verbundenen Kugelelementen (14).

7. Verfahren (100-3a) nach einem der Ansprüche 1 bis 4, das ferner folgende Schritte aufweist:
Bereitstellen (202) des mit Vertiefungen (12) versehenen, ersten Teilsubstrats (10), wobei die Kugelelemente (14) in den Vertiefungen (12) des ersten Teilsubstrats (10) angeordnet sind;
Bereitstellen eines zweiten Teilsubstrats (40), wobei das zweite Teilsubstrat Durchgangsöffnungen (48) und die Glasmaterialschicht (44) aufweist, wobei an einem ersten Hauptoberflächenbereich des zweiten Teilsubstrats die Glasmaterialschicht (44) angeordnet ist, wobei die Glasmaterialschicht (44) Öffnungen (46) aufweist, die mit den Durchgangsöffnungen (48) des zweiten Teilsubstrats (40) ausgerichtet sind, und wobei die Öffnungen (46) der Glasmaterialschicht (44) einen kleineren Durchmesser als die Durchgangsöffnungen (48) des zweiten Teilsubstrats (40) aufweisen;
Anordnen des zweiten Teilsubstrats (40) auf dem ersten, mit den Kugelelementen (14) versehenen Teilsubstrat (10), wobei der mit der Glasmaterialschicht (44) versehene erste Hauptoberflächenbereich des zweiten Teilsubstrats (40) den Kugelelementen (14) zugewandt ist, und wobei die Kugelelemente (14) mit den Durchgangsöffnungen (48) ausgerichtet sind; und
Fixieren mittels Tempern und Ausüben von mechanischem Druck des mit der Glasmaterialschicht (44) versehenen zweiten Teilsubstrats (40) an den Kugelelementen (14); und
Entfernen des ersten Teilsubstrats (10) von den fest mit dem zweiten Teilsubstrat (40) verbundenen Kugelelementen (14).

8. Verfahren (110-4) nach einem der Ansprüche 1 bis 4, wobei der Schritt (200) des Fixierens folgende Schritte aufweist:
Bereitstellen (202, 204, 206) des mit Vertiefungen (12) versehenen, ersten Teilsubstrats (10), wobei die Kugelelemente (14) in den Vertiefungen (12) des ersten Teilsubstrats (10) angeordnet sind;
Bereitstellen (242) eines zweiten Teilsubstrats (56), wobei das zweite Teilsubstrat (56) Ausnehmungen (52) und die Glasmaterialschicht (54) aufweist, wobei die Glasmaterialschicht (54) an dem mit den Ausnehmungen (52) versehenen ersten Hauptoberflächenbereich des zweiten Teilsubstrats (56) angeordnet ist, und wobei die Glasmaterialschicht (54) die Ausnehmungen (52) überspannt;
Anordnen des zweiten Teilsubstrats (56) auf dem ersten, mit den Kugelelementen (14) versehenen Teilsubstrat (10), wobei der mit der Glasmaterialschicht (54) versehene erste Hauptoberflächenbereich des zweiten Teilsubstrats (56) den Kugelelementen (14) zugewandt ist, und wobei die Kugelelemente (14) mit den Ausnehmungen (52) ausgerichtet sind;
Fixieren mittels Tempern und Ausüben von mechanischem Druck des mit der Glasmaterialschicht (54) versehenen zweiten Teilsubstrats (56) an den Kugelelementen (14); und
Entfernen des ersten Teilsubstrats (10) von den fest mit dem zweiten Teilsubstrat (56) verbundenen Kugelelementen (14).

9. Verfahren (100-5) nach einem der Ansprüche 1 bis 4, wobei der Schritt (200) des Fixierens folgende Schritte aufweist:
Bereitstellen (202, 204, 206) des mit Vertiefungen (12) versehenen, ersten Teilsubstrats (10), wobei die Kugelelemente (14) in den Vertiefungen (12) des ersten Teilsubstrats (10) angeordnet sind;
Bereitstellen eines zweiten Teilsubstrats (60), wobei eine Glasmaterialschicht (64) an einem ersten Hauptoberflächenbereich des zweiten Teilsubstrats (60) angeordnet ist;
Anordnen des zweiten Teilsubstrats (60) auf dem ersten, mit den Kugelelementen (14) versehenen Teilsubstrat (10), wobei der mit der Glasmaterialschicht (62) versehene erste Hauptoberflächenbereich des zweiten Teilsubstrats (60) den Kugelelementen (14) zugewandt ist;
Fixieren mittels Tempern und unter Ausüben von mechanischem Druck des mit der Glasmaterialschicht (64) versehenen zweiten Teilsubstrats (60) an den Kugelelementen (14);
Entfernen des ersten Teilsubstrats (10) von den fest mit dem zweiten Teilsubstrat (60) verbundenen Kugelelementen (14).

10. Verfahren (100-6a) nach einem der Ansprüche 1 bis 4, wobei der Schritt (200) des Fixierens folgende Schritte aufweist:
Bereitstellen (202) des mit Vertiefungen (12) versehenen, ersten Teilsubstrats (10), wobei die Kugelelemente (14) in den Vertiefungen (12) des ersten Teilsubstrats (10) angeordnet sind;
Bereitstellen eines zweiten Teilsubstrats (70), wobei das zweite Teilsubstrat Durchgangsöffnungen und eine Glasmaterialschicht aufweist, wobei die Glasmaterialschicht (76) die Durchgangsöffnungen (74) überspannt;
Anordnen des zweiten Teilsubstrats (70) auf dem ersten, mit den Kugelelementen (14) versehenen Teilsubstrat (10), wobei der mit der Glasmaterialschicht (76) versehene erste Hauptoberflächenbereich des zweiten Teilsubstrats (70) den Kugelelementen (14) zugewandt ist, und wobei die Kugelelemente (14) mit den Durchgangsöffnungen (74) ausgerichtet sind;
Fixieren mittels Tempern und Ausüben von mechanischem Druck des mit der Glasmaterialschicht (76) versehenen zweiten Teilsubstrats (70) an den Kugelelementen (14); und
Entfernen des ersten Teilsubstrats (10) von den fest mit dem zweiten Teilsubstrat (70) verbundenen Kugelelementen (14).

11. Verfahren (100-6b) nach einem der Ansprüche 1 bis 4, wobei der Schritt (200) des Fixierens folgende Schritte aufweist:
Bereitstellen (202, 204, 206) des mit Vertiefungen (12) versehenen, ersten Teilsubstrats (10), wobei ein Teilsatz der Kugelelemente (14) in den Vertiefungen (12) des Teilsubstrats (10) angeordnet sind;
Bereitstellen (260-1) eines zweiten Teilsubstrats (70), wobei das zweite Teilsubstrat Durchgangsöffnungen (74) und die Glasmaterialschicht (76) aufweist, wobei die Glasmaterialschicht (76) die Durchgangsöffnungen (74) überspannt;
Anordnen (262-1) des zweiten Teilsubstrats (70) auf dem mit den Kugelelementen (14) versehenen ersten Teilsubstrat (10), wobei der mit der Glasmaterialschicht (76) versehene erste Hauptoberflächenbereich des zweiten Teilsubstrats (70) den Kugelelementen (14) zugewandt ist, und wobei die Kugelelemente (14) mit einem Teilsatz der Durchgangsöffnungen (74) ausgerichtet sind;
Fixieren (264-1) mittels Tempern und Ausüben von mechanischem Druck des mit der Glasmaterialschicht (76) versehenen zweiten Teilsubstrats (70) an den Kugelelementen (14);
Entfernen (266-1) des ersten Teilsubstrats (10) von den fest mit dem zweiten Teilsubstrat (70) verbundenen Kugelelementen (14);
Durchführen (300-1) des Schritts des Dünnens (300) der an dem zweiten Teilsubstrat (70) fixierten Kugelelemente (14), um plankonvexe Linsenelemente (24) zu erhalten;
Bereitstellen des mit Vertiefungen (12) versehenen, weiteren Teilsubstrats (10), wobei ein weiterer Teilsatz der Kugelelemente (14) in den Vertiefungen (12) des Teilsubstrats (10) angeordnet sind;
Anordnen (262-2) des zweiten Teilsubstrats (70) auf dem mit dem weiteren Teilsatz von Kugelelementen (14) versehenen, weiteren Teilsubstrat (10), wobei der mit der Glasmaterialschicht (76) versehene erste Hauptoberflächenbereich des zweiten Teilsubstrats (70) den Kugelelementen (14) zugewandt ist, und wobei die Kugelelemente (14) mit einem weiteren Teilsatz der Durchgangsöffnungen (74) ausgerichtet sind;
Fixieren (264-2) mittels Tempern und Ausüben von mechanischem Druck des mit der Glasmaterialschicht (76) versehenen zweiten Teilsubstrats (70) an dem weiteren Teilsatz von Kugelelementen (14);
Entfernen (266-2) des weiteren Teilsubstrats (10) von den fest mit dem zweiten Teilsubstrat (70) verbundenen Kugelelementen (14);
Durchführen des Schritts des Dünnens (300-2) des an dem zweiten Teilsubstrat (70) fixierten, weiteren Teilsatzes von Kugelelementen (14), um die plankonvexen Linsenelemente (24) zu erhalten.

12. Verfahren (100-6c) nach einem der Ansprüche 1 bis 4, wobei der Schritt (200) des Fixierens folgende Schritte aufweist:
Bereitstellen (202) des mit Vertiefungen (12) versehenen, ersten Teilsubstrats (10), wobei die Kugelelemente (14) in den Vertiefungen (12) des ersten Teilsubstrats (10) angeordnet sind;
Bereitstellen eines zweiten Teilsubstrats (71), wobei das zweite Teilsubstrat (71) ausgehend von dem ersten Hauptoberflächenbereich Ausnehmungen (73) und ferner eine Glasmaterialschicht (76) aufweist, wobei die Glasmaterialschicht (76) die Ausnehmungen (76) überspannt;
Anordnen des zweiten Teilsubstrats (70) auf dem ersten, mit den Kugelelementen (14) versehenen Teilsubstrat (10), wobei der mit der Glasmaterialschicht (76) versehene erste Hauptoberflächenbereich des zweiten Teilsubstrats (71) den Kugelelementen (14) zugewandt ist, und wobei die Kugelelemente (14) mit den Ausnehmungen (74) ausgerichtet sind;
Fixieren mittels Tempern und Ausübens von mechanischem Druck des mit der Glasmaterialschicht (76) versehenen zweiten Teilsubstrats (71) an den Kugelelementen (14); und
Entfernen des ersten Teilsubstrats (10) von den an dem zweiten Teilsubstrat (70) fixierten Kugelelementen (14).

13. Verfahren (100-7) nach einem der Ansprüche 1 bis 4, wobei der Schritt (200) des Fixierens folgende Schritte aufweist:
Bereitstellen (202) des mit Vertiefungen (12) versehenen, ersten Teilsubstrats (10);
Anordnen (204) der Kugelelemente (14) in den Vertiefungen (12) des ersten Teilsubstrats (10);
Anordnen eines zweiten Teilsubstrats (18) auf dem ersten, mit den Kugelelementen (14) versehenen Teilsubstrat (10), wobei das zweite Teilsubstrat (18) ein Glasmaterial aufweist, wobei das erste und das zweite Teilsubstrat (10, 18) zumindest in einem Randbereich aneinander fixiert werden; und
Tempern der beiden Teilsubstrate derart, dass ein teilweises Umfließen der Kugelelemente (14) mit dem Glasmaterial des zweiten Teilsubstrats (18) bewirkt wird, so dass die Kugelelemente nach einer Wiederverfestigung des Glasmaterials des zweiten Teilsubstrats (18) zwischen dem ersten Teilsubstrat (10) und dem verfestigten Glasmaterial des zweiten Teilsubstrats (18) eingebettet sind, wobei das erste Teilsubstrat (10) und das verfestigte Glasmaterial des zweiten Teilsubstrats (18) ein Trägersubstrat bilden.

14. Herstellungsverfahren (100-8), mit folgenden Schritten:
Bereitstellen (202) eines mit Vertiefungen (12) versehenen ersten Teilsubstrats (10);
Anordnen von Kugelelementen (14) in den Vertiefungen (12) des ersten Teilsubstrats (10);
Anordnen (270) eines Polymermaterials (80) auf dem ersten, mit den Kugelelementen versehenen Teilsubstrat (10), so dass nach einer Verfestigung des Polymermaterials (80) die Kugelelemente (14) zwischen dem verfestigten Polymermaterial (80) und dem ersten Teilsubstrat (10) eingebettet sind, wobei das erste Teilsubstrat (10) und das verfestigte Polymermaterial (80) ein Trägersubstrat bilden;
mechanisches Dünnen des Trägersubstrats, wobei der Schritt (300) des Dünnens der an dem Trägersubstrat fixierten Kugelelemente (14) ausgehend von dem freiliegenden Hauptoberflächenbereich des ersten Teilsubstrats (10) erfolgt, um die plankonvexen Linsenelemente (24) zu erhalten.

15. Verfahren (600) zur Herstellung eines gehäusten Bauelements auf Waferebene, mit folgenden Schritten:
Herstellen (610) eines mit plankonvexen Linsenelementen versehenen Trägersubstrats gemäß dem Verfahren nach einem der Ansprüche 1 bis 14;
Bereitstellen (620) eines Bauelementesubstrats mit einer Vielzahl von Bauelementen;
Anordnen (630) der Substrate aneinander, so dass die an dem Trägersubstrat angeordneten Linsenelemente mit den zugeordneten Bauelementen des Bauelementesubstrats ausgerichtet sind, wobei das Trägersubstrat und das Bauelementesubstrat hermetisch dicht gefügt werden; und
Vereinzeln (640) des Trägersubstrats mit dem daran angeordneten Bauelementesubstrat, um vereinzelte, mit jeweils zumindest einem Linsenelement versehene Bauelemente zu erhalten.

## Claims

1. Method (100, 100-1, ..., 100-7) for producing plano-convex lens elements (24) for radiation-sensitive devices, comprising:
providing (202) a first partial substrate (10), provided with depressions (12), with ball elements (14) arranged thereon;
providing (230) a second partial substrate (30; 40; 41; 56; 60; 70; 71) comprising a glass material layer (30; 44; 54; 76);
arranging (236; 244; 262) the second partial substrate (30; 40; 41; 56; 60; 70; 71) on the first partial substrate (10) provided with the ball elements (14);
fixing (238, 246, 264) the ball elements (14) to the glass material layer (30; 44; 54) of the second partial substrate by means of annealing and applying mechanical pressure; and
one-sided thinning (300) of the ball elements (14) fixed to the glass material layer (30; 44; 54; 76) of the second partial substrate (30; 40; 41; 56; 60; 70; 71) to obtain the plano-convex lens elements (24).

2. Method according to claim 1, wherein the ball elements (14) comprise a semiconductor material and the convex-side radius of curvature R of the lens elements (24) corresponds to the ball radius R of the ball elements (14).

3. Method according to claim 1 or 2, further comprising:
fixing (630) the radiation-sensitive devices to the second partial substrate (30; 40; 41; 56; 60; 70) provided with the lens elements (24) to obtain radiation-sensitive devices provided with at least one lens element (24) each.

4. Method according to claim 3, further comprising:
dicing (640) the second partial substrate (30; 40; 41; 56; 60; 70) with the lens elements (24) and the radiation-sensitive devices arranged thereon to obtain diced radiation-sensitive devices provided with at least one lens element (24) each.

5. Method (100-3b) according to one of claims 1 to 4, further comprising:
providing (202) the first partial substrate (10) provided with depressions (12), wherein the ball elements (14) are arranged in the depressions (12) of the first partial substrate (10);
providing a second partial substrate (41), wherein the second partial substrate comprises recesses (49) and the glass material layer (44), wherein the glass material layer (44) is arranged on a first main surface area of the second partial substrate, wherein the glass material layer (44) comprises openings (46) that are aligned with the recesses (49) of the second partial substrate (41), and wherein the openings (46) of the glass material layer (44) have a smaller diameter than the recesses (49) of the second partial substrate (41);
arranging the second partial substrate (41) on the first partial substrate (10) provided with the ball elements (14), wherein the first main surface area of the second partial substrate (41) provided with the glass material layer (44) is facing the ball elements (14), and wherein the ball elements (14) are aligned with the recesses (49); and
fixing the second partial substrate (41) provided with the glass material layer (44) to the ball elements (14) by means of annealing and applying mechanical pressure; and
removing the first partial substrate (10) from the ball elements (14) firmly connected to the second partial substrate (41).

6. Method (100-2) according to one of claims 1 to 4, further comprising:
providing (202, 204, 206) the first partial substrate (10) provided with depressions (12), wherein the ball elements (14) are arranged in the depressions (12) of the first partial substrate (10);
providing a second partial substrate (30) comprising the glass material layer, wherein the second partial substrate (30) comprises depressions (32);
arranging (222) the second partial substrate (30) on the first partial substrate (10) provided with the ball elements (14), wherein the depressions (32) are aligned with the ball elements (14) in the second partial substrate (30);
fixing the second partial substrate (30) to the ball elements (14) arranged on the depressions (12) of the first partial substrate (10) by means of annealing and applying mechanical pressure to fix the ball elements (14) to the depressions (32) of the second partial substrate (30); and
removing the first partial substrate (10) from the ball elements (14) firmly connected to the second partial substrate (30).

7. Method (100-3a) according to one of claims 1 to 4, further comprising:
providing the first partial substrate (10) provided with depressions (12), wherein the ball elements (14) are arranged in the depressions (12) of the first partial substrate (10);
providing a second partial substrate (40), wherein the second partial substrate comprises vias (48) and the glass material layer (44), wherein the glass material layer (44) is arranged on a first main surface area of the second partial substrate, wherein the glass material layer (44) comprises openings (46) that are aligned with the vias (48) of the second partial substrate (40), and wherein the openings (46) of the glass material layer (44) have a smaller diameter than the vias (48) of the second partial substrate (40);
arranging the second partial substrate (40) on the first partial substrate (10) provided with the ball elements (14), wherein the first main surface area of the second partial substrate (40) provided with the glass material layer (44) is facing the ball elements (14) and wherein the ball elements (14) are aligned with the vias (48); and
fixing the second partial substrate (40) provided with the glass material layer (40) to the ball elements (14) by means of annealing and applying mechanical pressure; and
removing the first partial substrate (10) from the ball elements (14) firmly connected to the second partial substrate (40).

8. Method (110-4) according to one of claims 1 to 4, wherein the step (200) of fixing comprises:
providing (202, 204, 206) the first partial substrate (10) provided with depressions (12), wherein the ball elements (14) are arranged in the depressions (12) of the first partial substrate (10);
providing (242) a second partial substrate (56), wherein the second partial substrate (56) comprises recesses (52) and the glass material layer (54), wherein the glass material layer (54) is arranged on the first main surface area of the second partial substrate (56) provided with the recesses (52), and wherein the glass material layer (54) spans the recesses (52);
arranging the second partial substrate (56) on the first partial substrate (10) provided with the ball elements (14), wherein the first main surface area of the second partial substrate (56) provided with the glass material layer (54) is facing the ball elements (14), and wherein the ball elements (14) are aligned with the recesses (52);
fixing the second partial substrate (56) provided with the glass material layer (54) to the ball elements (14) by means of annealing and applying mechanical pressure; and
removing the first partial substrate (10) from the ball elements (14) firmly connected to the second partial substrate (56).

9. Method (100-5) according to one of claims 1 to 4, wherein the step (200) of fixing comprises:
providing (202, 204, 206) the first partial substrate (10) provided with depressions (12), wherein the ball elements (14) are arranged in the depressions (12) of the first partial substrate (10);
providing a second partial substrate (60), wherein a glass material layer (64) is arranged on a first main surface area of the second partial substrate (60);
arranging the second partial substrate (60) on the first partial substrate (10) provided with the ball elements (14), wherein the first main surface area of the second partial substrate (60) provided with the glass material layer (62) is facing the ball elements (14);
fixing the second partial substrate (60) provided with the glass material layer (64) to the ball elements (14) by means of annealing and applying mechanical pressure;
removing the first partial substrate (10) from the ball elements (14) firmly connected to the second partial substrate (60).

10. Method (100-6a) according to one of claims 1 to 4, wherein the step (200) of fixing comprises:
providing (202) the first partial substrate (10) provided with depressions (12), wherein the ball elements (14) are arranged in the depressions (12) of the first partial substrate (10);
providing a second partial substrate (70), wherein the second partial substrate comprises vias and a glass material layer, wherein the glass material layer (76) spans the vias (74);
arranging the second partial substrate (70) on the first partial substrate (10) provided with the ball elements (14), wherein the first main surface area of the second partial substrate (70) provided with the glass material layer (76) is facing the ball elements (14), and wherein the ball elements (14) are aligned with the vias (74);
fixing the second partial substrate (70) provided with the glass material layer (76) to the ball elements (14) by means of annealing and applying mechanical pressure; and
removing the first partial substrate (10) from the ball elements (14) firmly connected to the second partial substrate (70).

11. Method (100-6b) according to one of claims 1 to 4, wherein the step (200) of fixing comprises:
providing (202, 204, 206) the first partial substrate (10) provided with depressions (12), wherein a subset of the ball elements (14) is arranged in the depressions (12) of the first partial substrate (10);
providing (260-1) a second partial substrate (70), wherein the second partial substrate comprises vias (74) and the glass material layer (76), wherein the glass material layer (76) spans the vias (74);
arranging (262-1) the second partial substrate (70) on the first partial substrate (10) provided with the ball elements (14), wherein the first main surface area of the second partial substrate (70) provided with the glass material layer (76) is facing the ball elements (14), and wherein the ball elements (14) are aligned with a subset of the vias (74);
fixing (264-1) the second partial substrate (70) provided with the glass material layer (76) to the ball elements (14) by means of annealing and applying mechanical pressure;
removing (266-1) the first partial substrate (10) from the ball elements (14) firmly connected to the second partial substrate (70);
performing (300-1) the step of thinning (300) the ball elements (14) fixed to the second partial substrate (70) to obtain plano-convex lens elements (24);
providing the further partial substrate (10) provided with depressions (12), wherein a further subset of the ball elements is arranged in the depressions (12) of the partial substrate (10);
arranging (262-2) the second partial substrate (70) on the further partial substrate (10) provided with the further subset of ball elements (14), wherein the first main surface area of the second partial substrate (70) provided with the glass material layer (76) is facing the ball elements (14), and wherein the ball elements (14) are aligned with the further subset of the vias (74);
fixing (264-2) the second partial substrate (70) provided with the glass material layer (76) to the further subset of ball elements (14) by means of annealing and applying mechanical pressure;
removing (266-2) the further partial substrate (10) from the ball elements (14) firmly connected to the second partial substrate (70);
performing the step of thinning (300-2) the further subset of ball elements (14) fixed to the second partial substrate (70) to obtain the plano-convex elements (24).

12. Method (100-6c) according to one of claims 1 to 4, wherein the step (200) of fixing comprises:
providing (202) the first partial substrate (10) provided with depressions (12), wherein the ball elements (14) are arranged in the depressions (12) of the first partial substrate (10);
providing a second partial substrate (71), wherein the second partial substrate (71) comprises, starting from the main surface area, recesses (73) and further a glass material layer (76), wherein the glass material layer (76) spans the recesses (76);
arranging the second partial substrate (70) on the first partial substrate (10) provided with the ball elements (14), wherein the first main surface area of the second partial substrate (71) provided with the glass material layer (76) is facing the ball elements (14), and wherein the ball elements (14) are aligned with the recesses (74);
fixing the second partial substrate (71) provided with the glass material layer (76) to the ball elements (14) by means of annealing and applying mechanical pressure; and
removing the first partial substrate (10) from the ball elements (14) fixed to the second partial substrate (70).

13. Method (100-7) according to one of claims 1 to 4, wherein the step (200) of fixing comprises:
providing (202) the first partial substrate (10) provided with depressions (12);
arranging (204) the ball elements (14) in the depressions (12) of the first partial substrate (10);
arranging a second partial substrate (18) on the first partial substrate (10) provided with the ball elements (14), wherein the second partial substrate (18) comprises a glass material, wherein the first and second partial substrates (10, 18) are fixed to one another at least in an edge region; and
annealing the two partial substrates such that the glass material of the second partial substrate (18) flows at least partly around the ball elements (14), such that the ball elements are embedded, after re-solidification of the glass material of the second partial substrate (18), between the first partial substrate (10) and the solidified glass material of the second partial substrate (18), wherein the first partial substrate (10) and the solidified glass material of the second partial substrate (18) form a carrier substrate.

14. Production method (100-8) comprising:
providing (202) a first partial substrate (10) provided with depressions (12);
arranging ball elements (14) in the depressions (12) of the first partial substrate (10);
arranging (270) a polymer material (80) on the first partial substrate (10) provided with the ball elements, such that after solidification of the polymer material (80) the ball elements (14) are embedded between the solidified polymer material (80) and the first partial substrate (10), wherein the first partial substrate (10) and the solidified polymer material (80) form a carrier substrate;
mechanical thinning of the carrier substrate, wherein the step (300) of thinning the ball elements (14) fixed to the carrier substrate takes place starting from the exposed main surface area of the first partial substrate (10) to obtain the plano-convex lens element (10).

15. Method (600) for producing a packaged device on wafer level, comprising:
producing (610) a carrier substrate provided with plano-convex lens elements according to the method according to one of claims 1 to 14;
providing (620) a device substrate with a plurality of devices;
arranging (630) the substrates on one another, such that the lens elements arranged on the carrier substrate are aligned with the associated devices of the device substrate, wherein the carrier substrate and the device substrate are joined in a hermetically sealed manner; and
dicing (640) the carrier substrate with the device substrate arranged thereon to obtain diced devices provided with at least one lens element each.

## Revendications

1. Procédé (100, 100-1, .... 100-7) servant à fabriquer des lentilles planes-convexes (24) pour des composants sensibles au rayonnement, aux étapes suivantes consistant à:
prévoir (202) un premier substrat partiel (10) pourvu d'évidements (12) avec des éléments sphériques (14) y disposés;
prévoir (230) un deuxième substrat partiel (30; 40; 41; 56; 60; 70; 71) qui présente une couche de matériau de verre (30; 44; 54; 76);
disposer (236; 244; 262) le deuxième substrat partiel (30; 40; 41; 56; 60; 70; 71) sur le premier substrat partiel (10) pourvu des éléments sphériques (14);
fixer (238, 246, 264) au moyen de trempe et d'exercice d'une pression mécanique des éléments sphériques (14) à la couche de matériau de verre (30; 44; 54) du deuxième substrat partiel; et
amincir d'un côté (300) les éléments sphériques (14) fixés à la couche de verre (30; 44; 54; 76) du deuxième substrat partiel (30; 40; 41; 56; 60; 70; 71), pour obtenir les lentilles planes-convexes (24).

2. Procédé selon la revendication 1, dans lequel les éléments sphériques (14) présentent un matériau semi-conducteur et le rayon de courbure R du côté convexe des éléments de lentille (24) correspond au rayon sphérique R des éléments sphériques (14).

3. Procédé selon la revendication 1 ou 2, par ailleurs avec l'étape suivante consistant à:
fixer (630) les composants sensibles au rayonnement au deuxième substrat partiel (30; 40; 41; 56; 60; 70) pourvu des éléments de lentille (24), pour obtenir, des composants sensibles au rayonnement pourvus, chacun, d'au moins un élément de lentille (24).

4. Procédé selon la revendication 3, par ailleurs avec l'étape suivante consistant à:
séparer (640) le deuxième substrat partiel (30; 40; 41; 56; 60; 70) avec les éléments de lentille (24) y disposés et les composants sensibles au rayonnement pour obtenir des composants sensibles au rayonnement séparés pourvus, chacun, d'au moins un élément de lentille (24).

5. Procédé (100-3b) selon l'une des revendications 1 à 4, présentant par ailleurs les étapes suivantes consistant à:
prévoir (202) le premier substrat partiel (10) pourvu d'évidements (12), où les éléments sphériques (14) sont disposés dans les évidements (12) du premier substrat partiel (10);
prévoir un deuxième substrat partiel (41), où le deuxième substrat partiel présente des évidements (49) et la couche de matériau de verre (44), où la couche de matériau de verre (44) est disposée sur une première zone de surface principale du deuxième substrat partiel, où la couche de matériau de verre (44) présente des ouvertures (46) qui sont alignées sur les évidements (49) du deuxième substrat partiel (41), et où les ouvertures (46) de la couche de matériau de verre (44) présentent un diamètre plus petit que les évidements (49) du deuxième substrat partiel (41);
disposer le deuxième substrat partiel (41) sur le premier substrat partiel (10) pourvu des éléments sphériques (14), où la première zone de surface principale pourvue de la couche de matériau de verre (44) du deuxième substrat partiel (41) fait face aux éléments sphériques (14), et où les éléments sphériques (14) sont alignés sur les évidements (49); et
fixer au moyen de trempe et d'exercice d'une pression mécanique le deuxième substrat partiel (41) pourvu de la couche de verre (44) aux éléments sphériques (14); et
éliminer le premier substrat partiel (10) des éléments sphériques (14) rendus solidaires du deuxième substrat partiel (41).

6. Procédé (100-2) selon l'une des revendications 1 à 4, présentant par ailleurs les étapes suivantes consistant à:
prévoir (202, 204, 206) le premier substrat partiel (10) pourvu d'évidements (12), où les éléments sphériques (14) sont disposés dans les évidements (12) du premier substrat partiel (10);
prévoir un deuxième substrat partiel (30) présentant la couche de matériau de verre, où le deuxième substrat partiel (30) présente des évidements (32);
disposer (222) le deuxième substrat partiel (30) sur le premier substrat partiel (10) pourvu des éléments sphériques (14), où les évidements (32) dans le deuxième substrat partiel (30) sont alignés sur les éléments sphériques (14);
fixer au moyen de trempe et d'exercice d'une pression mécanique le deuxième substrat partiel (30) aux éléments sphériques (14) disposés dans les évidements (12) du premier substrat partiel (10), pour fixer les éléments sphériques (14) dans les évidements (32) du deuxième substrat partiel (30); et
éliminer le premier substrat partiel (10) des éléments sphériques (14) rendus solidaires du deuxième substrat partiel (30).

7. Procédé (100-3a) selon l'une des revendications 1 à 4, présentant par ailleurs les étapes suivantes consistant à:
prévoir (202) le premier substrat partiel (10) pourvu d'évidements (12), où les éléments sphériques (14) sont disposés dans les évidements (12) du premier substrat partiel (10);
prévoir un deuxième substrat partiel (40), où le deuxième substrat partiel présente des ouvertures traversantes (48) et la couche de matériau de verre (44), où la couche de matériau de verre (44) est disposée sur une première zone de surface principale du deuxième substrat partiel, où la couche de matériau de verre (44) présente des ouvertures (46) qui sont alignées sur les ouvertures traversantes (48) du deuxième substrat partiel (40), et où les ouvertures (46) de la couche de matériau de verre (44) présentent un diamètre plus petit que les ouvertures traversantes (48) du deuxième substrat partiel (40);
disposer le deuxième substrat partiel (40) sur le premier substrat partiel (10) pourvu des éléments sphériques (14), où la première zone de surface principale pourvue de la couche de matériau de verre (44) du deuxième substrat partiel (40) fait face aux éléments sphériques (14), et où les éléments sphériques (14) sont alignés sur les ouvertures traversantes (48); et
fixer au moyen de trempe et d'exercice d'une pression mécanique le deuxième substrat partiel (40) pourvu de la couche de matériau de verre (44) aux éléments sphériques (14); et
éliminer le premier substrat partiel (10) des éléments sphériques (14) rendus solidaires du deuxième substrat partiel (40).

8. Procédé (110-4) selon l'une des revendications 1 à 4, dans lequel l'étape (200) de fixation présente les étapes suivantes consistant à:
prévoir (202, 204, 206) le premier substrat partiel (10) pourvu d'évidements (12), où les éléments sphériques (14) sont disposés dans les évidements (12) du premier substrat partiel (10);
prévoir (242) un deuxième substrat partiel (56), où le deuxième substrat partiel (56) présente des évidements (52) et la couche de matériau de verre (54), où la couche de matériau de verre (54) est disposée sur la première zone de surface principale pourvue des évidements (52) du deuxième substrat partiel (56), et où la couche de matériau de verre (54) enjambe les évidements (52);
disposer le deuxième substrat partiel (56) sur le premier substrat partiel (10) pourvu des éléments sphériques (14), où la première zone de surface principale pourvue de la couche de matériau de verre (54) du deuxième substrat partiel (56) fait face aux éléments sphériques (14), et où les éléments sphériques (14) sont alignés sur les évidements (52);
fixer au moyen de trempe et d'exercice d'une pression mécanique le deuxième substrat partiel (56) pourvu de la couche de matériau de verre (54) aux éléments sphériques (14); et
éliminer le premier substrat partiel (10) des éléments sphériques (14) rendus solidaires du deuxième substrat partiel (56).

9. Procédé (100-5) selon l'une des revendications 1 à 4, dans lequel l'étape (200) de fixation présente les étapes suivantes consistant à:
prévoir (202, 204, 206) le premier substrat partiel (10) pourvu d'évidements (12), où les éléments sphériques (14) sont disposés dans les évidements (12) du premier substrat partiel (10);
prévoir un deuxième substrat partiel (60), où une couche de matériau de verre (64) est disposée sur une première zone de surface principale du deuxième substrat partiel (60);
disposer le deuxième substrat partiel (60) sur le premier substrat partiel (10) pourvu des éléments sphériques (14), où la première zone de surface principale pourvue de la couche de matériau de verre (62) du deuxième substrat partiel (60) fait face aux éléments sphériques (14);
fixer au moyen de trempe et d'exercice d'une pression mécanique le deuxième substrat partiel (60) pourvu de la couche de matériau de verre (64) aux éléments sphériques (14);
éliminer le premier substrat partiel (10) des éléments sphériques (14) rendus solidaires du deuxième substrat partiel (60).

10. Procédé (100-6a) selon l'une des revendications 1 à 4, dans lequel l'étape (200) de fixation présente les étapes suivantes consistant à:
prévoir (202) le premier substrat partiel (10) pourvu des évidements (12), où les éléments sphériques (14) sont disposés dans les évidements (12) du premier substrat partiel (10);
prévoir un deuxième substrat partiel (70), où le deuxième substrat partiel présente des ouvertures traversantes et une couche de matériau de verre, où la couche de matériau de verre (76) enjambe les ouvertures traversantes (74);
disposer le deuxième substrat partiel (70) sur le premier substrat partiel (10) pourvu des éléments sphériques (14), où la première zone de surface principale pourvue de la couche de matériau de verre (76) du deuxième substrat partiel (70) fait face aux éléments sphériques (14), et où les éléments sphériques (14) sont alignés sur les ouvertures traversantes (74);
fixer au moyen de trempe et d'exercice d'une pression mécanique le deuxième substrat partiel (70) pourvu de la couche de verre (76) aux éléments sphériques (14); et
éliminer le premier substrat partiel (10) des éléments sphériques (14) rendus solidaires du deuxième substrat partiel (70).

11. Procédé (100-6b) selon l'une des revendications 1 à 4, dans lequel l'étape (200) de fixation présente les étapes suivantes consistant à:
prévoir (202, 204, 206) le premier substrat partiel (10) pourvu des évidements (12), où un sous-ensemble des éléments sphériques (14) est disposé dans les évidements (12) du substrat partiel (10);
prévoir (260-1) un deuxième substrat partiel (70), où le deuxième substrat partiel présente des ouvertures traversantes (74) et la couche de matériau de verre (76), où la couche de matériau de verre (76) enjambe les ouvertures traversantes (74);
disposer (262-1) le deuxième substrat partiel (70) sur le premier substrat partiel (10) pourvu des éléments sphériques (14), où la première zone de surface principale pourvue de la couche de matériau de verre (76) du deuxième substrat partiel (70) fait face aux éléments sphériques (14), et où les éléments sphériques (14) sont alignés sur un sous-ensemble des ouvertures traversantes (74);
fixer (264-1) au moyen de trempe et d'exercice d'une pression mécanique le deuxième substrat partiel (70) pourvu de la couche de verre (76) aux éléments sphériques (14);
éliminer (266-1) le premier substrat partiel (10) des éléments sphériques (14) rendus solidaires du deuxième substrat partiel (70);
réaliser (300-1) l'étape consistant à amincir (300) les éléments sphériques (14) fixés au deuxième substrat partiel (70) pour obtenir des éléments de lentille plane-convexe (24);
prévoir l'autre substrat partiel (10) pourvu d'évidements (12), où un autre sous-ensemble des éléments sphériques (14) est disposé dans les évidements (12) du substrat partiel (10);
disposer (262-2) le deuxième substrat partiel (70) sur l'autre substrat partiel (10) pourvu de l'autre sous-ensemble d'éléments sphériques (14), où la première zone de surface principale pourvue de la couche de matériau de verre (76) du deuxième substrat partiel (70) fait face aux éléments sphériques (14), et où les éléments sphériques (14) sont alignés sur un autre sous-ensemble des ouvertures traversantes (74);
fixer (264-2) par trempe et exercice d'une pression mécanique le deuxième substrat partiel (70) pourvu de la couche de verre (76) à l'autre sous-ensemble d'éléments sphériques (14);
éliminer (266-2) l'autre substrat partiel (10) des éléments sphériques (14) rendus solidaires du deuxième substrat partiel (70);
effectuer l'étape d'amincissement (300-2) de l'autre sous-ensemble d'éléments sphériques (14) fixé au deuxième substrat partiel (70), pour obtenir les éléments de lentille plane-convexe (24).

12. Procédé (100-6c) selon l'une des revendications 1 à 4, dans lequel l'étape (200) de fixation présente les étapes suivantes consistant à:
prévoir (202) le premier substrat partiel (10) pourvu d'évidements (12), où les éléments sphériques (14) sont disposés dans les évidements (12) du premier substrat partiel (10);
prévoir un deuxième substrat partiel (71), le deuxième substrat partiel (71) présente, en partant de la première zone de surface principale, des évidements (73) et par ailleurs une couche de matériau de verre (76), où la couche de matériau de verre (76) enjambe les évidements (76);
disposer le deuxième substrat partiel (70) sur le premier substrat partiel (10) pourvu des éléments sphériques (14), où la première zone de surface principale pourvue de la couche de matériau de verre (76) du deuxième substrat partiel (71) fait face aux éléments sphériques (14), et où les éléments sphériques (14) sont alignés sur les évidements (74);
fixer par trempe et exercice d'une pression mécanique le deuxième substrat partiel (71) pourvu de la couche de verre (76) aux éléments sphériques (14); et
éliminer le premier substrat partiel (10) des éléments sphériques (14) fixés au deuxième substrat partiel (70).

13. Procédé (100-7) selon l'une des revendications 1 à 4, dans lequel l'étape (200) de fixation présente les étapes suivantes consistant à:
prévoir (202) le premier substrat partiel (10) pourvu d'évidements (12);
disposer (204) les éléments sphériques (14) dans les évidements (12) du premier substrat partiel (10);
disposer un deuxième substrat partiel (18) sur le premier substrat partiel (10) pourvu des éléments sphériques (14), où le deuxième substrat partiel (18) présente un matériau de verre, où le premier et le deuxième substrat partiel (10, 18) sont fixés l'un à l'autre au moins dans une zone de bord; et
tremper les deux substrats partiels de sorte que soit provoqué un enveloppement partiel des éléments sphériques (14) par le matériau de verre du deuxième substrat partiel (18), de sorte que les éléments sphériques soient noyés, après une nouvelle solidification du matériau de verre du deuxième substrat partiel (18) entre le premier substrat partiel (10) et le matériau de verre solidifié du deuxième substrat partiel (18), où le premier substrat partiel (10) et le matériau de verre solidifié du deuxième substrat partiel (18) forment un substrat porteur.

14. Procédé de fabrication (100-8), aux étapes suivantes consistant à:
prévoir (202) un premier substrat partiel (10) pourvu d'évidements (12);
disposer des éléments sphériques (14) dans les évidements (12) du premier substrat partiel (10);
disposer (270) un matériau polymère (80) sur le premier substrat partiel (10) pourvu des éléments sphériques, de sorte que, après une solidification du matériau polymère (80), les éléments sphériques (14) soient noyés entre le matériau polymère solidifié (80) et le premier substrat partiel (10), où le premier substrat partiel (10) et le matériau polymère solidifié (80) forment un substrat porteur;
amincir mécaniquement le substrat porteur, où l'étape (300) consistant à amincir les éléments sphériques (14) fixés au substrat porteur a lieu en partant de la zone de surface principale découverte du premier substrat partiel (10), pour obtenir les éléments de lentille plane-convexe (24).

15. Procédé (600) servant à fabriquer un composant encapsulé à un niveau de plaquette, aux étapes suivantes consistant à:
fabriquer (610) un substrat porteur pourvu d'éléments de lentille plane-convexe selon le procédé selon l'une des revendications 1 à 14;
prévoir (620) un substrat de composant avec une pluralité de composants;
disposer (630) les substrats l'un adjacent à l'autre, de sorte que les éléments de lentille disposés sur le substrat de support soient alignés sur les composants associés du substrat de composant, où le substrat de support et le substrat de composant sont assemblés de manière hermétique; et
séparer (640) le substrat de support et le substrat de composant disposé sur ce dernier, pour obtenir des composants séparés pourvus, chacun, d'au moins un élément de lentille.
